(19) Europäisches Patentamt
European Patent Office
Office européen des brevets

(11) EP 1 322 118 B1

(12) EUROPEAN PATENT SPECIFICATION

(45) Date of publication and mention of the grant of the patent:
**14.11.2012 Bulletin 2012/46**

(51) Int Cl.:
***H04N 7/26*** *(2006.01)*

(21) Application number: **02258127.6**

(22) Date of filing: **26.11.2002**

# (54) Method and apparatus for encoding and decoding key data

Verfahren und Vorrichtung zur Kodierung und Dekodierung von Schlüsseldaten

Appareil pour le codage et le décodage de donnée clé

(84) Designated Contracting States:
**DE FI FR GB NL SE**

(30) Priority:
**27.11.2001 US 333130 P**
**03.12.2001 US 334541 P**
**26.12.2001 US 342101 P**
**04.04.2002 US 369597 P**
**19.10.2002 KR 2002064007**

(43) Date of publication of application:
**25.06.2003 Bulletin 2003/26**

(60) Divisional application:
**06122708.8 / 1 761 065**
**06122709.6 / 1 750 447**

(73) Proprietor: **Samsung Electronics Co., Ltd.**
**Suwon-si, Gyeonggi-do, 443-742 (KR)**

(72) Inventors:
- **Lee, Shin-jun**
  **Seoul (KR)**
- **Jung, Seok-yoon**
  **Seoul (KR)**
- **Jang, Euee-seon,**
  **101-2301 Gangbyeon Kunyoung Apt.**
  **Seoul (KR)**
- **Woo, Sang-oak,**
  **508-1303 Gongjak Maeul Lucky Apt.**
  **Anyang-city,**
  **Kyungki-do (KR)**
- **Han, Mahn-jin,**
  **307-602 Satbyeol Maeul Woobang Apt.**
  **Seongnam-city,**
  **Kyungki-do (KR)**
- **Kim, Do-kyoon**
  **Seongnam-city,**
  **Kyungki-do 463-832 (KR)**
- **Jang, Gyeong-ja,**
  **1901-1201 Hatvit Maeul**
  **Goyang-city,**
  **Kyungki-do (KR)**

(74) Representative: **Anderson, James Edward George**
**Elkington and Fife LLP**
**Prospect House**
**8 Pembroke Road**
**Sevenoaks, Kent TN13 1XR (GB)**

(56) References cited:
- **KIM J D K ET AL: "Animation data compression in MPEG-4: interpolators" PROCEEDINGS 2002 INTERNATIONAL CONFERENCE ON IMAGE PROCESSING. ICIP 2002. ROCHESTER, NY, SEPT. 22 - 25, 2002, INTERNATIONAL CONFERENCE ON IMAGE PROCESSING, NEW YORK, NY : IEEE, US, vol. VOL. 2 OF 3, 22 September 2002 (2002-09-22), pages 33-36, XP010607503 ISBN: 0-7803-7622-6**
- **CHUNG H LU ET AL: "A DPCM SYSTEM WITH MODULO LIMITERS" COMMUNICATIONS FOR THE INFORMATION AGE. HOLLYWOOD, NOV. 28 - DEC. 1, 1988, PROCEEDINGS OF THE GLOBAL TELECOMMUNICATIONS CONFERENCE AND EXHIBITION(GLOBECOM), NEW YORK, IEEE, US, vol. VOL. 1, 28 November 1988 (1988-11-28), pages 581-585, XP000079267**
- **BOURGES-SEVENIER M ET AL: "Animation framework for MPEG-4 systems" MULTIMEDIA AND EXPO, 2000. ICME 2000. 2000 IEEE INTERNATIONAL CONFERENCE ON NEW YORK, NY, USA 30 JULY-2 AUG. 2000, PISCATAWAY, NJ, USA,IEEE, US, vol. 2, 30 July 2000 (2000-07-30), pages 1115-1118, XP010513205 ISBN: 0-7803-6536-4**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 322 118 B1

• DO-KYOON KIM ET AL: "Proposal for Interpolator Compression", 57. MPEG MEETING; 16-07-2001 - 20-07-2001; SYDNEY; (MOTION PICTUREEXPERT GROUP OR ISO/IEC JTC1/SC29/WG11),, no. M7473, 9 July 2001 (2001-07-09), XP030036580, ISSN: 0000-0282

## Description

The present invention relates to a method and an apparatus for encoding and decoding key data, and more particularly, to an apparatus and a method for encoding key data which are capable of increasing the efficiency of encoding key data by generating differential data performing differential pulse code modulation (DPCM) on key data and by decreasing the range of the differential data to be encoded performing predetermined operations, and to an apparatus and a method for decoding encoded key data.

Three-dimensional (3D) representation has been widely used for 3D-computer games or a virtual reality environment in a computer system. A virtual reality modeling language (VRML) is used to represent 3D animation.

VRML and MPEG-4 binary format for scene (BIFS) provide an animation representation method based on key framing. In the animation representation method, predetermined key frames are arranged on an arbitrary time axis, and animation data between the key frames are filled by linear interpolation. The key frames are defined by interpolator nodes, and each of the interpolator node is represented by a floating-point number within a predetermined range, for example, a range from $-\infty$ to $+\infty$. Each of the interpolator nodes constitutes fields each consisting of key data representing the position of a certain key frame on the time axis and key value data representing the characteristics and movement information on the key data corresponding to the key data.

In order to represent animation as naturally and smoothly as the movement of a real object by using key framing, which is a piecewise linear interpolation, a considerable amount of key frame information must be provided via each of the interpolator nodes, the fact which causes serious problems in terms of computational costs and efficiency. In the event where key framing is used in an off-line circumstance, a storage of a large capacity is needed to store a considerable amount of 3D animation data. In addition, when used in an on-line circumstance, key framing also requires not only such a large capacity storage but also high-speed data transmission lines, which can transmit a considerable amount of data at a time at high speeds, so as to transmit 3D animation information from a server to a terminal. In this case, as the possibility of errors to occur during transmission of data increases, the reliability of the data decreases. Therefore, an effective method for compressing and decoding data so as to reduce the amount of interpolator node data is required.

MPEG-4 BIFS provides two different methods for encoding animation data. One is BIFS-Q for encoding animation data, and the other is differential pulse code modulation (DPCM) for encoding differences among data. DPCM is also called predictive MF coding (PMFC). BIFS-Q only uses quantization and thus is not considered effective. PMFC is considered more effective than BIFS-Q because in PMFC, entropy encoding is performed to remove redundant data after DPCM is performed. A PMFC encoder and a PMFC decoder for key data is shown in FIG. 1. As described above, PMFC is not sufficiently effective in encoding animation data because it only performs DPCM before entropy encoding without taking into consideration the characteristics of keys and a correlation between the keys.

Referring to FIG. 1, input key data 105 is input into an encoder 100. A quantizer 110 receives the input key data 105 and quantizes them into integers. A DPCM processor 115 receives the quantized key data and generates differential data. An entropy encoder 120 receives the differential data, removes redundancy existing among bits in terms of the probability of symbols occurring, and generates a compressed bitstream 125. The bitstream 125 generated by the encoder 100 shown in FIG. 1 is input into an entropy decoder 155 of a decoder 150 and is entropy-decoded. The entropy-decoded differential data are input into an inverse DPCM processor 160 as quantized differential data, and an inverse quantizer 165 performs inverse quantization on the quantized key data input from the inverse DPCM processor 160 and outputs decoded key data.

However, the encoder 100 only performs DPCM before entropy encoding without considering the characteristics of a key, and thus it is very difficult to achieve effective encoding showing a high compression rate.

The present invention aims to provide an apparatus and a method for encoding data which are capable of compressing animation key data with a high efficiency taking the characteristics of key data into consideration when removing redundancy among bits of key data.

The present invention aims to provide an apparatus and a method for decoding bitstream encoded by the apparatus and the method for encoding data described above.

The aspects and advantages of the present invention will become apparent by describing in detail preferred embodiments thereof with reference to the attached drawings in which:

FIG. 1 is a block diagram of conventional key data encoder and key data decoder;
FIG. 2A is a block diagram of an encoder according to a preferred embodiment of the present invention;
FIG. 2B is a block diagram of a divide-and-divide (DND) processor shown in FIG. 2A;
FIGS. 2C through 2G are block diagrams of examples of an encoder according to the present invention;
FIGS. 3A and 3B are flowcharts of a method for encoding key data according to a preferred embodiment of the present invention;
FIGS. 4A and 4B are flowcharts of a floating-point number conversion process according to a preferred embodiment of the present invention;

FIG. 5 is a flowchart of a quantization process according to a preferred embodiment of the present invention;
FIG. 6 is a flowchart of a DPCM process according to a preferred embodiment of the present invention;
FIG. 7 is a flowchart of a DND operation process according to a preferred embodiment of the present invention;
FIG. 8 is a diagram illustrating entropy encoding according to a preferred embodiment of the present invention;
FIGS. 9A through 9J are graphs showing key data having been through different operations according to a preferred embodiment of the present invention;
FIGS. 10A and 10B are diagrams illustrating a process of encoding animation data using key data and key value data;
FIG. 11A is a block diagram of a key data decoder according to a preferred embodiment of the present invention;
FIGS. 11B through 11E are block diagrams of examples of a key data decoder according to the present invention;
FIG. 12 is a flowchart of a method for decoding key data according to a preferred embodiment of the present invention;
FIG. 13 is a flowchart of an inverse DND operation process according to a preferred embodiment of the present invention;
FIGS. 14A through 14E are diagrams showing examples of bitstream syntax and variables required for decoding; and
FIGS. 15A through 15C are diagrams showing examples of program codes into which operations required for decoding key data are realized.
FIG. 2A is a block diagram of an encoder according to a preferred embodiment of the present invention.

A method for encoding key data according to a preferred embodiment of the present invention will now be described with reference to FIGS. 3A and 3B. FIGS. 3A and 3B are flowcharts of the method for encoding key data. Referring to FIGS. 3A and 3B, if key data are input into an encoder, information on, for example, the number of key data and the number of digits of each of the key data, is input into a key header encoder 270 and is encoded. A linear key encoder 200 searches for a region in the input key data where key frames exist at certain temporal intervals, key data have the same difference, and the key data changes linearly, and the searched linear region is encoded first in step S3000.

Famous 3D application software, such as 3Dmax Maya, generates key-frame based animation using keys having a predetermined time gap therebetween in specific regions. In this case, it is possible to easily encode key data using the beginning and ending key data of a linear key data region and the number of key frames existing between them. Accordingly, linear prediction is very useful for encoding keys in a certain region using an interpolator.

The following equation is used for linear prediction.

$$t(i) = \frac{t_E - t_S}{E - S} i + t_S \quad (0 \le i \le E - S,\ S < E) \qquad \ldots(1)$$

Here, $t_S$ represents the data of a key where a partially linear region begins, $t_E$ represents the data of a key where the partially linear region ends, S represents an index of $t_S$, and E represents an index of $t_E$. The error between real key data in a specific region ranging from S-th key data to E-th key data and key data linearly predicted following Equation (1) can be calculated using the following equation.

$$e_i = t(i) - t_{i+S} = \frac{t_E - t_S}{E - S} i + t_S - t_{i+S} \qquad \cdots(2)$$

If a maximum value among errors calculated using Equation (2) is not greater than a predetermined critical value, $t_i$ can be considered co-linear in region [$t_S$, $t_E$] or within a certain range of errors. Whether or not the maximum error value $t_i$ is co-linear with the specific region is determined using the following Equation (3).

$$E_p = \underset{i=0,\ldots(E-S)}{MAX} \left| e_i \right| = \underset{i=0,\ldots(E-S)}{MAX} \left| \frac{t_E - t_S}{E - S} i + t_S - t_{i+S} \right| \qquad \cdots(3)$$

If $E_p \le \frac{1}{2^{nBits+1}}$, , $t_i$ is co-linear with region [$t_S$, $t_E$]. Here, nBits represents the number of bits used for encoding.

If the linear key encoder 200 searches for the partially linear region, the beginning and ending key data of the partially linear key data region are output to the floating-point number converter 205. The number of keys included in the linear key data region is output to the key header encoder 270 and is encoded. It is possible to considerably reduce the amount of data to be encoded using linear encoding.

The beginning key data and the ending key data are encoded using floating-point number conversion, which will be described later.

The floating-point number converter 205 converts key data represented in the binary system into the decimal system in order to encode the beginning key data and the ending key data.

A computer stores floating-point numbers as 32-bit binary numbers. If a floating-point number represented in the binary system is given, the floating-point number converter 205 converts the floating-point number into a mantissa and an exponent in the decimal system, and this process is expressed by the following equation.

$$\underbrace{mantissa_binary * 2^{exponent_binary}}_{\text{the floating-point number in binary system}} = \underbrace{mantissa * 10^{exponent}}_{\text{the floating-point number in decimal system}} \quad \cdots(4)$$

For example, a floating-point number 12.34 can be converted into a binary number by a computer, which is shown in the following.

$$\underbrace{0}_{1}\ \underbrace{10001010111000010100011}_{2}\ \underbrace{10000010}_{3}$$

1: the sign
2: the mantissa in the binary system
3: the exponent in the binary system

The binary number can be converted into a decimal number following Equation (4), which is shown in the following.

$$\underbrace{0}_{1}\ \underbrace{1234}_{2}\ \underbrace{2}_{3}$$

1: the sign
2: the mantissa in the decimal system
3: the exponent in the decimal system

In order to include a mantissa and an exponent in the decimal system in a bitstream, the numbers of bits required to represent the mantissa and the exponent must be calculated. The exponent has a value between -38 and 38 and thus can be expressed together with its sign using 7 bits. The number of bits required to represent the mantissa is dependent on the number of digits. The values of the mantissa and the number of bits required to represent the mantissa are shown in the following table.

Table 1.

| Values of mantissa | Digits of mantissa | Number of bits required |
|---|---|---|
| 0 | 0 | 0 |
| 1-9 | 1 | 4 |
| 10-99 | 2 | 7 |
| 100-999 | 3 | 10 |
| 1000-9999 | 4 | 14 |
| 10000-99999 | 5 | 17 |
| 100000-999999 | 6 | 20 |
| 1000000-9999999 | 7 | 24 |

The beginning and ending key data of the linear key data region that has been searched for and converted using the above-mentioned processes are encoded following the encoding process shown in FIGS. 4A and 4B, are output to the key header encoder 270, and are stored in the bitstream.

FIGS. 4A and 4B show that the floating-point number converter 205 encodes two input floating-point numbers. The way the floating-point number converter 205 encodes a floating-point number will be described with reference to FIGS. 4A and 4B.

The floating-point number converter 205 receives the digit number Kd of original key data, beginning key data S, and ending key data E and converts them in step S3040 following Equation (4).

The floating-point number converter 205 encodes S first. In particular, the floating-point number converter 205 checks whether or not the digit number of S is different from Kd. If the digit number of S is different from Kd, the digit number of S is obtained and is output to the key header encoder 270 in step S3042. The floating-point number converter 205 obtains the digit number of S using function Digit ( ).

If the digit number of S is greater than 7, S is output to the key header encoder 270 using a predetermined number of bits (in the present invention, 32 bits are used following a floating-point number manner of IEEE Standard 754) in step 3043 so that the digit number of S can be included in the bitstream.

If the digit number of S is not 0 and is smaller than 7, the floating-point number converter 205 outputs the sign of S to the key header encoder 270 in step 3044. The number of bits required to encode the absolute value of the mantissa of S, is obtained using Table 1. Next, the absolute value of the mantissa of S is output to the key header encoder 270 using the number of bits obtained using Table 1, in step 3045. The floating-point number converter 305 calculates the exponent of S, outputs the sign of S to the key header encoder 270, and outputs the exponent to the key header encoder 270 as a predetermined number of bits, for example, 6 bits, in step S3046. Such key data conversion makes it possible to considerably reduce the number of bits included in the bitstream.

If the digit number of S is 0, the encoding of the beginning key data is ended, and the method goes to a step of converting the ending key data E because when the digit number of S is 0, the corresponding floating-point number is also 0 which does not require encoding.

After converting and encoding the beginning key data S, the floating-point number converter 205 converts the ending key data E. The conversion of E is almost the same as that of S. In particular, it is checked whether or not the exponent of E is the same as that of S in step S3047. If the exponent of E is the same as that of S, only a flag bit representing that the exponent of E is the same as the exponent of S is output to the key header encoder 270. If the exponent of E is not the same as that of S, the exponent of E as well as the flag bit is output to the key header encoder 270 in the same way as the exponent of S has been output to the key header encoder 270, in step S3048.

Key data among the input key data which do not belong to the linear region are input into the quantizer 210 and quantized according to a predetermined quantization bit size, i.e., nKeyQBit.

However, in the case of decoding quantized key data using a decoder, it is impossible to perfectly recover original key data due to the error between the original key data and the quantized key data. Therefore, the quantizer 210 of the present invention obtains a maximum value and a minimum value among the input key data and quantizes the input key data using the maximum and minimum values. In addition, the present invention includes a quantization error minimizer 215 so that the error between original key data and their quantized key data can be minimized using the maximum and minimum values among the input key data.

The quantization error minimizer 215 quantizes or inversely quantizes the input key data in advance using a method for controlling a range of quantization so that the quantization error can be minimized, in step S3100.

In particular, if a mixed maximum value used for quantization is represented by Max, a minimum value to be controlled for quantization is represented by Min, an input value is represented by $X_i$, and the number of bits used for quantization is represented by nQuantBit, then, a quantized input value $\tilde{X}_i$, an inversely quantized value $\hat{X}_i$, and an error $e_i$ are obtained using the following equation.

$$\tilde{X}_i = floor\left(\frac{X_i - Min}{Max - Min} * (2^{nQuantBit} - 1) + 0.5\right) \quad \cdots(5)$$

$$\hat{X}_i = \frac{\tilde{X}_i * (Max - Min)}{2^{nQuantBit} - 1} + Min$$

$$e_i = X_i - \hat{X}_i$$

There are two methods for reducing the sum $\sum e_i$ of errors. One is a method for reducing the sum of errors by continuously controlling Min until the sum of errors is minimized. The other is as follows.

First, let us assume that $X_i = (i + n)\,\Delta x + \varepsilon_i$ where $X_i$ indicates an input key data sequence, $\Delta x$ indicates a basic

step size of input data, n is an arbitrary integer, and $\varepsilon_i$ indicates zero-mean random noise.

Next, when $d_i \equiv X_i - X_{i-1} = \Delta x + (\varepsilon_i - \varepsilon_{i-1})$, $\Delta' x = E[d_i]$ and Min = Max - $\Delta' x * (2^{nQuantBit} - 1)$.

Min, which can make it possible to minimize a quantization error, and Max are input into the quantizer 210 and are used for quantization of key data.

The quantizer 210 receives the maximum and minimum values Max and Min which can minimize a quantization error and quantizes key data $fKey_i$ in step S3200, following Equation (6).

$$nQKey_i = floor\left(\frac{fKey_i - fKeyMin}{fKeyMax - fKeyMin}(2^{nKeyQBit} - 1) + 0.5\right) \quad \cdots (6)$$

Here, i indicates an index of quantized key data, $nQKey_i$ indicates an array of integers of the quantized key data, $fkey_i$ indicates an array of floating-point numbers of the quantized key data, fKeyMax indicates a maximum value input from the quantization error minimizer 215, fKeyMin indicates a minimum value input from the quantization error minimizer 215, and nKeyQBit indicates a quantization bit size. In Equation (6), function floor(v) is a function which outputs a maximum integer no greater than a certain floating-point value v.

The quantizer 210 of the present invention may not use such algorithm for reducing a quantization error, in which case quantization is performed simply using the maximum and minimum values fKeyMax and fKeyMin among input key data.

A quantization process of the present invention will be described more fully with reference to FIG. 5.

The quantizer 210 receives key data in step S3210 and checks if the maximum and minimum values MAX and MIN are input from the quantization error minimizer 215 in step 3220.

If MAX and MIN are input, the quantizer 210 sets the maximum and minimum values fKeyMax and fKeyMin for quantization as MAX and MIN, respectively, in step 3230 and outputs the newly set maximum and minimum values fKeyMax and fKeyMin to the floating-point number converter 205. The maximum and minimum values fKeyMax and fKeyMin are converted and encoded through the above-mentioned floating-point number conversion process and are output to the key header encoder 270 so that they can be included in a key header for being used in decoding.

If there is no value input from the quantization error minimizer 215, the quantizer 210 sets first key data $fKey_0$ and final key data $fKey_{N-1}$ as the minimum value fKeyMin and the maximum value fKeyMax, respectively, instep S3240.

Next, the quantizer 210 checks whether or not the maximum value fKeyMax is smaller than 1 but greater than 0 and whether or not the minimum value fKeyMin is greater than 0 in step S3250. If the maximum value fKeyMax is not smaller than 1 or not greater than 0, the maximum and minimum values fKeyMax and fKeyMin are output to the floating-point number converter 105 and are converted and encoded through the above-mentioned floating-point number conversion. Next, the maximum and minimum values fKeyMax and fKeyMin that have been converted and encoded are included in the key header in step S3260 so that they can be used in decoding.

On the other hand, if the maximum value fKeyMax is smaller than 1 and the minimum value fKeyMin is greater than 0, a flag indicating whether the maximum and minimum values fKeyMax and fKeyMin will be included in the key header for being used in decoding is checked in step S3270. If the flag is set up so that the maximum and minimum values fKeyMax and fKeyMin can be included in the key header, step S3260 is performed so that the maximum and minimum values fKeyMax and fKeyMin are output to the key header encoder 270. If the flag is not set up, the quantizer 210 does not allow the maximum and minimum values fKeyMax and fKeyMin to be included in the key header.

In a case where the maximum and minimum values fKeyMax and fKeyMin are not included in the key header, the key data encoder and the key data decoder are supposed to perform encoding and decoding, respectively, setting up the maximum and minimum values fKeyMax and fKeyMin at 1 and 0, respectively. In this case, the quantizer 210 sets up the maximum and minimum values fKeyMax and fKeyMin at 1 and 0, respectively, in step S3280. The maximum and minimum values fKeyMax and fKeyMin are already known to the key data decoder so that they do not need to be included in the key header.

The quantizer 210 quantizes the input key data by substituting the maximum and minimum values fKeyMax and fKeyMin that have been set up through the above-mentioned process into Equation (6) and outputs the quantized key data to a DPCM processor 220 in step S3290.

The DPCM processor 220 receives the quantized key data and performs DPCM on the quantized key data a predetermined number of times. Next, the DPCM processor 220 outputs the order of DPCM, by which a minimum value in the degree of dispersion can be obtained, and intra key data obtained in each cycle of DPCM, to the key header encoder 270. The DPCM processor 220 outputs differential data generated by DPCM to the shifter 230 in step S3300.

Referring to FIG. 6, the DPCM processor 220 performs DPCM on the input key data a predetermined number of times and stores the number of cycles of DPCM as the order of DPCM in step S3310. In a preferred embodiment of the present invention, DPCM may be performed three times.

Thereafter, the DPCM processor 220 calculates the degree of dispersion of the results of each cycle of DPCM in step S3320. Here, the degree of dispersion may be represented by dispersion, standard deviation, or quartile deviation, and in a preferred embodiment of the present invention, quartile deviation may be used.

Next, the DPCM processor 220 selects a cycle of DPCM by which a minimum value in the degree of dispersion can be obtained and outputs the results of the selected order of DPCM to the shifter 230. The selected cycle of DPCM, intra key data of each cycle of DPCM and other pieces of information required for DPCM are output to the key header encoder 270 in step S3330. However, in a preferred embodiment of the present invention, DPCM is performed only one time if the number of keys is smaller than 5. For example, a first cycle of DPCM is performed following Equation (7).

$$\Delta_i = nQKey_{i+1} - nQKey_i \quad \cdots(7)$$

Here, i indicates an index of quantized key data, $nQKey_i$ indicates an array of integers, and $\Delta_i$ indicates differential data.

The DPCM processor 220 calculates the number of bits required to encode the results of the selected cycle of DPCM and differential data of the key data that have been generated by DPCM in a predetermined memory (nQStep_DPCM) in step S3340. The calculation of the number of bits required for encoding may also be performed later in a subsequent step of selecting key data to be encoded, the fact which is obvious to one skilled in the art.

The shifter 230 selects a differential datum (hereinafter, referred to as a mode) which has the highest frequency from among the differential data input from the DPCM processor 220. Then, the shifter 230 subtracts the mode from all the differential data in step S3400 so that most data to be encoded are arranged a cycle 0 and the number of bits required for encoding can be decreased.

Such shifting operation is performed subtracting mode nKeyShift from all the quantized key data, which is expressed by the following equation.

$$shift(nQKey_i) = nQKey_i - nKeyShift \quad \cdots(8)$$

Here, i indicates an index of quantized key data, $nQKey_i$ indicates an array of integers, and nKeyShift indicates a mode value. As a result of the shifting operation, differential data having the highest frequency become 0 so that the number of bits required for encoding can be considerably reduced.

The key data having been through the shifting operation are output to a folding processor 240 and a DND processor 250, and the mode value nKeyShift is output to the key header encoder 270 so as to be included in the key header.

The folding processor 240 performs a folding operation on the outputs of the shifter 230 and outputs the results of the folding operation to the DND processor 250 in step S3500.

The folding operation is used to reduce the range of differential data that widely disperse over both a positive number region and a negative number region by concentrating them in either the positive or negative number region. In the present embodiment, the folding operation is performed following Equation (9) to concentrate the differential data in the positive number region.

$$\begin{aligned} fold(nQKey_i) &= 2 \cdot nQKey_i \quad (if\ nQKey_i \geq 0) \quad \cdots(9) \\ &= 2\left|nQKey_i\right| - 1 \quad (if\ nQKey_i < 0) \end{aligned}$$

Here, i indicates an index of quantized key data, and $nQKey_i$ indicates an array of integers. As a result of the folding operation, positive differential data are converted into even numbers, and negative different data are converted into odd numbers.

The folding processor 240 calculates the number of bits required for encoding the differential data having been through the folding operation and stores it in a predetermined memory nQStep_fold. In this step, the calculation of the number of bits required for encoding may be performed later in a subsequent step of selecting differential data to be entropy-encoded, the fact which is obvious to one in the art. The data generated by the folding operation in the folding processor 240 are output to the DND processor 250.

In order to enhance the efficiency of entropy encoding, the DND processor 250 performs a DND operation on the input differential data of the key data a predetermined number of times, thus reducing the range of the differential data in S3600.

Referring to FIG. 2B, the DND processor 250 includes a DND operator 252 which performs a DND operation on differential data, a first differential data selector 254 which selects differential data to be entropy-encoded based on the number of bits for encoding, a shift-up operator 256 which performs a shift-up operation on the differential data having been through a DND operation, and a second differential data selector 258 which selects from between the differential data having been through only the DND operation and the differential data having been through the shift-up operation the ones that have a lower dispersion degree and outputs the selected differential data to the entropy encoder 260.

The DND operation performed in the DND operator 252 will be described in the following.

When the differential data having been through the folding operation in the folding processor 240 are input into the DND operator 252, they are divided in two groups, and a group of differential data having a higher range than the other group of differential data is moved to the positive number region by a divide function. The divide function is defined by the following equation.

$$
\begin{aligned}
& divide(nQKey_j, nKeyMax) && \cdots(10) \\
&= nQKey_j - (nKeyMax + 1) && (if\ nQKey_j > \frac{nKeyMax}{2}) \\
&= nQKey_j && (if\ nQKey_j \le \frac{nKeyMax}{2})
\end{aligned}
$$

Here, j indicates an index of input differential data, $nQKey_j$ indicates an array of integers, and nKeyMax indicates a maximum value among differential data having been through the folding operation. Especially, in a case where most differential data are densely populated along boundaries of the entire region accounted for by all differential data, it is possible to considerably reduce the entire region of all differential data using the divide operation.

After the divide operation, the degree of dispersion is calculated, in which case the size of bits required for encoding is used as a measure of the degree of dispersion so that a minimum value in the size of bits for encoding can be selected.

After the DND operation, a different kind of DND operation, i.e., a divide-up operation or a divide-down operation, is further performed. Whether a divide-up operation or a divide-down operation will be further performed is determined depending on both the size of a positive range of differential data and the size of a negative range of the differential data.

If the range of the differential data having positive values is larger than that of the differential data having negative values, a divide-down operation defined by the following equation is performed.

$$
\begin{aligned}
& divide-down(nQKey_j, nKeyMax) && \cdots(11) \\
&= -2(nKeyMax - nQKey_j + 1) + 1 && (if\ nQKey_j > \frac{nKeyMax}{2}) \\
&= nQKey_j && (if\ 0 \le nQKey_j \le \frac{nKeyMax}{2}) \\
&= 2 \cdot nQKey_j && (if\ nQKey_j < 0)
\end{aligned}
$$

On the other hand, if the range of the differential data having positive values is not larger than the range of the differential data having negative values, a divide-up operation defined by the following equation is performed.

$$
\begin{aligned}
& divide-up(nQKey_j, nKeyMin) && \cdots(12) \\
&= nQKey_j && (nQKey_j \ge 0) \\
&= 2 \cdot nQKey_j && (\frac{nKeyMin}{2} \le nQKey_j \le 0) \\
&= 2(nKeyMin - nQKey_j - 1) + 1 && (nQKey_j < \frac{nKeyMin}{2})
\end{aligned}
$$

In Equations (11) and (12), j indicates an index of quantized key data, $nQKey_j$ represents an array of integers, nKeyMax indicates a maximum value of $nQKey_j$, and nKeyMin indicates a minimum value of $nQKey_j$.

The operation of the DND operator 252 will be described in the following with reference to FIG. 7.

When the differential data of the input key data are input from the folding processor 240, the DND operator 252 obtains the maximum value nKeyMax and the minimum value nKeyMin among the input differential data in step S3610. Then, the DND operator 252 compares the absolute value of nKeyMax with that of nKeyMin in step S3620. If nKeyMax is not smaller than the absolute value of nKeyMin, the DND operator 252 sets nKeyMax as a maximum value in the current cycle of DND operation in step S3622.

The DND operator 252 checks if the order of DND operation is 1, in other words, if the order of DND operation is 1, in step S3624, and if it is, the DND operator 252 performs a divide operation on the input differential data in step S3630 substituting the maximum value nKeyMax in Equation (10).

Thereafter, the DND operator 252 measures the size of bits required for encoding the differential data range having been reduced using the divide operation, in step S3640, using function getQBit (). If the order of DND operation turns out to be 1 in step S3650, the size of bits required for encoding is stored as a value nQBitDND indicating the minimum size of bits for encoding, and the order of DND operation is increased by 1 in step S3655.

Next, the DND processor 252 performs steps S3610 through S3622 again. If the order of DND operation is not 1 in step S3624, the DND operator 252 performs a divide-down operation in step S3634 substituting the maximum value nKeyMax in Equation (11). The DND operator 252 calculates the number of bits required for encoding the differential data having been through the divide-down operation, in step S3640. If the number is smaller than the minimum value nQBitDND stored in the previous cycle of DND operation, it replaces the minimum size of bits required for encoding after the DND operation in step S3658.

If the absolute value of the minimum value nKeyMin appears to be greater than that of the maximum value nKeyMax in step S3620, the maximum value in the current cycle of DND operation is renewed as a minimum value in step S3623, and then a divide-up operation is performed in step S3628 substituting the minimum value for nKeyMin in Equation 12. Thereafter, the DND operator 252 calculates the number of bits for encoding the differential data having been through the divide-up operation in step S3640. If the result of the calculation turns out to be smaller than nQBitDND that has been stored in the previous cycle of DND operation in step S3652, it replaces the minimum number nQBitDND of bits required for encoding after the DND operation in step S3658.

The DND processor 252 performs the DND operation a predetermined number of times, and the number of performance of the DND operation may vary. For example, in the present embodiment, the DND operation is performed 7 times. The DND operator 252 outputs nQBitDND and the differential data corresponding to nQBitDND to the first differential data selector 254. The DND operator 252 outputs the order of DND by which the corresponding differential data have been generated to the key header encoder 270 and allows them to be included in the bitstream.

The first differential data selector 254 receives the differential data having been through the shifting operation, the differential data having been through the folding operation, and the differential data having been through the DND operation and determines which differential data among the three will be entropy-encoded.

Referring to FIGS. 3A and 3B, the first differential data selector 254 selects the results of the DPCM and performs a shifting operation on them in step S3710 if the minimum number nQBitDND of bits required for encoding after the DND operation is no smaller than the size nQStep-DPCM of bits for encoding after the DPCM operation in step S3700. Next, the first differential data selector 254 outputs the results of the shifting operation to the entropy encoder 260 and allows them to be entropy-encoded in step S3710. In this case, the order of DND operation is set up as -1, is output to the key header encoder 270, and is included in the key header.

However, if it turns out in step S3720 that nQBitDND is smaller than nQStep-DPCM and is not smaller than the size of bits for encoding after the folding operation, the first differential data selector 254 outputs the differential data having been through the folding operation to the entropy encoder 260 and allows them to be entropy-encoded in step S3730, in which case the order of DND operation is set up at 0, is output to the key header encoder 270, and thus is included in the key header.

If the number of bits for encoding the differential data after the DND operation is smallest, the first differential data selector 254 outputs the differential data having been through the DND operation to the shift-up operator 256, and then the shift-up operator 256 calculates a first dispersion degree of the differential data input from the first differential data selector 254, in step S3740. Next, the shift-up operator 256 performs a shift-up operation defined by the following equation on the differential data having been through the DND operation, in step S3800 and calculates a second dispersion degree of the results of the shift-up operation in step S3810.

$$
\begin{aligned}
& shift-up(nQKey_j, nKeyMax) \quad \cdots(13) \\
& = nQKey_j \quad (if\ nQKey_j \geq 0) \\
& = nKeyMax - nQKey_j \quad (if\ nQKey_j < 0)
\end{aligned}
$$

Here, j indicates an index of differential data of quantized key data, $nQKey_j$ indicates an array of integers, and nKeyMax indicates a maximum value among differential data.

When the differential data having been through the DND operation and the differential data having been through the shift-up operation are input, the second differential data selector 258 compares the first dispersion degree with the second dispersion degree in step S3900. If the second dispersion degree is smaller than the first dispersion degree, the second differential data selector 258 outputs the differential data having been through the shift-up operation to the entropy-encoder 260 and allows them to be entropy-encoded in step S3910. The second differential data selector 258 outputs the maximum and minimum values nKeyMax and nKeyMin used in the DND operation, and the maximum value nKeyMax used in the shift-up operation to the key header encoder 270 and allows them to be included in the key header.

However, if the first dispersion degree is smaller than the second dispersion degree, the second differential data selector 258 outputs the differential data having been through the DND operation to the entropy encoder 260 and allows them to be entropy-encoded in step S3920. Then, the second differential data selector 258 outputs only the maximum and minimum values nKeyMax and nKeyMin used in the DND operation to the key header encoder 270. In a preferred embodiment of the present invention, standard deviation may used as a measure of the first and second dispersion degrees.

The entropy encoder 260 performs two different functions on differential data depending on the characteristics of the differential data. For example, differential data having been through a DPCM operation and a shifting operation and differential data having been through only a divide operation have both positive and negative values, and thus it is required to perform a process of encoding the sign of each of the differential data as well as the differential data themselves. On the other hand, since differential data having been through a folding operation only have positive values, a process of encoding only the differential data is performed.

In a preferred embodiment of the present invention, function encodeSignedAAC is used for encoding the differential data and their signs as well, and function encodeUnsignedAAC is used for encoding only differential data.

FIG. 8 is a diagram of an example of function encodeSignedAAC. Referring to FIG. 8, when an input value is 74 and the number of bits for encoding the input value is 8, its sign is 0, and it is the same as a binary number of 1001010. Signs and all bit planes are encoded in the following way:

First step: a binary number is encoded on every bit plane in an order of from its most significant bit (MSB) to its least significant bit (LSB);
Second step: it is checked if the bit which is currently being encoded is 0;
Third step: if the bit currently being encoded is not 0, the sign of the binary number is encoded next; and
Fourth step: the remaining bits of the binary number are encoded.

Function encodeUnsignedAAC encodes values not having a sign as an adaptive arithmetic encoding bitstream using a context regarding the values. This function is almost the same as function encodeSignedAAC except that there exists a sign context.

FIGS. 9A through 9J are graphs showing key data which have been subjected to operations according to a preferred embodiment of the present invention. In FIGS. 9A through 9J, the X-axis represents indexes of each of the key data, and the Y-axis represents the values of the key data.

FIG. 9A is a graph showing original key data input into the encoder of the present invention. The key data shown in FIG. 9A are output to the quantizer 210 and then are quantized with nine quantization bits so that quantized key data shown in FIG. 9B are obtained. If DPCM is performed on the quantized key data shown in FIG. 9B, differential data shown in FIG. 9C are obtained.

Next, the differential data of the quantized key data are shifted using a mode value of about 7 so that differential data shown in FIG. 9D are obtained. Thereafter, if a folding operation is performed on the shifted differential data, data having only positive values can be obtained, as shown in FIG. 9E.

The results of performing a DND operation on the folded data shown in FIG. 9E are shown in FIGS. 9F through 9H. In particular, the results of performing a divide operation on the folded data are shown in FIG. 9F. As shown in FIG. 9F, positive key data values range from 0 to 28, and negative key data values range from - 29 to 0, which means that the range of negative key data values is greater than that of positive key data values. Accordingly, it is required to perform a divide-up operation on the data shown in FIG. 9F, and the results of the divide-sup operation are shown in FIG. 9G.

As a result of the divide-up operation, the range of negative key data valuers is considerably reduced so that it is much smaller than the range of positive key data values. In a subsequent cycle of DND operation, a divide-down operation is performed on the results of the divide-up operation. FIG. 9H is a diagram showing the results of performing a divide-down operation on the differential data shown in FIG. 9G. The results of performing a shift-up operation on the key data shown in FIG. 9H are shown in FIG. 9I.

As shown in FIGS. 9A through 9G, the range of key data and differential data gradually decreases. However, as shown in FIGS. 9H and 9I, the range of differential data is increased greater after the shift-up operation than before, which shows that the differential data having been through the divide-down operation, as shown in FIG. 9H, are the ones that are to be finally encoded, as shown in FIG. 9J.

The information encoded in the key header encoder 270 and stored in the key header will be described in the following.

When key data to be encoded are input, the key header encoder 270 encodes the digit number of key data and the number of keys to be encoded. Next, the key header encoder 270 receives information on whether or not there exists a linear key data region that has been through the linear key encoding in the input key data and the number of key data in the linear key data region from the linear key encoder 200 and receives the beginning and ending key data of the linear key data region that has been through the floating-point number conversion from the floating-point number converter 205.

In a case where the floating-point number converter 205 receives maximum and minimum values which can bring about a minimum quantization error and converts them into floating-point numbers, the converted maximum and minimum values are input into the key header encoder 270 from the floating-point number converter 205 so that they can be used again for inverse quantization. In addition, the size of quantization bits is also input into the key header encoder 270 and is included in the key header.

The key header encoder 270 receives the order of DPCM and intra key data in each cycle of DPCM from the DPCM processor 220 and receives a mode value which has been used for a shifting operation from the shifter 230. In addition, the key header encoder 270 receives from the DND processor 250 information on whether or not a shift-up operation has been performed, the order of DND by which the dispersion degree of differential data can be minimized, and maximum and minimum values in each cycle of DND operation.

Finally, the key header encoder 270 receives the number of bits used for encoding from the entropy encoder 260 and encodes it as a key header.

An example of the key data encoder according to a preferred embodiment of the present invention has been described above. It is obvious to one in the art that the present invention may be embodied in various ways. Hereinafter, other examples of the key data encoder according to other preferred embodiments of the present invention, which are capable of increasing the efficiency of encoding key data, will be described more fully with reference to FIGS. 2C through 2G. In FIGS. 2A through 2G, the same reference numerals indicate the same elements.

Referring to FIG. 2C, a key data encoder according to another preferred embodiment of the present invention includes a quantizer 210, a DPCM processor 220, a shifter 230, a folding processor 240, a DND processor 250, and an entropy encoder 260.

Key data input into the key data encoder are input into the quantizer 210 first and quantized into predetermined quantization bits. The quantized key data are input into the DPCM processor 220. Then, the DPCM processor 220 performs a DPCM operation on the quantized key data and outputs the results of the DPCM operation, i.e., differential data, to the shifter 230. The shifter 230 obtains a differential datum (a mode) having the highest frequency among the differential data and performs a shifting operation in which the mode is subtracted from each of the differential data. Next, the shifter 230 outputs the results of the shifting operation to the folding processor 240. The folding processor 240 converts the differential data input from the shifter 230 into either a positive or negative number region and outputs the results of the conversion to the DND processor 250. The DND processor 250 performs a DND operation on the differential data input from the folding processor 240. Next, the DND processor 250 selects from among the differential data having been through the shifting operation, the differential data having been through the folding operation, and the differential data having been through the DND operation the ones which can minimize the number of bits for encoding and outputs the selected differential data to the entropy encoder 260 so that the key data can be encoded. Here, the DND processor 250 may not perform a shift-up operation on the differential data having been through the DND operation, and the key data encoder shows a much higher encoding efficiency than conventional key data encoders.

Referring to FIG. 2D, a key data encoder according to another preferred embodiment of the present invention includes a quantizer 210, a DPCM processor 220, a shifter 230, a DND processor 250, and an entropy encoder 260.

Key data are input into the quantizer 210 first and are quantized with predetermined quantization bits. The quantized key data are input into the DPCM processor 220. Then, the DPCM processor 220 performs a DPCM operation on the quantized key data and outputs the results of the DPCM operation, i.e., differential data to the shifter 230. The shifter 230 obtains a differential datum (a mode) having the highest frequency among the differential data and performs a shifting operation in which the mode is subtracted from each of the differential data. Next, the shifter 230 outputs the results of the shifting operation to the DND processor 250. The DND processor 250 performs a DND operation on the shifted differential data input from the shifter 230. Next, the DND processor 250 figures out which differential data have a smaller number of bits required for encoding between the differential data having been through the shifting operation and the differential data having been through the DND operation. If the differential data having been through the DND operation turn out to have a smaller number of its required for encoding, the DND processor 250 performs a shift-up operation on them. Next, the DND processor 250 selects from between the differential data having been through the shift-up operation and the differential data having been through the DND operation the ones having a smaller number of bits required for encoding. Then, the DND processor 250 outputs the selected differential data to the entropy encoder 260. The entropy encoder performs entropy encoding on the differential data input from the DND processor 250, thus generating a bitstream. The key data encoder in the present embodiment shows a much higher encoding efficiency than conventional key data encoders even though it does not perform a folding operation.

Referring to FIG. 2E, a key data encoder according to another preferred embodiment of the present invention encodes differential data and outputs them when the differential data of key data are input.

The key data encoder includes a shifter 230, a folding processor 240, a DND processor 250, and an entropy encoder 260. A differential datum having the highest frequency among input differential data is subtracted from the input differential data in the shifter 230, and the results of the subtraction are output to the folding processor 240. The folding processor 240 converts the differential data output from the folding processor 240 into either a positive or negative number region and outputs the results of the conversion to the DND processor 250. The DND processor 250 performs a DND operation on the differential data input from the folding processor 240 and figures out which differential data can minimize the number of bits required for encoding among the differential data having been through the shifting operation, the differential data having been through the folding operation, and the differential data having been through the DND operation. If the differential data having been through the shifting operation or the folding operation are considered capable of minimizing the number of bits required for encoding, the DND processor 250 outputs them to the entropy encoder 260 so that the key data can be encoded. On the other hand, in a case where the differential data having been through the DND operation are selected, the DND processor 250 performs a shift-up operation on them. Next, the DND processor 250 selects from between the differential data having been through the DND operation and the differential data having been through the shift-up operation the ones having a smaller number of bits required for encoding. Next, the selected differential data are output to the entropy encoder 260. The entropy encoder 260 encodes the outputs of the DND operation 250, thus generating a bitstream. The key data encoder in the present embodiment also shows a much higher encoding efficiency than conventional key data encoders.

FIG. 2F is a block diagram of a key data encoder according to another preferred embodiment of the present invention. Referring to FIG. 2F, the key data encoder includes a DND operator 252, a shift-up operator 256, a differential data selector 258b, and an entropy encoder 260.

The DND operator performs a DND operation, which has been described above, on differential data of key data input thereinto and outputs the DNDed differential data to the shift-up operator 256 and the differential data selector 258b. The shift-up operator 256 performs a shift-up operation, which has been described above, on the DNDed differential data input from the DND operator 252 and then outputs the results of the shift-up operation to the differential data selector 258b. The differential data selector 258b compares the number of bits required for encoding the DNDed differential data input from the DND operator 252 with the number of bits required for encoding the differential data input from the shift-up operator 256 and outputs the ones having a smaller number of bits required for encoding to the entropy encoder 260 so as to make a bitstream of key data be output. The key data encoder in the present embodiment also shows a much higher encoding efficiency than conventional key data encoders.

In FIG. 2G, a key data encoder according to another preferred embodiment of the present invention, which can increase the efficiency of encoding key data by identifying a linear key data region in input differential data, is shown. The key data encoder includes a linear key encoder 200, a floating-point number converter 205, a quantizer 210, an entropy encoder 280, and a key header encoder 270.

When key data are input into the key data encoder shown in FIG. 2G, the linear key encoder 200 searches for a region where key data linearly increases, i.e., a linear key data region, in the input key data and outputs the beginning and ending key data of the linear key data region to the floating-point number converter 205. The input key data except for the linear key data region are input into the quantizer 210. The key data input into the quantizer 210 are quantized with predetermined quantization bits and are output to the entropy encoder 280. The entropy encoder 280 encodes the quantized key data input from the quantizer 210 by performing a predetermined operation on them and thus outputs the results of the operation as a bitstream.

The floating-point number converter 205 converts the beginning and ending key data of the linear key data region which are represented by binary numbers into the decimal system and outputs the results of the conversion to the key header encoder 270 so that they can be included in the bitstream. The key data encoder in the present embodiment may further include a quantization error minimizer 215.

A process of encoding animation data using key data and key value data will be described more fully with reference to FIGS. 10A and 10B.

In an animation path of key values, a key value encoder searches a set of points representing almost the same animation path as that of the key values, in which case a considerable number of key values can be decreased and the rest are represented by key selection flags. For example, supposing that key values are given showing a curved line shown in FIG. 10A and four points are selected, key selection flags have some values, as shown in FIG. 10B. Such key selection flags are encoded by the entropy encoder 260 so that only the key value data corresponding to the key selection flags are encoded.

An example of SDL program codes and variables that have been used for the aforementioned encoding process will be described more fully with reference to FIGS. 14A through 14E.

Program codes of class key header are shown in FIG. 14A. Variables used in the program codes will be described first.

Key header data are pieces of information required for decoding key data. The main information of the key header includes the number of keys, a quantization bit, intra key data, a DND header, and the number of bits required for decoding. nKeyQBit indicates a quantization bit used for inverse quantization, which restores floating-point number key values, nNumKeyCodingBit indicates the bit size of nNumberOfKey representing the number of key data, and nKeyDigit indicates the maximum number of significant digits of original key data and is used for rounding off the decoded value. In a case where information on a linear key data region is included in the key header, flag blsLinearKeySubRegion is set at 1, in which case some keys included in a predetermined sub-region within the entire range of keys can be calculated using decoded header information following the flag bisLinearKeySubRegion. bRangeFlag represents whether or not the range of the key data is between 0 and 1. If the key data does not range from 0 to 1, minimum and maximum values are decoded from class KeyMinMax. Class KeyMinMax reconstitutes maximum and minimum values for inverse quantization. Each of the maximum and minimum values can be divided into their mantissas and exponents. nBitSize indicates the bit size of bQIntraKey, and nKeyShift indicates the original bit size of nKeyMax. nQIntraKey indicates the size of first quantized intra data, is coupled with nQIntraKeySign representing the sign of nQIntraKey, and is used as a base for recovering other quantized key data. Among sign bits used for interpolator compression, 0 indicates positive values and 1 indicates negative values. nKDPCMOrder is the same as the result of subtracting 1 from the order of DPCM. The order of DPCM ranges from 1 to 3 and is the same as the number of intra data.

nkeyShift is an integer representing the amount of shift in a key data decoder, together with sign bit nKeyShift-Sign. nKeyShift and nKeyShiftSign are decoded when bShiftFlag is set at 1. nDNDOrder is the order of DND. DND will be described in greater detail later with a key data decoder according to a preferred embodiment of the present invention. If nDNDOrder is 7, bNoDND is decoded. This Boolean value nDNDOrder represents information on whether or not inverse DND is performed. nKeyMax and nKeyMin indicate maximum and minimum values, respectively, used in consecutive cycles of DND operation. nKeyCodingBit is a bit used for encoding key data. bSignedAACFlag shows which decoding method will be used for AAC decoding. If bSignedAACFlag is 0, unsignedAAC decoding is performed, and if not, signedAAC decoding is performed. bKeyInvertDownFlag is a Boolean value representing information on whether or not nKeyInvertDown will be used. nKeyInvertDown is an integer and inverses quantized key data over the integer so that the quantized key data are converted into native values of no greater than -1. If nKeyInvertDown is -1, a shift-down operation is not performed.

FIG. 14B is a diagram showing program codes of class LinearKey. In FIG. 14B, nNumLinearKeyCodingBit is a value representing the number of bits required for encoding a predetermined number of keys which can be linearly predicted.

FIG. 14C is a diagram showing program codes of class KeySelection Flag. In FIG. 14C, keyflag is a Boolean array and represents information on whether or not an i-th key value has been decoded. nNumOfKeyValue is an integer representing the number of key values to be decoded.

FIG. 14D is a diagram showing program codes of class KeyMinMax. In FIG. 14D, bMinKeyDigitSame represents whether or not the number of most significant digits of all keys is the same as the number of most significant digits of a maximum value among the keys. nMinKeyDigit indicates the number of most significant bits of the maximum value among the keys. nMinKeyMantissaSign indicates the sign of nMinKeyMantissa. NMinKeyMantissa indicates the mantissa of a minimum value among the keys.

nMinKeyExponentSign refers the sign of nMinKeyExponent. nMinKeyExponent indicates the exponent of the minimum value among the keys.

fKeyMin indicates the minimum value among the keys. nMaxKeyDigitSame represents whether or not the number nKeyDigit of most significant digits of all the keys is the same as the number of most significant digits of the maximum value among the keys. nMaxKeyDigit indicates the number of most significant digits of the maximum value among the keys. nMaxKeyMantissaSign indicates the sign of nMaxKeyMantissa. nMaxKeyMantissa indicates the mantissa of the maximum value among the keys.

bSameExponent represents whether or not the exponent of the maximum value among the keys is the same as nMinKeyExponent. nMaxKeyExponentSign indicates the sign of nMaxKeyExponent. nMaxKeyExponent indicates the exponent of the maximum value among the keys. fKeyMax indicates the maximum value among the keys.

FIG. 14E is a diagram showing program codes of class Key. In FIG. 14E, nQKey indicates an array of quantized key data to be decoded from a bitstream. KeyContext indicates a certain context used for reading the size of nQKey. KeySignContext indicates a context used for reading the sign of nQKey.

decodeUnsignedAAC is a function for performing unsigned decoding using a given context, which will be described more fully in the following, and decodeSignedAAC is a function for performing signed decoding using another given context, which will be described later.

Hereinafter, an apparatus and a method for decoding key data according to a preferred embodiment of the present invention will be described with reference to FIGS. 11A and 12.

FIG. 11A is a block diagram of an apparatus for decoding key data according to a preferred embodiment of the present invention. The apparatus for decoding key data receives an encoded bitstream and reconstitutes it into key data by decoding.

The apparatus for decoding key data includes a key header decoder 370 and a key data decoder. The key data decoder includes an entropy decoder 360, an inverse DND processor 350, an inverse folding processor 340, an inverse shifter 330, an inverse DPCM processor 320, an inverse quantizer 310, a linear key decoder 300, and a floating-point number inverse converter 305.

FIG. 12 is a flowchart of a method for decoding key data recording to a preferred embodiment of the present invention. Referring to FIGS. 11A and 12, a bitstream, into which key data are compressed, is input into the key header decoder 370 and the entropy decoder 360.

The key header decoder 370 decodes pieces of information required for each step of decoding and provides them to their corresponding steps of decoding in step S4000. The information decoded by the key header decoder 370 will be described with each decoding step.

The entropy decoder 360 receives the number of differential data to be decoded and the number of bits that have been used for encoding, i.e., the number of bits to be used for decoding, from the key header decoder 370 and decodes the input bitstream in step S4100. The number of differential data is equal to the result of subtracting the number of intra key data obtained by performing DPCM from the number of key data.

The entropy decoder 360 identifies if the differential data to be decoded have negative values or positive values based on predetermined information included in the bitstream, for example, bSignedAACFlag in the present embodiment. If the encoded differential data have negative values, the entropy decoder 360 decodes them using function decodeSignedAAC(). On the other hand, if the encoded differential data have only positive values, the entropy decoder 360 decodes them using function decodeUnsignedAAC(). Thereafter, the decoded differential data are transmitted to the inverse DND processor 350.

An example of program codes for realizing such functions for decoding a bitstream according to a preferred embodiment of the present invention will be described later.

The inverse DND processor 350 receives the order of DND and a maximum value nKeyMax in each cycle of DND from the key header decoder 370.

If the order of DND is -1, this means that the encoded differential data being decoded have been entropy-decoded going through a DPCM operation and a shifting operation instead of going through DND, and the method directly moves onto a step of performing an inverse shifting operation. If the order of DND is 0, this means that the encoded differential data being decoded have been entropy-decoded going through a folding operation instead of going through DND, and thus the method directly moves onto a step of performing an inverse folding operation. If the order of DND is greater than 0, an inverse DND operation is performed in step S4150.

The inverse DND processor 350 determines whether or not the encoded differential data being decoded have been encoded going through a shift-up operation in step S4170. In a preferred embodiment of the present invention, it is determined whether or not the encoded differential data being decoded have been encoded going through a shift-up operation by checking whether or not nKeyInvertDown included in a bitstream is greater than 0.

If the encoded differential data being decoded have not been through a shift-up operation, the method moves onto a step of performing an inverse DND. On the other hand, if the encoded differential data being decoded have been through a shift-up operation, the differential data that have been transferred from a positive number region to a negative number region by performing a shift-up operation are moved back to the negative number region in step S4200. In a preferred embodiment of the present invention, the differential data having been through a shift-up operation are restored by performing a shift-down operation (an invert-down operation) which is expressed by the following equation.

$$\begin{aligned} & invert-down(v) && \cdots(14) \\ & = v && (if\ v \le nKeyInvertDown) \\ & = nKeyInvertDown - v && (if\ v > nKeyInvertDown) \end{aligned}$$

Here, nKeyInvertDown has the same value as the maximum value nKeyMax used in the shift-up operation. As a result of the shift-down operation, the differential data having a value over nKeyInvertDown are converted into negative values below -1.

An inverse divide-down operation or an inverse divide-up operation is selectively performed on the differential data having been through the shift-down operation depending on the maximum value nKeyMax in each cycle of DND.

Referring to FIG. 13, the inverse DND processor 350 performs an inverse DND operation as many times as the differential data have been through a DND operation during encoding. In other words, the inverse DND processor 350 sets up an initial value of the order of inverse DND to be equal to the order of DND. Next, the inverse DND processor 350 subtracts 1 from the initial value of the order of inverse DND every time it performs an inverse DND operation and keeps performing the inverse DND operation until the order of inverse DND becomes 1. The inverse DND processor 350 searches for nKeyMax in each cycle of DND and checks whether or not each nKeyMax is not smaller than 0 in step S4310.

If nKeyMax is smaller than 0, it means that a divide-up operation has been performed in the process of encoding, and thus the inverse DND processor 350 extends the range of the differential data being decoded to a negative number region by performing an inverse divide-up operation, in step S4320. In a preferred embodiment of the present invention, an inverse divide-up operation which is defined by Equation (15) may be used.

$$
\begin{aligned}
& inverse-divide-up(v) && \cdots(15)\\
&= v && (if\ v \geq 0)\\
&= (nKeyMax_i - 1) - \frac{v-1}{2} && (if\ v < 0, v \bmod 2 \neq 0)\\
&= \frac{v}{2} && (if\ v < 0, v \bmod 2 = 0)
\end{aligned}
$$

However, if nKeyMax is not smaller than 0, the inverse DND processor 350 checks if the order of inverse DND is 1. If the order of inverse DND is not 1, it means that a divide-down operation has been performed on the differential data being decoded in the process of encoding, and thus the inverse DND processor 350 extends the range of the differential data to a positive number region by performing an inverse divide-down operation, in step S4340.

In a preferred embodiment of the present invention, an inverse divide-down operation which is defined by the following equation may be used.

$$
\begin{aligned}
& inverse-divide-down(v) && \cdots(16)\\
&= v && (if\ v \geq 0)\\
&= (nKeyMax_i + 1) + \frac{v-1}{2} && (if\ v < 0, v \bmod 2 \neq 0)\\
&= \frac{v}{2} && (if\ v < 0, v \bmod 2 = 0)
\end{aligned}
$$

If nKeyMax is not smaller than 0 and the order of inverse DND is 1, the inverse DND processor 350 completes an entire inverse DND operation after performing an inverse divide operation in step S4350. In a preferred embodiment of the present invention, an inverse divide operation which is defined by Equation (17) may be used.

$$
\begin{aligned}
& inverse-divide(v) && \cdots(17)\\
&= v && (if\ v \geq 0)\\
&= v + (nKeyMax_0 + 1) && (if\ v < 0)
\end{aligned}
$$

The differential data of key data which have been through the inverse DND operation are input into the inverse folding processor 340, and the inverse folding processor 340 performs an inverse folding operation on the differential data so that the differential data which used to be only in a positive number region are divided into positive values and negative values in step S4400. In a preferred embodiment of the present invention, an inverse folding operation which is defined by Equation (18) may be used.

$$\begin{aligned} inverse-fold(v) &= -\frac{(v+1)}{2} \quad (if\ v \bmod 2 \neq 0) \quad \cdots(18) \\ &= \frac{v}{2} \quad (if\ v \bmod 2 = 0) \\ &= 0 \quad (if\ v = 0) \end{aligned}$$

The differential data which have been through the inverse folding operation are output to the inverse shifter 330, and the inverse shifter 330 adds a mode nKeyShift, which has been used in the process of encoding and is input from the key header decoder 370, to the differential data input from the inverse folding processor 340, in step S4500. This operation is expressed by the following equation.

$$inverse-shift(v) = v + nKeyShift \quad \cdots(19)$$

The inverse DPCM processor 320 restores the differential data input from the inverse shifter 330 into quantized key data using the order of DPCM input from the key header encoder 370, in step S4600. The inverse shifter 330 performs an inverse DPCM operation as many times as the order of DPCM following Equation (20).

$$v(i+1) = v(i) + delta(i) \quad \cdots(20)$$

Here, i indicates an index of differential data and key data, v indicates an array of integers, and delta(i) indicates differential data.

The quantized key data having been through the inverse DPCM operation are input into the inverse quantizer 310. Then, the inverse quantizer 310 receives information on whether or not the size nKeyQBit of quantization bits and maximum and minimum values used for inverse quantization are encoded by the floating-point number converter 205 from the key header decoder 370 and converts the quantized key data into inversely quantized key data in step S4700 using the following equation.

$$inverse-quantize(v) = fKeyMin + \frac{v}{2^{nKeyQBit} - 1} \times (fKeyMax - fKeyMin) \quad \cdots(21)$$

If maximum and minimum values used for quantization have not been converted by the floating-point number converter 205 in the process of encoding key data, fKeyMin and fKeyMax shown in Equation (21) are set to 0 and 1, respectively. However, if the maximum and minimum values used for quantization have been converted by the floating-point number converter 205, maximum and minimum values which are inversely converted by the floating-point number inverse converter 305 are used as the maximum and minimum values, respectively, for inverse quantiazation.

An example of program codes into which the inverse DND operation to the inverse quantization are realized will be described later.

The decoded key data output from the inverse quantizer 310 are added to the key data decoded in the linear key decoder 300, thus constituting decoded key data.

Hereinafter, a linear key decoding process will be described in the following.

The key header decoder 370 decodes key header information from a bitstream. If information on a linear key data region exists in the bitstream, the key header decoder 370 outputs information required for decoding the beginning and ending keys of the linear key data region to the floating-point number converter 305 and outputs the number of keys, which are encoded as linear keys, to the linear key decoder 300.

The floating-point number inverse converter 305 inversely converts the beginning and ending keys of the linear key data region, which are expressed by decimal numbers, into binary numbers and outputs the binary numbers to the linear key decoder 300.

Supposing two floating-point numbers to be decoded are referred to as fKeyMin and fKeyMax, a process of decoding fKeyMin is as follows.

The key header decoder 370 reads the number of digits of fKeyMin from a bitstream. If the digit number of fKeyMin is 0, fKeyMin is set to 0, and the number of digits of fKeyMax is read from the bitstream in order to decode fKeyMax. If the digit number of fKeyMax is not smaller than 8, it means that fKeyMax has been encoded following the IEEE Standard 754. Thus, the floating-point number fKeyMax is decoded after 32 bits of it are read.

However, if the digit number of fKeyMax is between 1 and 7, the key header decoder 370 reads a sign bit from the bitstream. In a preferred embodiment of the present invention, if the sign bit is 1, MinKeyMantissaSign is set to -1. On the other hand, if the sign bit is 0, MinKeyMantissaSign is set to 1. Thereafter, the number of bits required for decoding is obtained referring to Table 1 which shows the relationship between the digit number of a mantissa and the number of bits required for encoding. Next, as many bits of the bitstream as the number of bits required for encoding are read and are stored in nMinKeyMantissa. Then, next one bit of the bitstream is read and is stored in MinKeyExponentSign in the same way as the sign of the mantissa is stored in MinKeyMantissaSign. Next six bits of the bitstream, which correspond to an exponent value, are read and are stored in nMinKeyExponent.

The floating-point number inverse converter 305 restores fKeyMin by substituting the value input from the key header decoder 370 into Equation (22).

$$fKeyMin = \frac{MinKeyMantissaSign * nMinKeyMantissa}{10^{MinKeyExponentSign * nMinKeyExponent}} \quad \cdots (22)$$

A process of restoring fKeyMax is the same as the process of restoring fKeyMin. In particular, it is determined whether or not the same value as the exponent of fKeyMin is used as the exponent of fKeyMax before reading the exponent of fKeyMax from the bitstream. If the same value as the exponent of fKeyMin is not used as the exponent of fKeyMin, the exponent of fKeyMax is read from the bitstream in the same way the exponent of fKeyMin is read from the bitstream.

The linear key decoder 300 receives the beginning and ending keys of the linear key data region from the floating-point number inverse converter 305 and decodes the linear key data region following Equation (23).

$$Key_i = fKeyMin + \frac{(fKeyMax - fKeyMin) * i}{(nNumberOfLinearKey - 1)} \quad \cdots (23)$$
$$(i = 0, \ldots, nNumberOfLinearKey - 1)$$

Here, fKeyMin and fKeyMax indicate the beginning and ending key data, respectively, of the linear key data region.

Key data in the linear key data region decoded using the aforementioned method are added to the key data output from the inverse quantizer 310, and then the results of the adding are output as final key data.

An example of the apparatus for decoding key data according to a preferred embodiment of the present invention has been described above. It is obvious to one skilled in the art that the present invention may be embodied in various ways. Hereinafter, various embodiments of the apparatus for decoding key data will be described with reference to FIGS. 11 B through 11E. The same reference numerals in FIGS. 11A through 11E represent the same elements.

Referring to FIG. 11 B, an apparatus for decoding key data according to another preferred embodiment of the present invention includes an entropy decoder 360, an inverse DND operator 352, an inverse folding processor 340, an inverse shifter 330, an inverse DPCM processor 320, and an inverse quantizer 310.

When a bitstream, in which key data are encoded, is input into the apparatus for decoding key data, the entropy decoder 360 entropy-decodes the input bitstream and outputs the results of the entropy decoding, i.e., decoded differential data to the inverse DND operator 352. The inverse DND operator 352 determines whether or not the input differential data have been through a DND operation based on the order of DND regarding the input differential data. If the differential data turn out to have been through a DND operation, the inverse DND operator 352 performs an inverse DND operation on the differential data and outputs the results of the inverse DND operation. If the differential data have not been through a DND operation, the inverse DND operator 352 bypasses them.

The inverse folding processor 340 checks if the differential data input from the inverse DND operator 352 have been through a folding operation using the order of DND and performs an inverse folding operation on the differential data if the differential data have been through a folding operation. If the differential data have not been through a folding operation, the inverse DND operator 352 bypasses them to the inverse shifter 330.

The inverse shifter 330 performs an inverse shifting operation on the differential data input from the inverse folding processor 340 and outputs the results of the inverse shifting operation to the inverse DPCM processor 320. The inverse DPCM processor 320 converts the differential data input from the inverse shifter 330 into quantized key data and outputs the quantized key data to the inverse quantizer 310. The inverse quantizer 310 inversely quantizes the quantized key data and outputs decoded key data.

Referring to FIG. 11 C, an apparatus for decoding key data according to another preferred embodiment of the present invention includes an entropy decoder 360, an inverse DND processor 350, an inverse shifter 330, an inverse DPCM processor 320, and an inverse quantizer 310.

When a bitstream, in which key data are encoded, is input into the apparatus for decoding key data, the entropy decoder 360 entropy-decodes the input bitstream and outputs decoded differential data to the inverse DND processor 350. The inverse DND processor 350 checks if the differential data input from the entropy decoder 360 have been through a shift-up operation in the process of encoding the key data. If the input differential data have been through a shift-up operation, the inverse DND processor 350 sequentially performs a shift-down operation and an inverse DND operation on the differential data and outputs the results of the inverse DND operation. If the input differential data have not been through a shift-up operation, the inverse DND processor 350 performs an inverse DND operation on the differential data and outputs the results of the inverse DND operation to the inverse shifter 330.

The inverse shifter 330 performs an inverse shifting operation on the differential data input from the inverse DND processor 350 and outputs the results of the inverse shifting operation to the inverse DPCM processor 320. The inverse DPCM processor 320 converts the differential data input from the inverse shifter 330 into quantized key data and outputs the quantized key data to the inverse quantizer 310. The inverse quantizer 310 inversely quantizes the quantized key data and outputs decoded key data.

Referring to FIG. 11D, an apparatus for decoding key data according to another preferred embodiment of the present invention includes an entropy decoder 360, an inverse shift-up operator 356, and an inverse DND operator 352.

An input bitstream is decoded in the entropy decoder 360, is converted in differential data, and is input into the inverse shift-up operator 356. The inverse shift-up operator 356 performs a shift-down operation on the input differential data and outputs the results of the shift-down operation to the inverse DND operator 352. The inverse DND operator 352 performs an inverse DND operation on the differential data input from the shift-up operator 356 and outputs differential data of decoded key data. The differential data of decoded key data can be output using a general decoder.

Referring to FIG. 11 E, an apparatus for decoding key data according to another preferred embodiment of the present invention decodes a bitstream which has been encoded in an apparatus for encoding key data using a linear key encoder. The apparatus for decoding key data includes an entropy decoder 380, a key header decoder 370, an inverse quantizer 310, and a floating-point number inverse converter 305.

An input bitstream is input into the entropy decoder 380 and the key header decoder 370. The entropy decoder 380 entropy-decodes part of the bitstream corresponding to key data, performs a predetermined operation on it, and outputs the result of the predetermined operation to the inverse quantizer 310. The key header decoder 370 decodes another part of the bitstream corresponding to a key header and outputs the number of key data included in a linear key data region to a linear key decoder. In addition, the key header decoder 370 outputs information on the beginning and ending key data of the linear key data region to the floating-point number inverse converter 305.

The inverse quantizer 310 inversely quantizes quantized key data and outputs the results of the inverse quantization. The linear key decoder decodes the linear key data region using the beginning and ending key data of the linear key data region which are input from the floating-point number inverse converter 305. Next, the linear key decoder adds the decoded linear key data to the key data output from the inverse quantizer 310 and outputs decoded key data.

Examples of program codes, into which operations for decoding key data are realized, will be described in the following with reference to FIGS. 15A through 15C.

FIG. 15A is a diagram illustrating an example of program codes, into which a function decodeSignedAAC( ) for decoding, with the use of a context regarding values and their signs, values having a sign from a bitstream, which has been through adaptive arithmetic encoding, is realized.

FIG. 15B is a diagram illustrating an example of program codes, into which a function decodeUnsignedAAC( ) for decoding, with the use of a context regarding values and their signs, values not having a sign from a bitstream, which has been through adaptive arithmetic encoding, is realized. In FIG. 15B, qf_decode( ) indicates a function for reading one bit from a bitstream.

FIG. 15C is a diagram illustrating an example of program codes, into which the inverse DND operation to the inverse quantization, which have been described above, are realized.

The present invention can be realized as computer-readable codes written on a computer-readable recording medium. Here, the computer-readable recording medium includes any kind of recording medium which can be read by a computer system. For example, the computer-readable recording medium includes a ROM, a RAM, a CD-ROM, a magnetic tape, a floppy disk, an optical data storage, carrier wave (transmission through the Internet). The computer-readable recording medium can be decentralized to computer systems connected over network, and a computer can read the recording medium in a decentralized way.

Unlike conventional apparatuses for encoding and decoding key data, the method and apparatus for encoding and decoding key data according to the present invention can considerably improve the efficiency of encoding key data by performing a shifting operation, a folding operation, and a DND operation on differential data, which are obtained performing a DPCM operation, and encoding the results of one of the operations which can minimize the number of bits required for encoding. Therefore, according to the present invention, it is possible to considerably reduce a space for storing 3D animation and to transmit animation data at high speeds.

While this invention has been particularly shown and described with reference to preferred embodiments thereof, it will be understood by those skilled in the art that various changes in form and details may be made therein without departing from the scope of the invention as defined by the appended claims.

## Claims

1. An apparatus for encoding DPCMed differential data of key data, which are information on the locations of key frames on a time axis, the apparatus comprising:

   a shifter (230) which obtains a differential datum, hereinafter mode, having the highest frequency among the differential data and subtracts the mode from each of the differential data;
   a folding (240) processor which converts the shifted differential data into either a positive number region or a negative number region, such that positive data are converted into even numbers, and negative data are converted into odd numbers;
   a DND processor (250) which in consideration of the relationship between the converted differential data and maximum and minimum values among them, performs a DND operation on the converted differential data so as to reduce their range, selects one out of the differential data input from the shifter, the differential data input from the folding processor, the differential data having been through the DND operation, and the differential data having been through a shift-up operation as well as the DND operation, and outputs the selected differential data; and
   an entropy encoder (260) which entropy-encodes the differential data input from the DND processor,
   wherein the DND operation comprises a divide operation (53630) performed on the converted differential data so as to divide the range of differential data into halves and so as to convert the differential data belonging to an upper range into negative values, and either a divide-up operation or a divide-down operation selectively performed on the results of the divide operation depending on the range of the results of the divide operation so as to reduce the range of differential data belonging to a negative number region or the positive number region, respectively,
   wherein in the divide-up operation (53638), data that are smaller than a predetermined reference value but not smaller than the half of the minimum input value nKeyMin are multiplied by a first constant, and data that are smaller than nKeyMin/2 are subtracted from nKeyMin, the result of the subtraction is multiplied by the first constant, and a second constant is subtracted from the result of the multiplication,
   wherein in the divide-down operation (53634), for data that are greater than half of the maximum input value nKeyMax, nKeyMax is subtracted from the data, the result of the subtraction is multiplied by the first constant, and the second constant is subtracted from the result of the multiplication, and data that are smaller than the predetermined reference value are multiplied by the first constant,
   and wherein the shift-up operation (256) comprises subtracting each of the differential data having been through the DND operation from the maximum value nKeyMax among them if they are smaller than a predetermined reference value.

2. The apparatus of claim 1, wherein if the differential data input from the shifter are greater than a predetermined reference value, the folding processor multiplies the differential data by a first constant, and if the differential data are smaller than the predetermined reference value, the folding processor multiplies the absolute value of each of the differential data by the first constant and subtracts a second constant from each of the results of the multiplication.

3. The apparatus of claim 1 or 2, wherein the DND processor comprises:

   a DND operator which performs a DND operation on the differential data input from the folding processor;
   a first differential data selector which selects one out of the differential data having been through the shifting operation, the differential data having been through the folding operation, and the differential data having been through the DND operation and outputs the selected differential data;
   a shift-up operator which if the differential data having been through the DND operation are input from the first differential data selector, performs the shift-up operation on the differential data; and
a second differential data selector which selectively outputs the differential data having been through the DND operation or the differential data having been through the shift-up operation.

**4.** The apparatus of claim 3, wherein in the divide operation, a maximum value nKeyMax among the input differential data and a predetermined constant are subtracted from each of the input differential data if the input differential data are greater than $\frac{nKeyMax}{2}$.

**5.** The apparatus of claim 3 or claim 4, wherein the DND operator performs the DND operation on the differential data a predetermined number of times so as to output the results of a certain cycle of DND operation in which the number of bits required for encoding can be minimized.

**6.** The apparatus of any of claims 3 to 5, wherein from among the differential data respectively input from the shifter, the folding processor, and the DND operator, the first differential data selector selects the ones that have a smallest number of bits required for encoding and outputs the selected differential data.

**7.** The apparatus of any of claims 3 to 6, wherein if the differential data input from the shifter or the folding processor are selected, the first differential data selector outputs the selected differential data to the entropy encoder.

**8.** The apparatus of any of claims 3 to 7, wherein the second differential data selector measures the dispersion degree of the differential data having been through the DND operation and the dispersion degree of the differential data having been through the shift-up operation and outputs the ones that have a lower dispersion degree between the two.

**9.** An apparatus for encoding key data, the apparatus comprising:

a linear key encoder which identifies in input key data a region where key data linearly increase and encodes the linear key data region;
a quantization error minimizer which adjusts maximum and minimum values among the input key data so that a quantization error can be minimized and outputs the adjusted maximum and minimum values;
a quantizer which quantizes the input key data with predetermined quantization bits using the maximum and minimum values input from the quantization error minimizer;
a floating-point number converter which converts binary numbers representing the beginning and ending key data of the linear key data region input from the linear key encoder and binary numbers representing the maximum and minimum values input from the quantization error minimizer into decimal numbers;
a DPCM processor which generates differential data of the quantized key data;
the apparatus of claim 1; and
a key header encoder which generates key header data using data required for encoding which are input from at least one of the linear key encoder, the quantizer, the floating-point number converter, the DPCM processor, the shifter, the folding processor, the DND processor, and the entropy encoder.

**10.** The apparatus of claim 9, wherein the linear key encoder determines that the linear key data region is co-linear if a maximum error between the key data in the linear key data region and linearly-predicted key data in an arbitrary key data region is not greater than a predetermined critical value.

**11.** The apparatus of claim 9 or 10, wherein the quantizer converts the input key data into values of a predetermined range using the maximum and minimum values among the input key data and quantizes the values with the predetermined quantization bits.

**12.** The apparatus of any of claims 9 to 11, wherein the quantization error minimizer converts the input key data into values of a predetermined range using arbitrary maximum and minimum values, quantizes the values with the predetermined quantization bits, inversely quantizes the quantized key data, and obtains and outputs the maximum and minimum values which can minimize the sum of errors between the input key data and the inversely quantized key data.

**13.** The apparatus of any of claims 9 to 12, wherein the floating-point number converter converts binary numbers expressed in the form of *mantissa_binary* * $2^{exponent_binary}$ into decimal numbers expressed in the form of *mantissa* * $10^{exponent}$.

**14.** The apparatus of any of claims 9 to 13, wherein if the differential data input from the shifter are greater than a predetermined reference value, the folding processor multiplies them by a first constant, and if they are smaller than the predetermined reference value, the folding processor multiplies their absolute values by the first constant and then subtracts a second constant from each of the results of the multiplication.

**15.** The apparatus of any of claims 9 to 14, wherein the DND processor comprises:

a DND operator which performs a DND operation on the differential data input from the folding processor;
a first differential data selector which selects one out of the differential data having been through the shifting operation, the differential data having been through the folding operation, and the differential data having been through the DND operation and outputs the selected differential data;
a shift-up operator which if the differential data having been through the DND operation are input from the first differential data selector, performs the shift-up operation on the differential data; and
a second differential data selector which selectively outputs the differential data having been through the DND operation or the differential data having been through the shift-up operation.

**16.** The apparatus of claim 15, wherein the DND operator performs a DND operation on the differential data input from the folding processor so as to reduce the range of differential data to be encoded, and in particular, in the DND operation, a divide operation is performed on the differential data so as to divide the range of differential data in a positive number region into halves and so as to convert a half of the differential data belonging to an upper range than the other half into negative values and either a divide-up operation or a divide-down operation is performed on the results of the divide operation depending on the range of the differential data having been through the divide operation so as to reduce the range of differential data belonging to the negative number region or the positive number region, respectively.

**17.** The apparatus of any of claims 9 to 16, wherein the key header encoder receives the number of key data to be encoded and the digit number of the key data, receives the size of quantization bits and the maximum and minimum values having been used for quantization from the quantizer, receives information on whether there exists a linear key region that has been through linear key encoding and the number of linear key data from the linear key encoder, receives the beginning and ending key data of the linear key region from the floating-point number converter, receives the number of performance of DPCM, i.e., the order of DPCM, and intra key data in each cycle of DPCM from the DPCM processor, receives the mode from the shifter, receives the number of performance of DND, i.e., the order of DND, and the maximum and minimum values having been used for a DND operation, and allow all the inputs to be included in a key header.

**18.** An apparatus for decoding an encoded bitstream which is encoded by performing a quantization operation and a predetermined number of cycles of DPCM operation on key data, which are information on the location of a keyframe on a temporal axis, and then performing at least one of a shifting operation comprising subtracting the mode, being the datum having the highest frequency among the differential data, from each of the DPCMed differential data, which can reduce the range of differential data, a folding operation which converts the differential data into either a positive number region or a negative number region, and a predetermined number of cycles of DND operation, the apparatus comprising:

an entropy decoder (360) which entropy-decodes an input bitstream and outputs decoded differential data;
an inverse shift-up operator (356) which restores differential data having been encoded through a shift-up operation by performing a shift-down operation on them ;
an inverse DND operator (352) which depending on the order of DND read from the bitstream, either performs an inverse DND operation on the entropy-decoded differential data or bypasses them;
an inverse folding processor (340) which depending on the order of DND, either performs an inverse folding operation on the differential data input from the inverse DND operator so that the differential data can be divided into positive numbers and negative numbers or bypasses the differential data, wherein the inverse folding operation converts even numbers into positive data, and converts odd numbers into negative data;
an inverse shifte (330) which changes the range of the differential data input from the inverse DND operator or the inverse folding processor by adding the mode to the differential data;
an inverse DPCM processor (320) which restores the differential data having been through the inverse shifting operation and outputs quantized key data; and
an inverse quantizer (310) which inversely quantizes the restored quantized key data and outputs decoded key data,
wherein in the shift-down operation each of the entropy-decoded differential data is substracted from a maximum value among differential data having been through a DND operation if the entropy-decoded differential data having been greater than said maximum value.
wherein the DND operation comprises a divide operation performed on the differential data so as to divide the range of differential data into halves and so as to convert the differential data belonging to an upper range into negative values, and either a divide-up operation or a divide-down operation selectively performed on the results of the divide operation depending on the range of the results of the divide operation so as to reduce the range of differential data belonging to a negative number region or the positive number region, respectively,
wherein in the divide-up operation, data that are smaller than a predetermined reference value but not smaller than the half of the minimum input value are multiplied by a first constant, and data that are smaller than the half of the minimum input valueare subtracted from the minimum input value , the result of the subtraction is multiplied by the first constant, and a second constant is subtracted from the result of the multiplication,
wherein in the divide-down operation, for data that are greater than half of the maximum input value , the maximum input value is subtracted from the data, the result of the subtraction is multiplied by the first constant, and the second constant is subtracted from the result of the multiplication, and data that are smaller than the predetermined reference value are multiplied by the first constant,
and wherein the inverse DND operator performs an inverse DND operation as many times as the order of DND and performs an inverse divide operation on input differential data so as to extend their range if the maximum value nKeyMax among the differential data in the current cycle of inverse DND operation is not smaller than a predetermined first reference value and the current order of inverse DND operation is the same as 1, and
the inverse divide operation is **characterized by** the fact that if the differential data in the current cycle of inverse DND operation are smaller than a second reference value, they are added to nKeyMax and a predetermined constant.

**19.** The apparatus of claim 18, wherein the inverse folding processor divides the input differential data by a first constant if the input differential data are even numbers and divides the results of adding a second constant to the input differential data by a constant having the same absolute value as the first constant but a different sign if the input differential data are odd numbers.

**20.** The apparatus of claim 18 or 19, wherein the inverse DND operator performs an inverse DND operation as many times as the order of DND and performs an inverse divide-up operation on input differential data so as to extend their range if a maximum value nKeyMax among differential data in the current cycle of inverse DND operation is smaller than a predetermined reference value, and
the inverse divide-up operation is **characterized by** the fact that if the differential data in the current cycle of inverse DND operation have negative odd values, the results of dividing the differential data by the first constant and the second constant are subtracted from the maximum value nKeyMax among the differential data, and if the differential data in the current cycle of inverse DND operation have negative even values, they are divided by the first constant.

**21.** The apparatus of any of claims 18 to 20, wherein the inverse DND operator performs an inverse DND operation as many times as the order of DND and performs an inverse divide-down operation on input differential data so as to extend the range of the input differential data if the maximum value nKeyMax among the differential data in the current cycle of inverse DND operation is not smaller than the predetermined first reference value and the current order of inverse DND operation is not the same as 1, and
the inverse divide-down operation is **characterized by** the fact that if the differential data in the current cycle of inverse DND operation have odd values smaller than a second reference value, the results of dividing the differential data by the first constant and the second constant are added to nKeyMax, and if the differential data in the current cycle of inverse DND operation have even values smaller than the second reference value, they are divided by the first constant.

**22.** The apparatus of claim 18, further comprising:

a floating-point number inverse converter which extracts from the bitstream decimal numbers representing the beginning and ending key data of a linear key data region and decimal numbers representing maximum and minimum values used in the inverse quantizer, converts the decimal numbers into binary numbers, and outputs the binary numbers; and

a linear key decoder which decodes linear key data using the beginning and ending key data of the linear key data region, which are input from the floating-point number inverse converter, and adds the results of the decoding to the key data output from the inverse quantizer.

**23.** The apparatus of claim 22, further comprising a key header decoder which decodes header information required for decoding the encoded key data from the bitstream and provides the header information to at least one out of the entropy decoder, the inverse DND processor, the inverse shifter, the inverse DPCM processor, and the inverse quantizer.

**24.** The apparatus of claim 22 or 23, wherein the inverse DND processor performs an inverse DND operation as many times as the order of DND and performs an inverse divide-up operation on input differential data so as to extend their range if the maximum value nKeyMax among the differential data in the current cycle of inverse DND operation is smaller than a predetermined reference value, and
the inverse divide-up operation is **characterized by** the fact that if the differential data in the current cycle of inverse DND operation have negative odd values, the results of dividing the differential data by a first constant and a second constant are subtracted from the maximum value nKeyMax among the differential data, and if the differential data in the current cycle of inverse DND operation have negative even values, they are divided by the first constant.

**25.** The apparatus of any of claims 22 to 24, wherein the inverse DND processor performs an inverse DND operation as many times as the order of DND and performs an inverse divide-down operation on input differential data so as to extend their range if the maximum value nKeyMax among the differential data in the current cycle of inverse DND operation is not smaller than the predetermined first reference value and the current order of inverse DND operation is not the same as 1, and
the inverse divide-down operation is **characterized by** the fact that if the differential data in the current cycle of inverse DND operation have odd values smaller than a second reference value, the results of dividing the differential data by the first constant and the second constant are added to nKeyMax, and if the differential data in the current cycle of inverse DND operation have even values smaller than the second reference value, they are divided by the first constant.

**26.** The apparatus of any of claims 22 to 25, wherein the inverse DND processor performs an inverse DND operation as many times as the order of DND and performs an inverse divide operation on input differential data so as to extend their range if the maximum value nKeyMax among the differential data in the current cycle of inverse DND operation is not smaller than the predetermined first reference value and the current order of inverse DND operation is the same as 1, and
the inverse divide operation is **characterized by** the fact that if the differential data in the current cycle of inverse DND operation are smaller than a second reference value, they are added to nKeyMax and a predetermined constant.

**27.** The apparatus of any of claims 22 to 26, wherein the inverse DND processor checks based on the order of DND if the input differential data have not been through a DND operation, and outputs the differential data to the inverse folding processor if the differential data turn out to have been through a DND operation and outputs the differential data to the inverse shifter if the differential data turn out to not have been through a DND operation and a folding operation.

**28.** The apparatus of any of claims 22 to 27, wherein the inverse folding processor divides the input differential data by the first constant if the input differential data are even numbers and divides the results of adding the second constant to the input differential data by a constant having the same absolute value as the first constant but a different sign if the input differential data are odd numbers.

**29.** The apparatus of any of claims 22 to 28, wherein the inverse quantizer inversely quantizes the quantized key data input from the inverse DPCM processor by multiplying the result of dividing the difference between the maximum and minimum value, which have been used for quantization of the key data and are input from the floating-point number inverse converter, by a quantization step size by the quantized key data and adding the minimum value to the results of the multiplication.

**30.** A bitstream, into which key data, which are information on the location of a keyframe on a temporal axis, are encoded in a keyframe-based graphic animation, the bitstream comprising:

key data quantization information which includes the number of key data to be quantized, a predetermined number of bits used for quantization, and maximum and minimum values among key data quantized with the predetermined number of bits;
DPCM operation information which includes the order of DPCM operation which is performed on the quantized key data so as to generate differential data and intra key data in each cycle of DPCM operation;
a shift mode, being a differential datum having the highest frequency among the differential data, which is used for a shifting operation where differential data of the key data are transferred as much as the shift mode so as to reduce the range of the differential data; and
DND operation information which includes the order of DND operation, which is the number of cycles of DND operation for reducing the range of differential data having been through the shift operation and a folding operation which converts the differential data into either a positive number region or a negative number region, maximum and minimum values among differential data having been through a DND operation, and a flag indicating whether or not the differential data having been through a DND operation have also been through a shift-up operation, wherein the shift-up operation comprises subtracting each of the differential data having been through the DND operation from the maximum value nKeyMax among them if they are smaller than the predetermined reference value; and
information on encoded key data, into which the differential data having been through a DND operation are entropy-encoded,
wherein the DND operation comprises a divide operation performed on the converted differential data so as to divide the range of differential data into halves and so as to convert one half of the differential data belonging to an upper range nto negative values, and either a divide-up operation or a divide-down operation selectively performed on the results of the divide operation depending on the range of the results of the divide operation so as to reduce the range of differential data belonging to a negative number region or the positive number region, respectively,
wherein in the divide-up operation, data that are smaller than a predetermined reference value but not smaller than the half of the minimum input value nKeyMin are multiplied by a first constant, and data that are smaller than nKeyMin/2 are subtracted from nKeyMin, the result of the subtraction is multiplied by the first constant, and a second constant is subtracted from the result of the multiplication, and
wherein in the divide-down operation, for data that are greater than half of the maximum input value nKeyMax, nKeyMax is subtracted from the data, the result of the subtraction is multiplied by the first constant, and the second constant is subtracted from the result of the multiplication, and data that are smaller than the predetermined reference value are multiplied by the first constant.

**31.** The bitstream of claim 30 further comprising:

a flag which indicates whether or not a linear key region where key data linearly increases in input key data;
the number of key data included in the linear key region; and
beginning and ending key data of the linear key region.

**32.** The bitstream of claim 31, where the beginning and ending key data of the linear key region are each represented by a mantissa and an exponent.

**33.** The bitstream of claim 31 or 32, wherein the maximum and minimum values among the quantized key data are used to minimize a quantization error of the quantized key data.

**34.** A computer program comprising computer program code means for executing all of the steps of any of claims 31 to 33 when said program is run on a computer.

**35.** A computer program as claimed in claim 34 embodied on a computer readable medium.

## Patentansprüche

**1.** Vorrichtung zum Codieren von DPC-modulierten Differentialdaten von Schlüsseldaten, die Informationen über die Orte von Keyframes auf einer Zeitachse sind, wobei die Vorrichtung Folgendes umfasst:

einen Schieber (230), der ein Differentialdatenelement, nachfolgend Mode genannt, mit der größten Häufigkeit unter den Differentialdaten einholt und die Mode von den einzelnen Differentialdaten subtrahiert;
einen Faltungsprozessor (240), der die verschobenen Differentialdaten in eine positive Zahlenregion oder in eine negative Zahlenregion umwandelt, so dass positive Daten in gerade Zahlen und negative Daten in ungerade Zahlen umgewandelt werden;
einen DND-Prozessor (250), der unter Berücksichtigung der Beziehung zwischen den umgewandelten Differentialdaten und Maximal- und Minimalwerten darunter eine DND-Operation an den umgewandelten Differentialdaten durchführt, um deren Bereich zu verkleinern, Daten aus den folgenden auswählt: vom Schieber eingegebene Differentialdaten, vom Faltungsprozessor eingegebene Differentialdaten, die DND-Operation durchlaufene Differentialdaten sowie eine Aufwärtsschiebeoperation und die DND-Operation durchlaufene Differentialdaten; und die gewählten Differentialdaten ausgibt;
einen Entropie-Codierer (260), der die vom DND-Prozessor eingegebenen Differentialdaten Entropie-codiert;
wobei die DND-Operation eine Division (53630) beinhaltet, die an den umgewandelten Differentialdaten ausgeführt wird, um den Differentialdatenbereich in Hälften zu dividieren und somit die zu einem höheren Bereich gehörenden Differentialdaten in negative Werte umzuwandeln, und entweder eine Aufwärtsdivision oder eine Abwärtsdivision selektiv an den Divisionsergebnissen durchgeführt wird, je nach dem Divisionsergebnisbereich, um den Bereich von Differentialdaten zu verkleinern, die zu einer negativen Zahlregion bzw. zu der positiven Zahlregion gehören,
wobei in der Aufwärtsdivision (53638) Daten, die kleiner sind als ein vorbestimmter Referenzwert, aber nicht kleiner sind als die Hälfte des minimalen Eingabewertes nKeyMin, mit einer ersten Konstante multipliziert werden, und Daten, die kleiner sind als nKeyMin/2, von nKeyMin subtrahiert werden, das Subtraktionsergebnis mit der ersten Konstante multipliziert wird und eine zweite Konstante vom Ergebnis der Multiplikation subtrahiert wird,
wobei in der Abwärtsdivision (53634) für Daten, die größer als die Hälfte des maximalen Eingabewertes nKeyMax sind, nKeyMax von den Daten subtrahiert wird, das Ergebnis der Subtraktion mit der ersten Konstante multipliziert und die zweite Konstante vom Ergebnis der Multiplikation subtrahiert wird, und Daten, die kleiner sind als der vorbestimmte Referenzwert, mit der ersten Konstante multipliziert werden,
und wobei die Aufwärtsschiebeoperation (256) das Subtrahieren der einzelnen die DND-Operation durchlaufenen Differentialdaten vom Maximalwert nKeyMax darunter beinhaltet, wenn sie kleiner sind als ein vorbestimmter Referenzwert.

2. Vorrichtung nach Anspruch 1, wobei der Faltungsprozessor, wenn die vom Schieber eingegebenen Referenzdaten größer sind als ein vorbestimmter Referenzwert, die Differentialdaten mit einer ersten Konstante multipliziert, und wenn die Differentialdaten kleiner sind als der vorbestimmte Referenzwert, den Absolutwert der einzelnen Differentialdaten mit der ersten Konstante multipliziert und eine zweite Konstante von jedem der Ergebnisse der Multiplikation subtrahiert.

3. Vorrichtung nach Anspruch 1 oder 2, wobei der DND-Prozessor Folgendes umfasst:

einen DND-Operator, der eine DND-Operation an den vom Faltungsprozessor eingegebenen Differentialdaten ausführt;
einen ersten Differentialdatenselektor, der eines aus den Folgenden auswählt: die Schiebeoperation durchlaufene Differentialdaten, die Faltungsoperation durchlaufene Differentialdaten und die DND-Operation durchlaufene Differentialdaten, und die gewählten Differentialdaten ausgibt;
einen Aufwärtsschiebeoperator, der, wenn die die DND-Operation durchlaufenen Differentialdaten vom ersten Differentialdatenselektor eingegeben werden, die Aufwärtsschiebeoperation an den Differentialdaten ausführt; und
einen zweiten Differentialdatenselektor, der selektiv die die DND-Operation durchlaufenen Differentialdaten oder die die Aufwärtsschiebeoperation durchlaufenen Differentialdaten ausgibt.

4. Vorrichtung nach Anspruch 3, wobei bei der Division ein Maximalwert nKeyMax unter den eingegebenen Differentialdaten und eine vorbestimmte Konstante von den einzelnen eingegeben Differentialdaten subtrahiert werden, wenn die eingegebenen Differentialdaten größer sind als $\frac{nKeyMax}{2}$. .

5. Vorrichtung nach Anspruch 3 oder Anspruch 4, wobei der DND-Operator die DND-Operation an den Differentialdaten mit einer vorbestimmten Häufigkeit durchführt, um die Ergebnisse eines bestimmten DND-Operationszyklus auszugeben, in dem die zum Codieren benötigte Anzahl von Bits minimiert werden kann.

6. Vorrichtung nach einem der Ansprüche 3 bis 5, wobei der erste Differentialdatenselektor aus den jeweils vom Schieber, vom Faltungsprozessor und vom DND-Operator eingegebenen Differentialdaten diejenigen auswählt, die eine geringste Anzahl von zum Codieren benötigten Bits haben, und die gewählten Differentialdaten ausgibt.

**7.** Vorrichtung nach einem der Ansprüche 3 bis 6, wobei der erste Differentialdatenselektor, wenn die vom Schieber oder vom Faltungsprozessor eingegebenen Differentialdaten gewählt werden, die gewählten Differentialdaten an den Entropie-Codierer ausgibt.

**8.** Vorrichtung nach einem der Ansprüche 3 bis 7, wobei der zweite Differentialdatenselektor den Dispersionsgrad der die DND-Operation durchlaufenen Differentialdaten und den Dispersionsgrad der die Aufwärtsschiebeoperation durchlaufenen Differentialdaten misst und die mit einem geringeren Dispersionsgrad der beiden ausgibt.

**9.** Vorrichtung zum Codieren von Schlüsseldaten, wobei die Vorrichtung Folgendes umfasst:

einen Linear-Schlüssel-Codierer, der in eingegebenen Schlüsseldaten eine Region identifiziert, in der Schlüsseldaten linear zunehmen, und die lineare Schlüsseldatenregion codiert;
einen Quantisierungsfehler-Minimierer, der Maximal - und Minimalwerte unter den eingegebenen Schlüsseldaten justiert, so dass ein Quantisierungsfehler minimiert werden kann, und die justierten Maximal- und Minimalwerte ausgibt;
einen Quantisierer, der die eingegebenen Schlüsseldaten mit vorbestimmten Quantisierungsbits unter Verwendung der vom Quantisierungsfehler-Minimierer eingegebenen Maximal- und Minimalwerte quantisiert;
einen Gleitkommazahlenwandler, der binäre Zahlen, die die Anfangs- und Endschlüsseldaten der vom Linear-Schlüssel-Codierer eingegebenen linearen Schlüsseldatenregion repräsentieren, und binäre Zahlen, die die vom Quantisierungsfehler-Minimierer eingegebenen maximalen und minimalen Werte repräsentieren, in Dezimalzahlen umwandelt;
einen DPCM-Prozessor, der Differentialdaten der quantisierten Schlüsseldaten erzeugt;
die Vorrichtung von Anspruch 1; und
einen Schlüssel-Header-Codierer, der Schlüssel-Header-Daten anhand von zum Codieren benötigten Daten erzeugt, die von wenigstens einem aus Linear-Schlüssel-Codierer, Quantisierer, Gleitkommazahlenwandler, DPCM-Prozessor, Schieber, Faltungsprozessor, DND-Prozessor und Entropie-Codierer eingegeben werden.

**10.** Vorrichtung nach Anspruch 9, wobei der Linear-Schlüssel-Codierer ermittelt, dass die lineare Schlüsseldatenregion kollinear ist, wenn ein maximaler Fehler zwischen den Schlüsseldaten in der linearen Schlüsseldatenregion und linear vorhergesagten Schlüsseldaten in einer arbiträren Schlüsseldatenregion nicht größer ist als ein vorbestimmter kritischer Wert.

**11.** Vorrichtung nach Anspruch 9 oder 10, wobei der Quantisierer die eingegebenen Schlüsseldaten in Werte eines vorbestimmten Bereichs anhand der Maximal- und Minimalwerte aus den eingegebenen Schlüsseldaten umwandelt und die Werte mit den vorbestimmten Quantisierungsbits quantisiert.

**12.** Vorrichtung nach einem der Ansprüche 9 bis 11, wobei der Quantisierungsfehler-Minimierer die eingegebenen Schlüsseldaten in Werte eines vorbestimmten Bereichs anhand von arbiträren Maximal- und Minimalwerten umwandelt, die Werte mit den vorbestimmten Quantisierungsbits quantisiert, die quantisierten Schlüsseldaten invers quantisiert und die Maximal- und Minimalwerte einholt und ausgibt, die die Summe von Fehlern zwischen den eingegebenen Schlüsseldaten und den invers quantisierten Schlüsseldaten minimieren können.

**13.** Vorrichtung nach einem der Ansprüche 9 bis 12, wobei der Gleitkommazahlenwandler binäre Zahlen, die in der Form $mantissa_binary*2^{exponent_binary}$ ausgedrückt sind, in Dezimalzahlen umwandelt, die in der Form $mantissa*10^{exposant}$ ausgedrückt sind.

**14.** Vorrichtung nach einem der Ansprüche 9 bis 13, wobei der Faltungsprozessor, wenn die vom Schieber eingegebenen Differentialdaten größer sind als ein vorbestimmter Referenzwert, sie mit einer ersten Konstante multipliziert, und wenn sie kleiner sind als der vorbestimmte Referenzwert, ihre Absolutwerte mit der ersten Konstante multipliziert und dann eine zweite Konstante von jedem der Ergebnisse der Multiplikation subtrahiert.

**15.** Vorrichtung nach einem der Ansprüche 9 bis 14, wobei der DND-Prozessor Folgendes umfasst:

einen DND-Operator, der eine DND-Operation an den vom Faltungsprozessor eingegebenen Differentialdaten ausführt;

einen ersten Differentialdatenselektor, der eines der Folgenden auswählt: die Verschiebeoperation durchlaufene Differentialdaten, die Faltungsoperation durchlaufene Differentialdaten und die DND-Operation durchlaufene Differentialdaten, und die gewählten Differentialdaten ausgibt;
einen Aufwärtsschiebeoperator, der, wenn die die DND-Operation durchlaufenen Differentialdaten vom ersten Differentialdatenselektor eingegeben werden, die Aufwärtsschiebeoperation an den Differentialdaten ausführt; und
einen zweiten Differentialdatenselektor, der selektiv die die DND-Operation durchlaufenen Differentialdaten oder die die Aufwärtsschiebeoperation durchlaufenen Differentialdaten ausgibt.

**16.** Vorrichtung nach Anspruch 15, wobei der DND-Operator eine DND-Operation an den vom Faltungsprozessor eingegebenen Differentialdaten ausführt, um den zu codierenden Differentialdatenbereich zu verkleinern, und insbesondere in der DND-Operation eine Division an den Differentialdaten durchgeführt wird, um den Differentialdatenbereich in einer positiven Zahlenregion in Hälften zu dividieren und um eine Hälfte der zu einem höheren Bereich gehörenden Differentialdaten als die andere Hälfte in negative Werte umzuwandeln und entweder eine Aufwärtsdivision oder eine Abwärtsdivision an den Divisionsergebnissen durchgeführt wird, je nach dem Bereich der die Division durchlaufenen Differentialdaten, um den Bereich der Differentialdaten zu reduzieren, die zur negativen Zahlenregion bzw. zur positiven Zahlenregion gehören.

**17.** Vorrichtung nach einem der Ansprüche 9 bis 16, wobei der Schlüssel-Header-Codierer die Zahl der zu codierenden Schlüsseldaten und die Stellenanzahl der Schlüsseldaten erhält, die Größe von Quantisierungsbits und die zum Quantisieren vom Quantisierer benutzten Maximal- und Minimalwerte erhält, Informationen darüber erhält, ob eine lineare Schlüsselregion existiert, die eine lineare Schlüsselcodierung durchlaufen hat, und die Zahl von linearen Schlüsseldaten vom Linear-Schlüssel-Codierer, die Anfangs- und Endschlüsseldaten der linearen Schlüsselregion vom Gleitkommazahlenwandler erhält, die Zahl der DPC-Modulationen, d.h. die DPCM-Ordnung, und Intra-Schlüsseldaten in jedem DPCM-Zyklus vom DPCM-Prozessor erhält, die Mode vom Schieber erhält, die Zahl der DND-Durchführungen, d.h. die DND-Ordnung, und die für eine DND-Operation benutzten Maximal- und Minimalwerte erhält, und das Einbeziehen aller Eingaben in einen Key-Header zulässt.

**18.** Vorrichtung zum Decodieren eines codierten Bitstroms, der durch Ausführen einer Quantisierungsoperation und einer vorbestimmten Anzahl von DPCM-Operationszyklen an Schlüsseldaten codiert wird, die Informationen über den Ort eines Keyframe auf einer Zeitachse sind, und dann wenigstens eine der folgenden Operationen ausführt: eine Schiebeoperation, die das Subtrahieren der Mode, die das Datenelement mit der größten Häufigkeit unter den Differentialdaten ist, von allen DPC-modulierten Differentialdaten beinhaltet, die den Bereich der Differentialdaten verkleinern können, eine Faltungsoperation, die die Differentialdaten in eine positive Zahlenregion oder eine negative Zahlenregion umwandelt, und eine vorbestimmte Anzahl von DND-Operationszyklen, wobei die Vorrichtung Folgendes umfasst:

einen Entropie-Decoder (360), der einen Eingangsbitstrom Entropie-decodiert und decodierte Differentialdaten ausgibt;
einen Inverse-Aufwärtsschiebe-Operator (356), der durch eine Aufwärtsschiebeoperation codierte Differentialdaten durch Ausführen einer Aufwärtsschiebeoperation daran wiederherstellt;
einen Inverse-DND-Operator (352), der je nach der vom Bitstrom gelesenen DND-Ordnung entweder eine inverse DND-Operation an den Entropie-decodierten Differentialdaten ausführt oder sie umgeht;
einen Inverse-Faltungsprozessor (340), der je nach der DND-Ordnung entweder eine inverse Faltungsoperation an den vom Inverse-DND-Operator eingegebenen Differentialdaten ausführt, so dass die Differentialdaten in positive Zahlen oder negative Zahlen dividiert werden können, oder die Differentialdaten umgeht, wobei die inverse Faltungsoperation gerade Zahlen in positive Daten umwandelt und ungerade Zahlen in negative Daten umwandelt;
einen Inverse-Schieber (330), der den Bereich der vom Inverse-DND-Operator oder vom Inverse-Faltungsprozessor eingegebenen Differentialdaten durch Hinzufügen der Mode zu den Differentialdaten ändert;
einen Inverse-DPCM-Prozessor (320), der die die inverse Schiebeoperation durchlaufenen Differentialdaten wiederherstellt und quantisierte Schlüsseldaten ausgibt; und
einen Inverse-Quantisierer (310), der die wiederhergestellten quantisierten Schlüsseldaten invers quantisiert und decodierte Schlüsseldaten ausgibt;
wobei in der Aufwärtsschiebeoperation die einzelnen Entropie-decodierten Differentialdaten von einem Maximalwert unter den eine DND-Operation durchlaufenen Differentialdaten subtrahiert werden, wenn die Entropiedecoderten Differentialdaten größer sind als der genannte Maximalwert;
wobei die DND-Operation eine Division beinhaltet, die an den Differentialdaten durchgeführt wird, um den Differentialdatenbereich in Hälften zu dividieren und um die zu einem höheren Bereich gehörenden Differentialdaten in negative Werte umzuwandeln und eine Aufwärtsdivision oder eine Abwärtsdivision an den Divisionsergebnissen durchgeführt wird, je nach dem Divisionsergebnisbereich, um den Bereich von Differentialdaten, die zu einer negativen Zahlenregion bzw. der positiven Zahlenregion gehören, zu verkleinern,
wobei bei der Aufwärtsdivision Daten, die kleiner sind als ein vorbestimmter Referenzwert, aber nicht kleiner als die Hälfte des minimalen Eingabewerts, mit einer ersten Konstante multipliziert werden, und Daten, die kleiner sind als die Hälfte des minimalen Eingabewerts, vom minimalen Eingabewert subtrahiert werden, das Subtraktionsergebnis mit der ersten Konstante multipliziert und eine zweite Konstante vom Ergebnis der Multiplikation subtrahiert wird,
wobei in der Abwärtsdivision für Daten, die größer sind als die Hälfte des maximalen Eingabewerts, der maximale Eingabewert von den Daten subtrahiert wird, das Subtraktionsergebnis mit der ersten Konstante multipliziert und die zweite Konstante vom Ergebnis der Multiplikation subtrahiert wird, und Daten, die kleiner sind als der vorbestimmte Referenzwert, mit der ersten Konstante multipliziert werden,
und wobei der Inverse-DND-Operator eine inverse DND-Operation so häufig wie die DND-Ordnung durchführt und eine inverse Division an eingegebenen Differentialdaten durchführt, um ihren Bereich zu vergrößern, wenn der Maximalwert nKeyMax unter den Differentialdaten im aktuellen Inverse-DND-Operationszyklus nicht kleiner ist als ein vorbestimmter erster Referenzwert und die aktuelle Inverse-DND-Operationsordnung dieselbe ist wie 1, und
die inverse Division **dadurch gekennzeichnet ist, dass** die Differentialdaten, wenn sie im aktuellen Inverse-DND-Operationszyklus kleiner sind als ein zweiter Referenzwert, zu nKeyMax und einer vorbestimmten Konstante addiert werden.

**19.** Vorrichtung nach Anspruch 18, wobei der Inverse-Faltungsprozessor die eingegebenen Differentialdaten durch eine erste Konstante dividiert, wenn die eingegebenen Differentialdaten gerade Zahlen sind, und die Ergebnisse des Addierens einer zweiten Konstante zu den eingegebenen Differentialdaten durch eine Konstante mit demselben Absolutwert wie die erste Konstante, aber mit einem anderen Vorzeichen, dividiert, wenn die eingegebenen Differentialdaten ungerade Zahlen sind.

**20.** Vorrichtung nach Anspruch 18 oder 19, wobei der Inverse-DND-Operator eine inverse DND-Operation so häufig wie die DND-Ordnung durchführt und eine inverse Aufwärtsdivision an eingegebenen Differentialdaten durchführt, um ihren Bereich zu vergrößern, wenn ein Maximalwert nKeyMax unter Differentialdaten im aktuellen Inverse-DND-Operationszyklus kleiner ist als ein vorbestimmter Referenzwert, und
die inverse Aufwärtsdivision **dadurch gekennzeichnet ist, dass**, wenn die Differentialdaten im aktuellen Inverse-DND-Operationszyklus negative ungerade Werte haben, die Ergebnisse der Division der Differentialdaten durch die erste Konstante und die zweite Konstante vom Maximalwert nKeyMax unter den Differentialdaten subtrahiert werden, und wenn die Differentialdaten im aktuellen Inverse-DND-Operationszyklus negative gerade Werte haben, sie durch die erste Konstante dividiert werden.

**21.** Vorrichtung nach einem der Ansprüche 18 bis 20, wobei der Inverse-DND-Operator eine inverse DND-Operation so häufig wie die DND-Ordnung ausführt und eine inverse Abwärtsdivision an eingegebenen Differentialdaten durchführt, um den Bereich der eingegebenen Differentialdaten zu vergrößern, wenn der Maximalwert nKeyMax unter den Differentialdaten im aktuellen inversen DND-Operationszyklus nicht kleiner ist als der vorbestimmte erste Referenzwert und die aktuelle inverse DND-Operationsordnung nicht dieselbe ist wie 1, und
die inverse Abwärtsdivision **dadurch gekennzeichnet ist, dass**, wenn die Differentialdaten im aktuellen inversen DND-Operationszyklus ungerade Werte haben, die kleiner sind als ein zweiter Referenzwert, die Ergebnisse der Division der Differentialdaten durch die erste Konstante und die zweite Konstante zu nKeyMax addiert werden, und wenn die Differentialdaten im aktuellen inversen DND-Operationszyklus geradzahlige Werte haben, die kleiner sind als der zweite Referenzwert, sie durch die erste Konstante dividiert werden.

**22.** Vorrichtung nach Anspruch 18, die ferner Folgendes umfasst:

einen Gleitkommazahl-Inverse-Wandler, der aus dem Bitstrom die Anfangs- und Endschlüsseldaten einer linearen Schlüsseldatenregion repräsentierende Dezimalzahlen und im Inverse-Quantisierer verwendete Maximal- und Minimalwerte repräsentierende Dezimaldaten extrahiert, die Dezimalzahlen in Binärzahlen umwandelt und die Binärzahlen ausgibt; und
einen Linear-Schlüssel-Decoder, der lineare Schlüsseldaten anhand der Anfangs- und Endschlüsseldaten der linearen Schlüsseldatenregion decodiert, die vom Gleitkommazahl-Inverse-Wandler eingegeben werden, und die Ergebnisse der Decodierung zu den vom Inverse-Quantisierer ausgegebenen Schlüsseldaten addiert.

**23.** Vorrichtung nach Anspruch 22, die ferner einen Key-Header-Decoder umfasst, der Header-Informationen decodiert, die zum Decodieren der codierten Schlüsseldaten aus dem Bitstrom benötigt werden, und die Header-Informationen zu wenigstens einem aus Entropie-Decoder, Inverse-DND-Prozessor, Inverse-Schieber, Inverse-DPCM-Prozessor und Inverse-Quantisierer überträgt.

**24.** Vorrichtung nach Anspruch 22 oder 23, wobei der Inverse-DND-Prozessor eine Inverse-DND-Operation so häufig wie die DND-Ordnung ausführt und eine inverse Aufwärtsdivision an eingegebenen Differentialdaten durchführt, um deren Bereich zu vergrößern, wenn der Maximalwert nKeyMax unter den Differentialdaten im aktuellen Inverse-DND-Operationszyklus kleiner ist als ein vorbestimmter Referenzwert, und
die inverse Aufwärtsdivision **dadurch gekennzeichnet ist, dass**, wenn die Differentialdaten im aktuellen Inverse-DND-Operationszyklus negative ungeradzahlige Werte haben, die Ergebnisse der Division der Differentialdaten durch eine erste Konstante und eine zweite Konstante vom Maximalwert nKeyMax unter den Differentialdaten subtrahiert werden, und wenn die Differentialdaten im aktuellen Inverse-DND-Operationszyklus negative geradzahlige Werte haben, sie durch die erste Konstante dividiert werden.

**25.** Vorrichtung nach einem der Ansprüche 22 bis 24, wobei der Inverse-DND-Prozessor eine inverse DND-Operation so häufig wie die DND-Ordnung durchführt und eine inverse Abwärtsdivision an eingegebenen Differentialdaten durchführt, um deren Bereich zu vergrößern, wenn der Maximalwert nKeyMax unter den Differentialdaten im aktuellen Inverse- DND-Operationszyklus nicht kleiner ist als ein vorbestimmter erster Referenzwert und die aktuelle inverse DND-Operationsordnung nicht gleich 1 ist, und
die inverse Abwärtsdivision **dadurch gekennzeichnet ist, dass**, wenn die Differentialdaten im aktuellen Inverse-DND-Operationszyklus ungeradzahlige Werte haben, die kleiner sind als ein zweiter Referenzwert, die Ergebnisse der Division der Differentialdaten durch die erste Konstante und die zweite Konstante zu nKeyMax addiert werden, und wenn die Differentialdaten im aktuellen Inverse-DND-Operationszyklus geradzahlige Werte haben, die kleiner sind als der zweite Referenzwert, sie durch die erste Konstante dividiert werden.

**26.** Vorrichtung nach einem der Ansprüche 22 bis 25, wobei der Inverse-DND-Prozessor eine inverse DND-Operation so häufig wie die DND-Ordnung ausführt und eine inverse Division an eingegebenen Differentialdaten durchführt, um deren Bereich zu vergrößern, wenn der Maximalwert nKeyMax unter den Differentialdaten im aktuellen Inverse-DND-Operationszyklus nicht kleiner ist als der vorbestimmte erste Referenzwert und die aktuelle Inverse-DND-Operationsordnung gleich 1 ist, und
die inverse Division **dadurch gekennzeichnet ist, dass** die Differentialdaten, wenn sie im aktuellen Inverse-DND-Operationszyklus kleiner sind als ein zweiter Referenzwert, zu nKeyMax und einer vorbestimmten Konstante addiert werden.

**27.** Vorrichtung nach einem der Ansprüche 22 bis 26, wobei der Inverse-DND-Prozessor auf der Basis der DND-Ordnung prüft, ob die eingegebenen Differentialdaten keine DND-Operation durchlaufen haben, und die Differentialdaten an den Inverse-Faltungsprozessor ausgibt, wenn festgestellt wird, dass die Differentialdaten eine DND-Operation durchlaufen haben, und die Differentialdaten an den Inverse-Schieber ausgibt, wenn festgestellt wird, dass die Differentialdaten eine DND-Operation und eine Faltungsoperation durchlaufen haben.

**28.** Vorrichtung nach einem der Ansprüche 22 bis 27, wobei der Inverse-Faltungsprozessor die eingegebenen Differentialdaten durch die erste Konstante dividiert, wenn die eingegebenen Differentialdaten gerade Zahlen sind, und die Ergebnisse des Addierens der zweiten Konstante zu den eingegebenen Differentialdaten durch eine Konstante mit demselben Absolutwert wie die erste Konstante, aber mit einem anderen Vorzeichen, dividert, wenn die eingegebenen Differentialdaten ungerade Zahlen sind.

**29.** Vorrichtung nach einem der Ansprüche 22 bis 28, wobei der Inverse-Quantisierer die vom Inverse-DPCM-Prozessor eingegebenen quantisierten Schlüsseldaten durch Multiplizieren des Ergebnisses der Division der Differenz zwischen dem Maximal- und dem Minimalwert, die zum Quantisieren der Schlüsseldaten verwendet wurden und vom Gleitkommazahl-Inverse-Wandler eingegeben werden, durch eine Quantisierungsschrittgröße durch die quantisierten Schlüsseldaten invers quantisiert und den Maximalwert zu den Ergebnissen der Multiplikation addiert.

**30.** Bitstrom, in den Schlüsseldaten, die Informationen über den Ort eines Keyframe auf einer Zeitachse sind, in eine grafische Animation auf Keyframe-Basis codiert werden, wobei der Bitstrom Folgendes umfasst:

Schlüsseldaten-Quantisierungsinformationen, die die Zahl von zu quantisierenden Schlüsseldaten, eine vorbestimmte Anzahl von zur Quantisierung verwendeten Bits und Maximal- und Minimalwerte unter Schlüsseldaten enthalten, die mit der vorbestimmten Anzahl von Bits quantisiert werden;
DPCM-Operationsinformationen, die die Ordnung der DPCM-Operation enthalten, die an den quantisierten Schlüsseldaten ausgeführt wird, um Differentialdaten und Intra-Schlüsseldaten in jedem DPCM-Operationszyklus zu erzeugen;
eine Schiebemode, die ein Differentialdatenelement mit der größten Häufigkeit unter den Differentialdaten ist, die für eine Schiebeoperation verwendet wird, wobei Differentialdaten der Schlüsseldaten so häufig wie die Schiebemode übertragen werden, um den Differentialdatenbereich zu verkleinern; und
DND-Operationsinformationen, die die DND-Operationsordnung beinhalten, die die Anzahl von DND-Operationszyklen sind, um den Bereich von die Schiebeoperation und eine Faltungsoperation durchlaufenen Differentialdaten zu verkleinern, die die Differentialdaten in eine positive Zahlenregion oder eine negative Zahlenregion umwandelt, Maximal- und Minimalwerte unter eine DND-Operation durchlaufenen Differentialdaten, und einen Flag, der anzeigt, ob die eine DND-Operation durchlaufenen Differentialdaten auch eine Aufwärtsschiebeoperation durchlaufen haben oder nicht, wobei die Aufwärtsschiebeoperation das Subtrahieren aller die DND-Operation durchlaufenen Differentialdaten vom Maximalwert nKeyMax unter ihnen beinhaltet, wenn sie kleiner sind als der vorbestimmte Referenzwert; und
Informationen über codierte Schlüsseldaten, in die die eine DND-Operation durchlaufenen Differentialdaten Entropie-codiert werden,
wobei die DND-Operation eine Division beinhaltet, die an den umgewandelten Differentialdaten durchgeführt wird, um den Differentialdatenbereich in Hälften zu dividieren und um eine Hälfte der zu einem höheren Bereich gehörenden Differentialdaten in negative Daten umzuwandeln, und entweder eine Aufwärtsdivision oder eine Abwärtsdivision selektiv an den Ergebnissen der Division durchgeführt wird, je nach dem Bereich der Ergebnisse der Division, um den zu einer negativen Zahlenregion bzw. zur positiven Zahlenregion gehörenden Differentialdatenbereich zu verkleinern,
wobei in der Aufwärtsdivision Daten, die kleiner sind als ein vorbestimmter Referenzwert, aber nicht kleiner als die Hälfte des minimalen Eingabewertes nKeyMin, mit einer ersten Konstante multipliziert werden, und Daten, die kleiner sind als nKeyMin/2, von nKeyMin subtrahiert werden, das Subtraktionsergebnis mit der ersten Konstante multipliziert und eine zweite Konstante vom Ergebnis der Multiplikation subtrahiert wird, und
wobei in der Abwärtsdivision für Daten, die größer sind als die Hälfte des maximalen Eingabewertes nKeyMax, nKeyMax von den Daten subtrahiert wird, das Subtraktionsergebnis mit der ersten Konstante multipliziert und die zweite Konstante vom Ergebnis der Multiplikation subtrahiert wird, und Daten, die kleiner sind als der vorbestimmte Referenzwert, mit der ersten Konstante multipliziert werden.

**31.** Bitstrom nach Anspruch 30, der ferner Folgendes umfasst:

einen Flag, der anzeigt, ob eine lineare Schlüsselregion, wo Schlüsseldaten linear in Eingabeschlüsseldaten zunehmen;
die Anzahl von Schlüsseldaten, die in der linearen Schlüsselregion enthalten sind; und
Anfangs- und Endschlüsseldaten der linearen Schlüsselregion.

**32.** Bitstrom nach Anspruch 31, wobei die Anfangs- und Endschlüsseldaten der linearen Schlüsselregion jeweils durch eine Mantisse und einen Exponent repräsentiert werden.

**33.** Bitstrom nach Anspruch 31 oder 32, wobei die Maximal - und Minimalwerte unter den quantisierten Schlüsseldaten zum Minimieren eines Quantisierungsfehlers der quantisierten Schlüsseldaten verwendet werden.

**34.** Computerprogramm, das Computerprogrammcode zum Ausführen aller Schritte nach einem der Ansprüche 31 bis 33 enthält, wobei das genannte Programm auf einem Computer abgearbeitet wird.

**35.** Computerprogramm nach Anspruch 34, das auf einem rechnerlesbaren Medium ausgestaltet ist.

**Revendications**

**1.** Appareil de codage de données différentielles MICDées de données clés, lesquelles sont des informations sur les positions d'images clés sur un axe de temps, l'appareil comprenant :

un dispositif de décalage (230) qui obtient une donnée différentielle, ci-après mode, ayant la plus haute fréquence parmi les données différentielles et qui soustrait le mode de chacune des données différentielles ;

un processeur de transformation (240) qui convertit les données différentielles décalées en une région de nombres positifs ou une région de nombres négatifs, de telle sorte que les données positives soient converties en nombres pairs, et les données négatives soient converties en nombres impairs ;
un processeur DND (250) qui selon la relation entre les données différentielles converties et des valeurs maximum et minimum entre elles, exécute une opération DND sur les données différentielles converties de manière à réduire leur plage, sélectionne l'une des données différentielles entrées depuis le dispositif de décalage, des données différentielles entrées depuis le processeur de transformation, des données différentielles ayant subi l'opération DND, et des données différentielles ayant subi une opération de décalage ascendant ainsi que l'opération DND, et produit en sortie les données différentielles sélectionnées ; et
un codeur entropique (260) qui code entropiquement les données différentielles entrées depuis le processeur DND ;
dans lequel l'opération DND comprend une opération de division (53630) exécutée sur les données différentielles converties de manière à diviser la plage de données différentielles en moitiés et à convertir les données différentielles appartenant à une plage supérieure en valeurs négatives, et soit une opération de division ascendante, soit une opération de division descendante exécutée sélectivement sur les résultats de l'opération de division en fonction de la plage des résultats de l'opération de division de manière à réduire la plage de données différentielles appartenant à une région de nombres négatifs ou à la région de nombres positifs, respectivement,
dans lequel dans l'opération de division ascendante (53638), les données qui sont inférieures à une valeur de référence prédéterminée mais non inférieures à la moitié de la valeur d'entrée minimum nKeyMin sont multipliées par une première constante, et les données qui sont inférieures à nKeyMin/2 sont soustraites de nKeyMin, le résultat de la soustraction est multiplié par la première constante, et une seconde constante est soustraite du résultat de la multiplication,
dans lequel dans l'opération de division descendante (53634), pour les données qui sont supérieures à la moitié de la valeur d'entrée maximum nKeyMax, nKeyMax est soustrait des données, le résultat de la soustraction est multiplié par la première constante, et la seconde constante est soustraite du résultat de la multiplication, et les données qui sont inférieures à la valeur de référence prédéterminée sont multipliées par la première constante,
et dans lequel l'opération de décalage ascendant (256) comprend la soustraction de chacune des données différentielles ayant subi l'opération DND de la valeur maximum nKeyMax entre elles si elles sont inférieures à une valeur de référence prédéterminée.

2. Appareil selon la revendication 1, dans lequel si les données différentielles entrées depuis le dispositif de décalage sont supérieures à une valeur de référence prédéterminée, le processeur de transformation multiplie les données différentielles par une première constante, et si les données différentielles sont inférieures à la valeur de référence prédéterminée, le processeur de transformation multiplie la valeur absolue de chacune des données différentielles par la première constante et soustrait une seconde constante de chacun des résultats de la multiplication.

3. Appareil selon la revendication 1 ou 2, dans lequel le processeur DND comprend :

un opérateur DND qui exécute une opération DND sur les données différentielles entrées depuis le processeur de transformation ;
un premier sélecteur de données différentielles qui sélectionne l'une des données différentielles ayant subi l'opération de décalage, des données différentielles ayant subi l'opération de transformation, et des données différentielles ayant subi l'opération DND et produit en sortie les données différentielles sélectionnées ;
un opérateur de décalage ascendant qui, si les données différentielles ayant subi l'opération DND sont entrées depuis le premier sélecteur de données différentielles, exécute l'opération de décalage ascendante sur les données différentielles ; et
un second sélecteur de données différentielles qui produit en sortie sélectivement les données différentielles ayant subi l'opération DND ou les données différentielles ayant subi l'opération de décalage ascendant.

4. Appareil selon la revendication 3, dans lequel dans l'opération de division, une valeur maximum nKeyMax parmi les données différentielles entrées et une constante prédéterminée sont soustraites de chacune des données différentielles entrées si les données différentielles entrées sont supérieures à $\frac{nKeyMax}{2}$. .

5. Appareil selon la revendication 3 ou la revendication 4, dans lequel l'opérateur DND exécute l'opération DND sur les données différentielles un nombre de fois prédéterminé de manière à produire en sortie les résultats d'un certain cycle d'opération DND dans lequel le nombre de bits requis pour le codage peut être minimisé.

6. Appareil selon l'une quelconque des revendications 3 à 5, dans lequel parmi les données différentielles entrées respectivement depuis le dispositif de décalage, le processeur de transformation, et l'opérateur DND, le premier sélecteur de données différentielles sélectionne celles ayant le plus petit nombre de bits requis pour le codage et produit en sortie les données différentielles sélectionnées.

7. Appareil selon l'une quelconque des revendications 3 à 6, dans lequel si les données différentielles entrées depuis le dispositif de décalage ou le processeur de transformation sont sélectionnées, le premier sélecteur de données différentielles produit en sortie les données différentielles sélectionnées vers le codeur entropique.

8. Appareil selon l'une quelconque des revendications 3 à 7, dans lequel le second sélecteur de données différentielles mesure le degré de dispersion des données différentielles ayant subi l'opération DND et le degré de dispersion des données différentielles ayant subi l'opération de décalage ascendant et produit en sortie celles ayant un degré de dispersion inférieur entre les deux.

9. Appareil de codage de données clés, l'appareil comprenant :

un codeur de clé linéaire qui identifie dans les données clés d'entrée une région dans laquelle les données clés augmentent linéairement et code la région de données clés linéaires ;
un minimiseur d'erreur de quantification qui ajuste les valeurs maximum et minimum parmi les données clés d'entrée de telle sorte qu'une erreur de quantification puisse être minimisée et produit en sortie les valeurs maximum et minimum ajustées ;
un quantificateur qui quantifie les données clés d'entrée avec des bits de quantification prédéterminés en utilisant les valeurs maximum et minimum entrées depuis le minimiseur d'erreur de quantification ;
un convertisseur de nombres à virgule flottante qui convertit en nombres décimaux les nombres binaires représentant les données clés de début et de fin de la région de données clés linéaires entrées depuis le codeur de clé linéaire et les nombres binaires représentant les valeurs maximum et minimum entrées depuis le minimiseur d'erreur de quantification ;
un processeur MICD qui génère des données différentielles des données clés quantifiées ;
l'appareil selon la revendication 1 ; et
un codeur d'en-tête clé qui génère des données d'en-tête clés en utilisant des données requises pour le codage qui sont entrées depuis au moins l'un du codeur de clé linéaire, du quantificateur, du convertisseur de nombres à virgule flottante, du processeur MICD, du dispositif de décalage, du processeur de transformation, du processeur DND, et du codeur entropique.

10. Appareil selon la revendication 9, dans lequel le codeur de clé linéaire détermine que la région de données clés linéaires est co-linéaire si une erreur maximum entre les données clés dans la région de données clés linéaires et les données clés prédites linéairement dans une région de données clés arbitraires n'est pas supérieure à une valeur critique prédéterminée.

11. Appareil selon la revendication 9 ou 10, dans lequel le quantificateur convertit les données clés d'entrée en valeurs d'une plage prédéterminée en utilisant les valeurs maximum et minimum parmi les données clés d'entrée et quantifie les valeurs avec les bits de quantification prédéterminés.

12. Appareil selon l'une quelconque des revendications 9 à 11, dans lequel le minimiseur d'erreur de quantification convertit les données clés d'entrée en valeurs d'une plage prédéterminée en utilisant des valeurs maximum et minimum arbitraires, quantifie les valeurs avec les bits de quantification prédéterminés, quantifie de manière inverse les données clés quantifiées, et obtient et produit en sortie les valeurs maximum et minimum qui peuvent minimiser la somme des erreurs entre les données clés d'entrée et les données clés inversement quantifiées.

13. Appareil selon l'une quelconque des revendications 9 à 12, dans lequel le convertisseur de nombres à virgule flottante convertit les nombres binaires exprimés sous forme de $man\ tisse_binaire*2^{exposant_binaire}$ en nombres décimaux exprimés sous la forme de $matisse10^{exposant}$.

14. Appareil selon l'une quelconque des revendications 9 à 13, dans lequel si les données différentielles entrées depuis le dispositif de décalage sont supérieures à une valeur de référence prédéterminée, le processeur de transformation les multiplie par une première constante, et si elles sont inférieures à la valeur de référence prédéterminée, le processeur de transformation multiplie leurs valeurs absolues par la première constante puis soustrait une seconde constante de chacun des résultats de la multiplication.

**15.** Appareil selon l'une quelconque des revendications 9 à 14, dans lequel le processeur DND comprend :

un opérateur DND qui exécute une opération DND sur les données différentielles entrées depuis le processeur de transformation,
un premier sélecteur de données différentielles qui sélectionne l'une des données différentielles ayant subi l'opération de décalage, des données différentielles ayant subi l'opération de transformation, et des données différentielles ayant subi l'opération DND et produit en sortie les données différentielles sélectionnées ;
un opérateur de décalage ascendant qui, si les données différentielles ayant subi l'opération DND sont entrées depuis le premier sélecteur de données différentielles, exécute l'opération de décalage ascendant sur les données différentielles ; et
un second sélecteur de données différentielles qui produit en sortie sélectivement les données différentielles ayant subi l'opération DND ou les données différentielles ayant subi l'opération de décalage ascendant.

**16.** Appareil selon la revendication 15, dans lequel l'opérateur DND exécute une opération DND sur les données différentielles entrées depuis le processeur de transformation de manière à réduire la plage des données différentielles à coder, et en particulier, dans l'opération DND, une opération de division est exécutée sur les données différentielles de manière à diviser la plage de données différentielles dans une région de nombres positifs en moitiés et à convertir une moitié des données différentielles appartenant à une plage supérieure à l'autre moitié en valeurs négatives, et soit une opération de division ascendante, soit une opération de division descendante est exécutée sur les résultats de l'opération de division en fonction de la plage des données différentielles ayant subi l'opération de division de manière à réduire la plage de données différentielles appartenant à la région de nombres négatifs ou à la région de nombres positifs, respectivement,

**17.** Appareil selon l'une quelconque des revendications 9 à 16, dans lequel le codeur d'en-tête clé reçoit le nombre de données clés à coder et le nombre de chiffres des données clés, reçoit la taille des bits de quantification et les valeurs maximum et minimum ayant été utilisées pour la quantification provenant du quantificateur, reçoit des informations indiquant s'il existe ou non une région clé linéaire qui a subi un codage de clé linéaire et le nombre de données clés linéaires provenant du codeur de clé linéaire, reçoit les données clés de début et de fin de la région clé linéaire depuis le convertisseur de nombres à virgule flottante, reçoit le numéro de performance de la MICD, c.-à-d. l'ordre du MICD, et des intra données clés dans chaque cycle de la MICD depuis le processeur MICD, reçoit le mode depuis le dispositif de décalage, reçoit le numéro de performance de la DND, c.-à-d. l'ordre de la DND, et les valeurs maximum et minimum ayant été utilisées pour une opération DND, et permet l'inclusion de toutes les entrées dans un en-tête clé.

**18.** Appareil de décodage d'un train binaire codé qui est codé en exécutant une opération de quantification et un nombre prédéterminé de cycles d'opération MICD sur des données clés, lesquelles sont des informations sur la position d'une image clé sur un axe de temps, puis en exécutant au moins l'une d'une opération de décalage comprenant la soustraction du mode, à savoir la donnée ayant la plus haute fréquence parmi les données différentielles, de chacune des données différentielles MICDées, ce qui peut réduire la plage de données différentielles, une opération de transformation qui convertit les données différentielles en une région de nombres positifs ou une région de nombres négatifs, et un nombre prédéterminé de cycles d'opération DND, l'appareil comprenant :

un décodeur entropique (360) qui décode entropiquement un train binaire d'entrée et produit en sortie des données différentielles décodées ;
un opérateur de décalage ascendant inverse (356) qui rétablit les données différentielles ayant été codées par une opération de décalage ascendant en leur appliquant une opération de décalage descendant ;
un opérateur DND inverse (352) qui en fonction de l'ordre de la DND lu à partir du train binaire, soit effectue une opération DND inverse sur les données différentielles décodées entropiquement, soit les contourne ;
un processeur de transformation inverse (340) qui, en fonction de l'ordre de la DND, soit exécute une opération de transformation inverse sur les données différentielles entrées depuis l'opérateur DND inverse de telle sorte que les données différentielles puissent être divisées en nombres positifs et en nombres négatifs, soit contourne les données différentielles, dans lequel l'opération de transformation inverse convertit les nombres pairs en données positives, et convertit les nombres impairs en données négatives ;
un dispositif de décalage inverse (330) qui change la plage des données différentielles entrées depuis l'opérateur DND inverse ou le processeur de transformation inverse en ajoutant le mode aux données différentielles ;
un processeur MICD inverse (320) qui rétablit les données différentielles ayant subi l'opération de décalage inverse et produit en sortie les données clés quantifiées ; et
un quantificateur inverse (310) qui quantifie de manière inverse les données clés quantifiées rétablies et produit en sortie des données clés décodées,
dans lequel dans l'opération de décalage descendant chacune des données différentielles décodées entropiquement est soustraite d'une valeur maximum parmi les données différentielles ayant subi une opération DND si les données différentielles décodées entropiquement sont supérieures à ladite valeur maximum ;
dans lequel l'opération DND comprend une opération de division exécutée sur les données différentielles de manière à diviser la plage de données différentielles en moitiés et à convertir les données différentielles appartenant à une plage supérieure en valeurs négatives, et soit une opération de division ascendante, soit une opération de division descendante exécutée sélectivement sur les résultats de l'opération de division en fonction de la plage des résultats de l'opération de division de manière à réduire la plage de données différentielles appartenant à une région de nombres négatifs ou à la région de nombres positifs, respectivement,
dans lequel dans l'opération de division ascendante, les données qui sont inférieures à une valeur de référence prédéterminée mais non inférieures à la moitié de la valeur d'entrée minimum sont multipliées par une première constante, et les données qui sont inférieures à la moitié de la valeur d'entrée minimum sont soustraites de la valeur d'entrée minimum, le résultat de la soustraction est multiplié par la première constante, et une seconde constante est soustraite du résultat de la multiplication,
dans lequel dans l'opération de division descendante, pour les données qui sont supérieures à la moitié de la valeur d'entrée maximum, la valeur d'entrée maximum est soustraite des données, le résultat de la soustraction est multiplié par la première constante, et la seconde constante est soustraite du résultat de la multiplication, et les données qui sont inférieures à la valeur de référence prédéterminée sont multipliées par la première constante,
et dans lequel l'opérateur DND inverse exécute une opération DND inverse le nombre de fois correspondant à l'ordre de la DND et exécute une opération de division inverse sur les données différentielles d'entrée de manière à étendre leur plage si la valeur maximum nKeyMax parmi les données différentielles dans le cycle courant de l'opération DND inverse n'est pas inférieure à une première valeur de référence prédéterminée et l'ordre courant de l'opération DND inverse est égal à 1, et
l'opération de division inverse est **caractérisée par le fait que** si les données différentielles dans le cycle courant de l'opération DND inverse sont inférieures à une seconde valeur de référence, elles sont ajoutées à nKeyMax et à une constante prédéterminée.

**19.** Appareil selon la revendication 18, dans lequel le processeur de transformation inverse divise les données différentielles d'entrée par une première constante si les données différentielles d'entrée sont des nombres pairs et divise les résultats de l'addition d'une seconde constante aux données différentielles d'entrée par une constante ayant la même valeur absolue que la première constante mais un signe différent si les données différentielles d'entrée sont des nombres impairs.

**20.** Appareil selon la revendication 18 ou 19, dans lequel l'opérateur DND inverse exécute une opération DND inverse le nombre de fois correspondant à l'ordre de la DND et exécute une opération de division ascendante inverse sur les données différentielles d'entrée de manière à étendre leur plage si une valeur maximum nKeyMax parmi les données différentielles dans le cycle courant de l'opération DND inverse n'est pas inférieure à une valeur de référence prédéterminée, et
l'opération de division ascendante inverse est **caractérisée par le fait que** si les données différentielles dans le cycle courant de l'opération DND inverse ont des valeurs impaires négatives, les résultats de la division des données différentielles par la première constante et la seconde constante sont soustraits de la valeur maximum nKeyMax parmi les données différentielles, et si les données différentielles dans le cycle courant de l'opération DND inverse ont des valeurs paires négatives, elles sont divisées par la première constante.

**21.** Appareil selon l'une quelconque des revendications 18 à 20, dans lequel l'opérateur DND inverse exécute une opération DND inverse le nombre de fois correspondant à l'ordre de la DND et exécute une opération de division descendante inverse sur les données différentielles d'entrée de manière à étendre la plage des données différentielles d'entrée si la valeur maximum nKeyMax parmi les données différentielles dans le cycle courant de l'opération DND inverse n'est pas inférieure à la première valeur de référence prédéterminée et l'ordre courant de l'opération DND inverse n'est pas égal à 1, et
l'opération de division descendante inverse est **caractérisée par le fait que** si les données différentielles dans le cycle courant de l'opération DND inverse ont des valeurs impaires inférieures à une seconde valeur de référence, les résultats de la division des données différentielles par la première constante et la seconde constante sont ajoutés à nKeyMax, et si les données différentielles dans le cycle courant de l'opération DND inverse ont des valeurs paires supérieures à la seconde valeur de référence, elles sont divisées par la première constante.

**22.** Appareil selon la revendication 18, comprenant en outre :

un convertisseur inverse de nombres à virgule flottante qui extrait du train binaire des nombres décimaux représentant les données clés de début et de fin d'une région de données clés linéaires et des nombres décimaux représentant les valeurs maximum et minimum utilisées dans le quantificateur inverse, convertit les nombres décimaux en nombres binaires, et produit en sortie les nombres binaires ; et
un décodeur de clé linéaire qui décode des données clés linéaires en utilisant les données clés de début et de fin de la région de données clés linéaires, lesquelles sont entrées depuis le convertisseur inverse de nombres à virgule flottante, et ajoute les résultats du décodage aux données clés produites en sortie par le quantificateur inverse.

**23.** Appareil selon la revendication 22, comprenant en outre un décodeur d'en-tête clé qui décode des informations d'en-tête requises pour décoder les données clés codées du train binaire et fournit les informations d'en-tête à au moins l'un du décodeur entropique, du processeur DND inverse, du dispositif de décalage inverse, du processeur MICD inverse et du quantificateur inverse.

**24.** Appareil selon la revendication 22 ou 23, dans lequel le processeur DND inverse exécute une opération DND inverse le nombre de fois correspondant à l'ordre de la DND et exécute une opération de division ascendante inverse sur les données différentielles d'entrée de manière à étendre leur plage si la valeur maximum nKeyMax parmi les données différentielles dans le cycle courant de l'opération DND inverse est inférieure à une valeur de référence prédéterminée, et
l'opération de division ascendante inverse est **caractérisée par le fait que** si les données différentielles dans le cycle courant de l'opération DND inverse ont des valeurs impaires négatives, les résultats de la division des données différentielles par une première constante et une seconde constante sont soustraits de la valeur maximum nKeyMax parmi les données différentielles, et si les données différentielles dans le cycle courant de l'opération DND inverse ont des valeurs paires négatives, elles sont divisées par la première constante.

**25.** Appareil selon l'une quelconque des opérations 22 à 24, dans lequel le processeur DND inverse exécute une opération DND inverse le nombre de fois correspondant à l'ordre de la DND et exécute une opération de division descendante inverse sur les données différentielles d'entrée de manière à étendre leur plage si la valeur maximum nKeyMax parmi les données différentielles dans le cycle courant de l'opération DND inverse n'est pas inférieure à la première valeur de référence prédéterminée et l'ordre courant de l'opération DND inverse n'est pas égal à 1, et
l'opération de division descendante inverse est **caractérisée par le fait que** si les données différentielles dans le cycle courant de l'opération DND inverse ont des valeurs impaires inférieures à une seconde valeur de référence, les résultats de la division des données différentielles par la première constante et la seconde constante sont ajoutés à nKeyMax, et si les données différentielles dans le cycle courant de l'opération DND inverse ont des valeurs paires inférieures à la seconde valeur de référence, elles sont divisées par la première constante.

**26.** Appareil selon l'une quelconque des opérations 22 à 25, dans lequel le processeur DND inverse exécute une opération DND inverse le nombre de fois correspondant à l'ordre DND et exécute une opération de division inverse sur les données différentielles d'entrée de manière à étendre leur plage si la valeur maximum nKeyMax parmi les données différentielles dans le cycle courant de l'opération DND inverse n'est pas inférieure à la première valeur de référence prédéterminée et l'ordre courant de l'opération DND inverse est égal à 1, et
l'opération de division inverse est **caractérisée par le fait que** si les données différentielles dans le cycle courant de l'opération DND sont inférieures à une seconde valeur de référence, elles sont ajoutées à nKeyMax et à une constante prédéterminée.

**27.** Appareil selon l'une quelconque des opérations 22 à 26, dans lequel le processeur DND inverse vérifie en fonction de l'ordre de DND que les données différentielles d'entrée ont subi ou non l'opération DND, et produit en sortie les données différentielles vers le processeur de transformation inverse si les données différentielles s'avèrent avoir subi une opération DND et produit en sortie les données différentielles vers le dispositif de décalage inverse si les données différentielles s'avèrent ne pas avoir subi d'opération DND et d'opération de transformation.

**28.** Appareil selon l'une quelconque des opérations 22 à 27, dans lequel le processeur de transformation inverse divise les données différentielles d'entrée par la première constante si les données différentielles d'entrée sont des nombres pairs et divise les résultats de l'addition de la seconde constante aux données différentielles d'entrée par une constante ayant la même valeur absolue que la première constante mais un signe différent si les données différentielles d'entrée sont des numéros impairs.

**29.** Appareil selon l'une quelconque des opérations 22 à 28, dans lequel le quantificateur inverse quantifie de manière inverse les données clés quantifiées entrées depuis le processeur MICD inverse en multipliant le résultat de la division de la différence entre les valeurs maximum et minimum, lesquelles ont été utilisées pour la quantification des données clés et sont entrées depuis le convertisseur inverse de nombres à virgule flottante, par une taille de pas de quantification par les données clés quantifiées et en ajoutant la valeur minimum aux résultats de la multiplication.

**30.** Train binaire, dans lequel des données clés, qui sont des informations sur la position d'une image clé sur un axe de temps, sont codées dans une animation graphique basée sur des images clés, le train binaire comprenant :

des informations de quantification de données clés qui comportent le nombre de données clés à quantifier, un nombre prédéterminé de bits utilisé pour la quantification, et des valeurs maximum et minimum parmi les données clés quantifiées avec le nombre de bits prédéterminé ;
des informations d'opération MICD qui comporte l'ordre de l'opération DND qui est exécutée sur les données clés quantifiées de manière à générer des données différentielles et des intra données clés dans chaque cycle d'opération MICD ;
un mode de décalage, à savoir une donnée différentielle ayant la plus haute fréquence parmi les données différentielles, qui est utilisé pour une opération de décalage où les données différentielles des données clés sont transférées par autant que le mode de décalage de manière à réduire la plage des données différentielles ; et
des informations d'opération DND qui comportent l'ordre de l'opération DND, à savoir le nombre de cycles d'opération DND pour réduire la plage de données différentielles ayant subi l'opération de décalage et une opération de transformation qui convertit les données différentielles soit en une région de nombres positifs, soit en une région de nombres négatifs, des valeurs maximum et minimum parmi les données différentielles ayant subi une opération DND, et un fanion indiquant si les données différentielles ayant subi une opération DND ont ou non également subi une opération de décalage ascendant, l'opération de décalage ascendant comprenant la soustraction de chacune des données différentielles ayant subi l'opération DND de la valeur maximum nKeyMax parmi elles si elles sont inférieures à la valeur de référence prédéterminée ; et
des informations sur les données clés codées, en lesquelles les données différentielles ayant subi une opération DND sont codées entropiquement,
dans lequel l'opération DND comprend une opération de division exécutée sur les données différentielles converties de manière à diviser la plage de données différentielles en moitiés et à convertir une moitié des données différentielles appartenant à une plage supérieure en valeurs négatives, et soit une opération de division ascendante, soit une opération de division descendante exécutée sélectivement sur les résultats de l'opération de division en fonction de la plage des résultats de l'opération de division de manière à réduire la plage de données différentielles appartenant à une région de nombres négatifs ou à la région de nombres positifs, respectivement,
dans lequel dans l'opération de division ascendante, les données qui sont inférieures à une valeur de référence prédéterminée mais non inférieures à la moitié de la valeur d'entrée minimum nKeyMin sont multipliées par une première constante, et les données qui sont inférieures à nKeyMin/2 sont soustraites de nKeyMin, le résultat de la soustraction est multiplié par la première constante, et une seconde constante est soustraite du résultat de la multiplication, et
dans lequel dans l'opération de division descendante, pour les données qui sont supérieures à la moitié de la valeur d'entrée maximum nKeyMax, nKeyMax est soustrait des données, le résultat de la soustraction est multiplié par la première constante, et la seconde constante est soustraite du résultat de la multiplication, et les données qui sont inférieures à la valeur de référence prédéterminée sont multipliées par la première constante.

**31.** Train binaire selon la revendication 30, comprenant en outre :

un fanion qui indique si ou non une région clé linéaire où les données clés augmentent linéairement dans les données clés d'entrée ;
le nombre de données clés incluses dans la région de clé linéaire ; et
des données clés de début et de fin de la région de clé linéaire.

**32.** Train binaire selon la revendication 31, dans lequel les données clés de début et de fin de la région de clé linéaire sont chacune représentées par une mantisse et un exposant.

**33.** Train binaire selon la revendication 31 ou 32, dans lequel les valeurs maximum et minimum parmi les données clés quantifiées sont utilisées pour minimiser une erreur de quantification des données clés quantifiées.

**34.** Programme informatique comprenant des moyens de code de programme informatique pour exécuter toutes les étapes de l'une quelconque des revendications 31 à 33, quand ledit programme est exécuté sur un ordinateur.

**35.** Programme informatique selon la revendication 34 intégré sur un support lisible par ordinateur.

FIG. 1 (PRIOR ART)

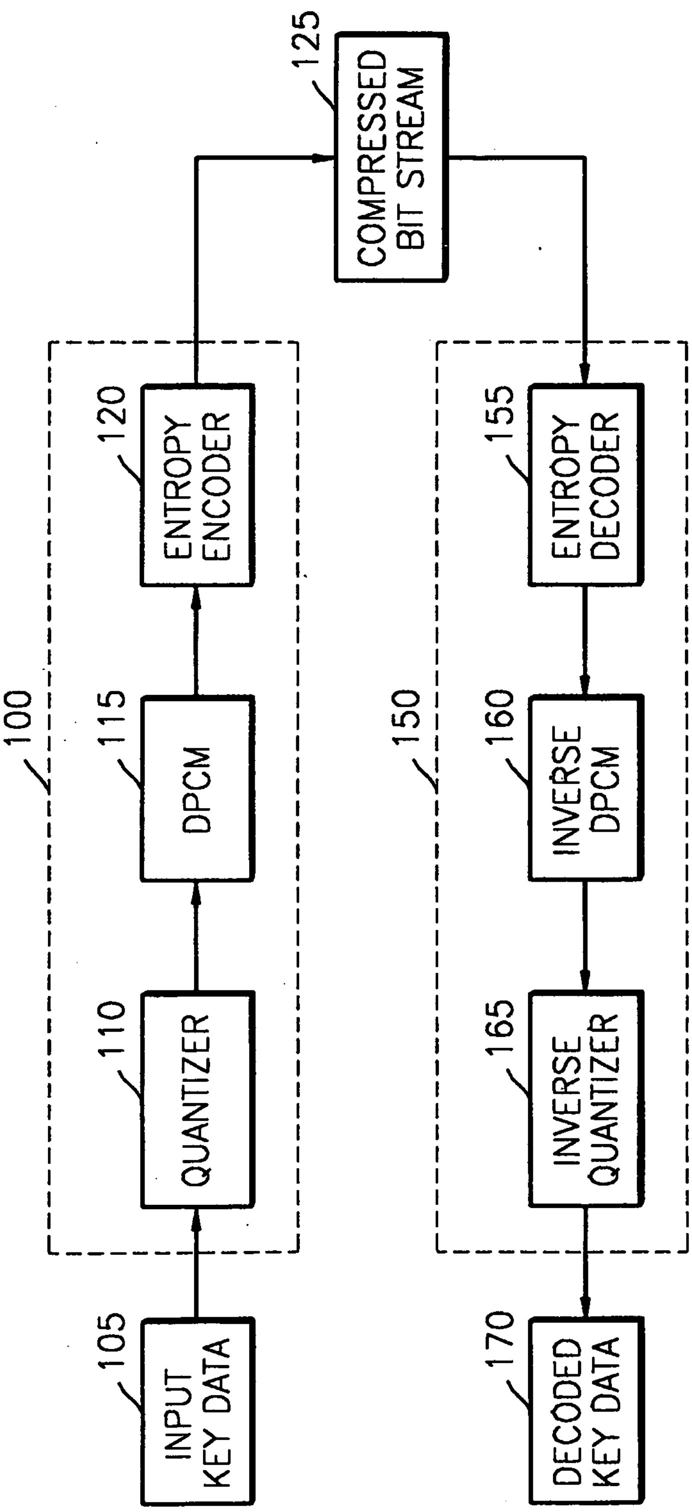

FIG. 2A

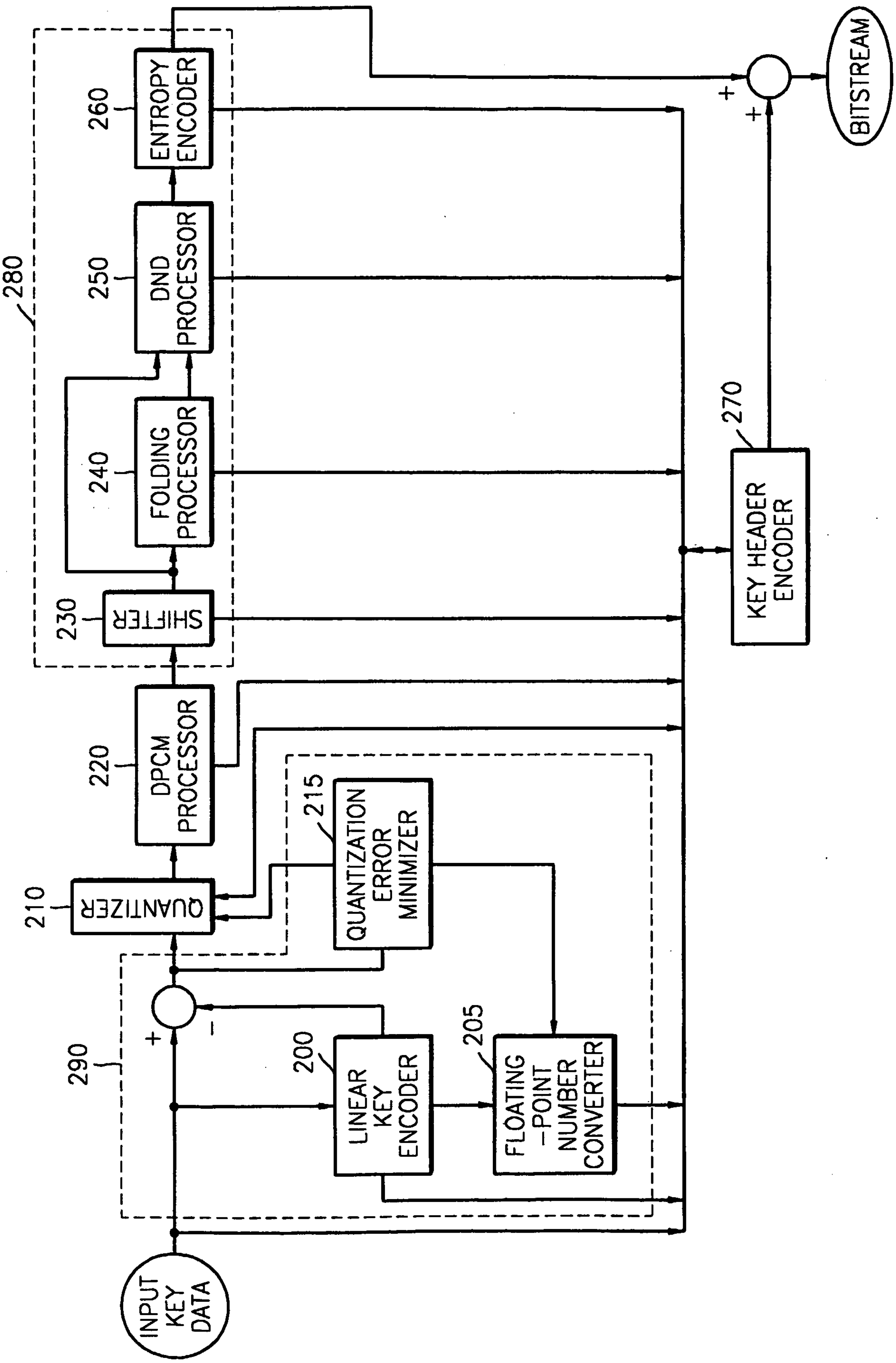
INPUT KEY DATA
290
LINEAR KEY ENCODER
200
FLOATING -POINT NUMBER CONVERTER
205
QUANTIZATION ERROR MINIMIZER
215
QUANTIZER
210
DPCM PROCESSOR
220
SHIFTER
230
FOLDING PROCESSOR
240
DND PROCESSOR
250
ENTROPY ENCODER
260
280
KEY HEADER ENCODER
270
BITSTREAM
+
-

FIG. 2B

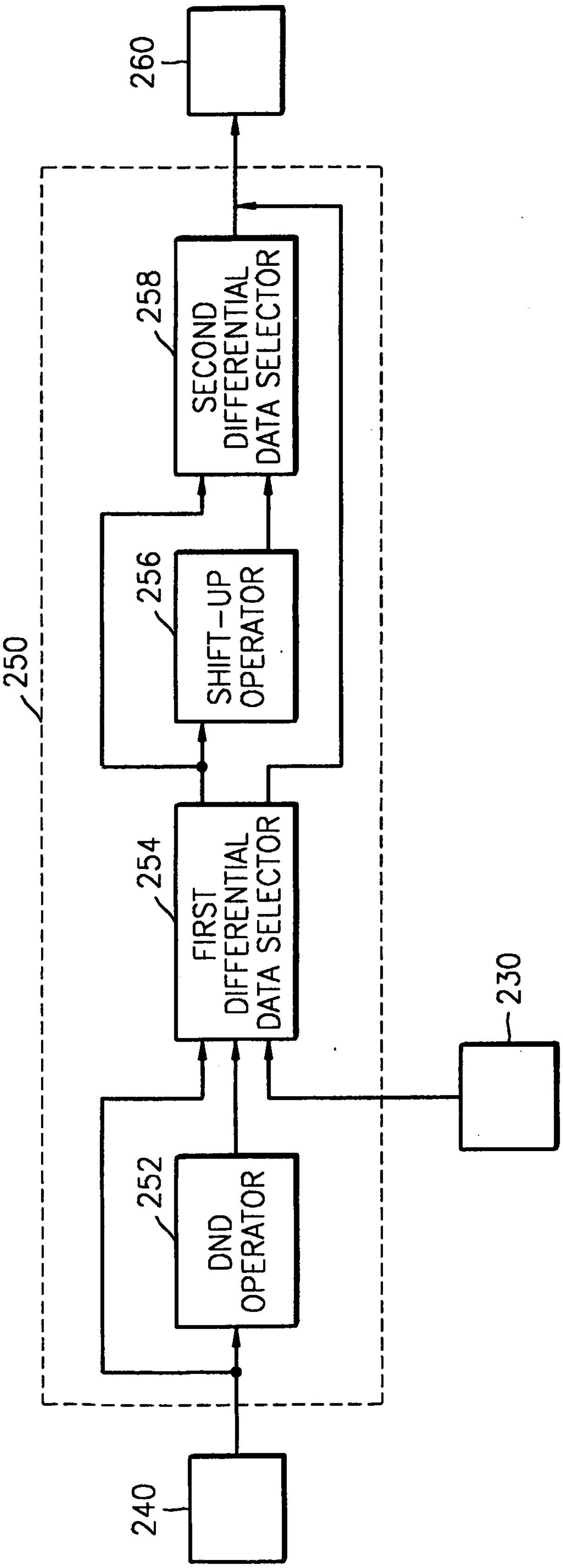
240
252
DND OPERATOR
230
254
FIRST DIFFERENTIAL DATA SELECTOR
250
256
SHIFT-UP OPERATOR
258
SECOND DIFFERENTIAL DATA SELECTOR
260

FIG. 2C

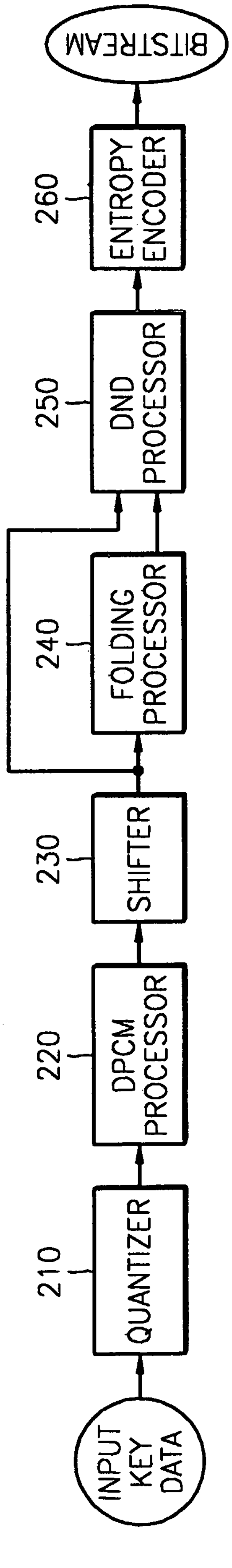
INPUT KEY DATA
210
QUANTIZER
220
DPCM PROCESSOR
230
SHIFTER
240
FOLDING PROCESSOR
250
DND PROCESSOR
260
ENTROPY ENCODER
BITSTREAM

FIG. 2D

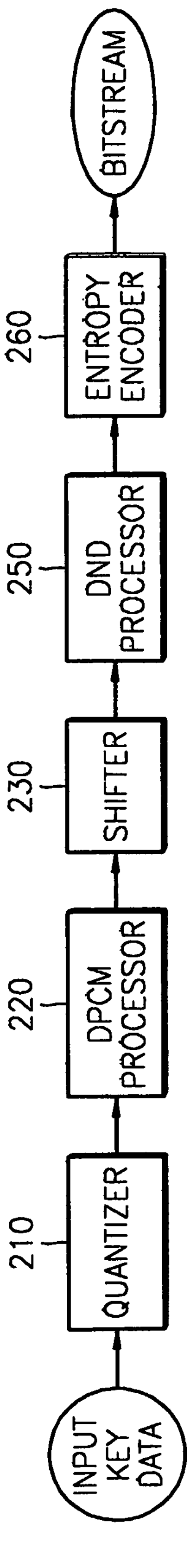
INPUT KEY DATA
210
QUANTIZER
220
DPCM PROCESSOR
230
SHIFTER
250
DND PROCESSOR
260
ENTROPY ENCODER
BITSTREAM

FIG. 2E

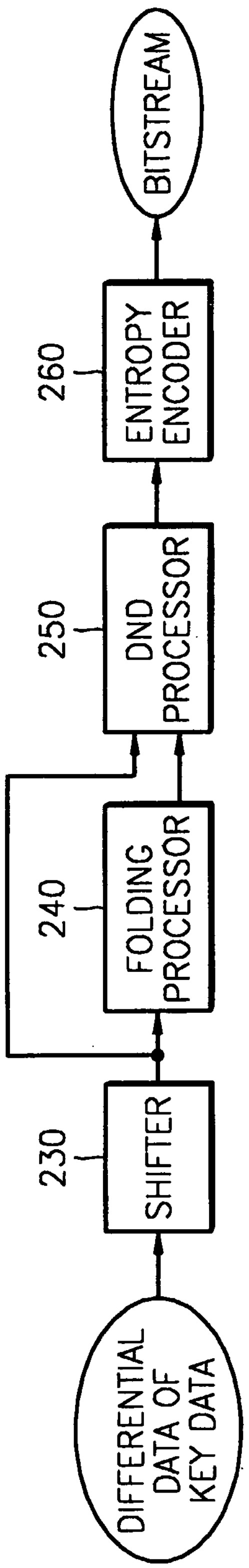
DIFFERENTIAL DATA OF KEY DATA
230
SHIFTER
240
FOLDING PROCESSOR
250
DND PROCESSOR
260
ENTROPY ENCODER
BITSTREAM

FIG. 2F

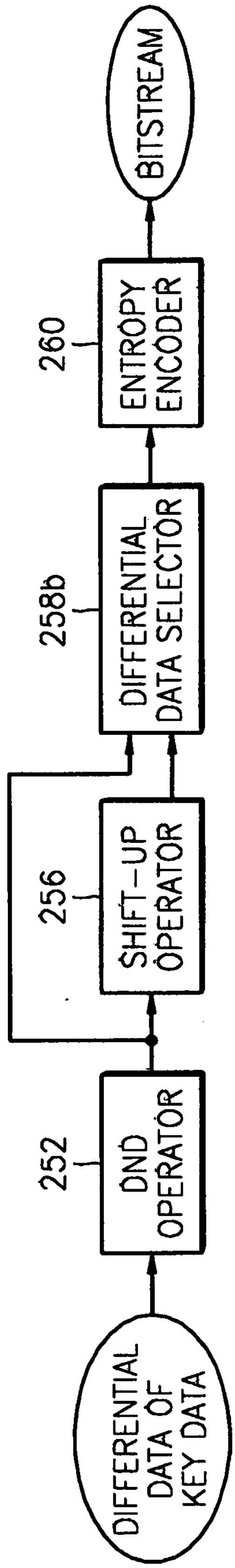
DIFFERENTIAL DATA OF KEY DATA
252
DND OPERATOR
256
SHIFT-UP OPERATOR
258b
DIFFERENTIAL DATA SELECTOR
260
ENTROPY ENCODER
BITSTREAM

FIG. 2G

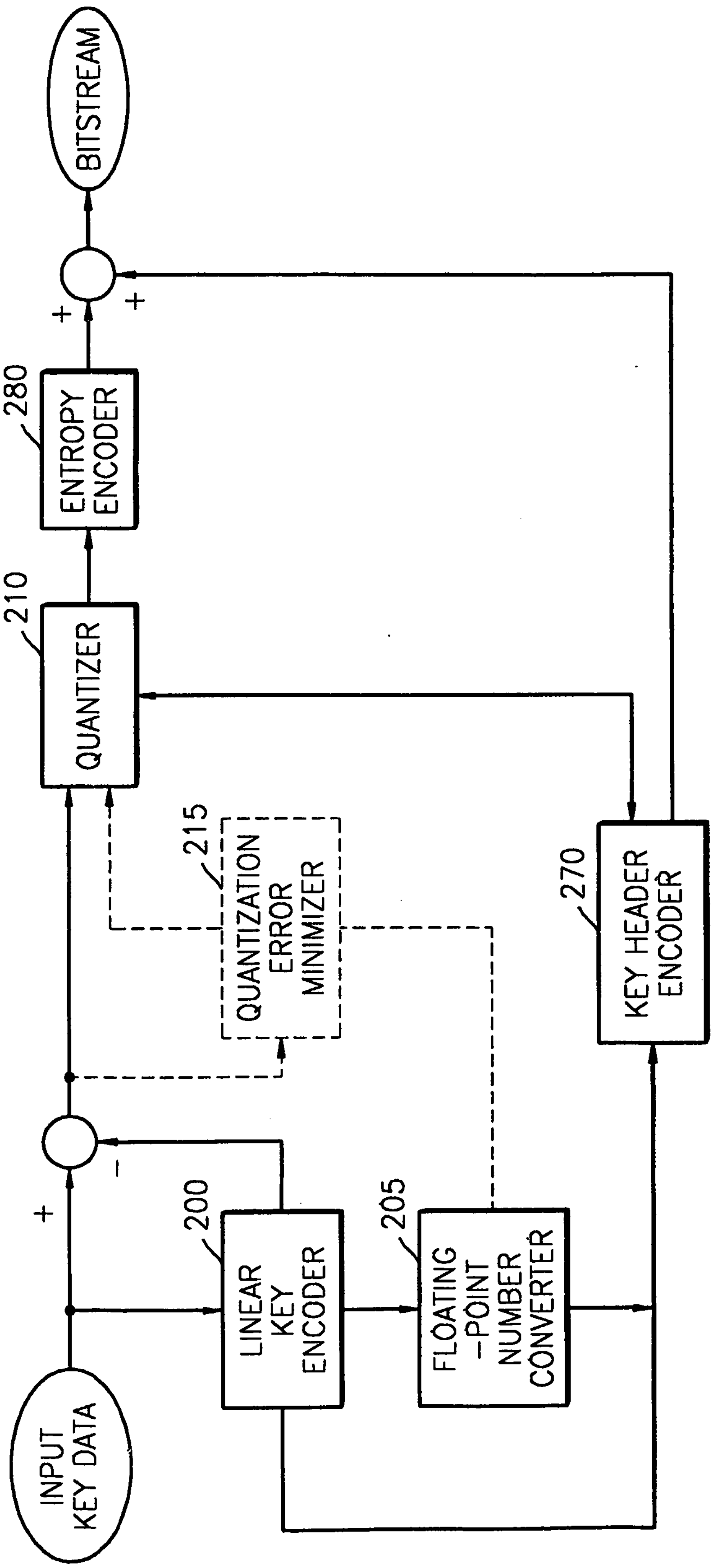
INPUT KEY DATA
LINEAR KEY ENCODER
200
FLOATING -POINT NUMBER CONVERTER
205
QUANTIZATION ERROR MINIMIZER
215
QUANTIZER
210
ENTROPY ENCODER
280
KEY HEADER ENCODER
270
BITSTREAM
+
-
+
+

# FIG. 3A

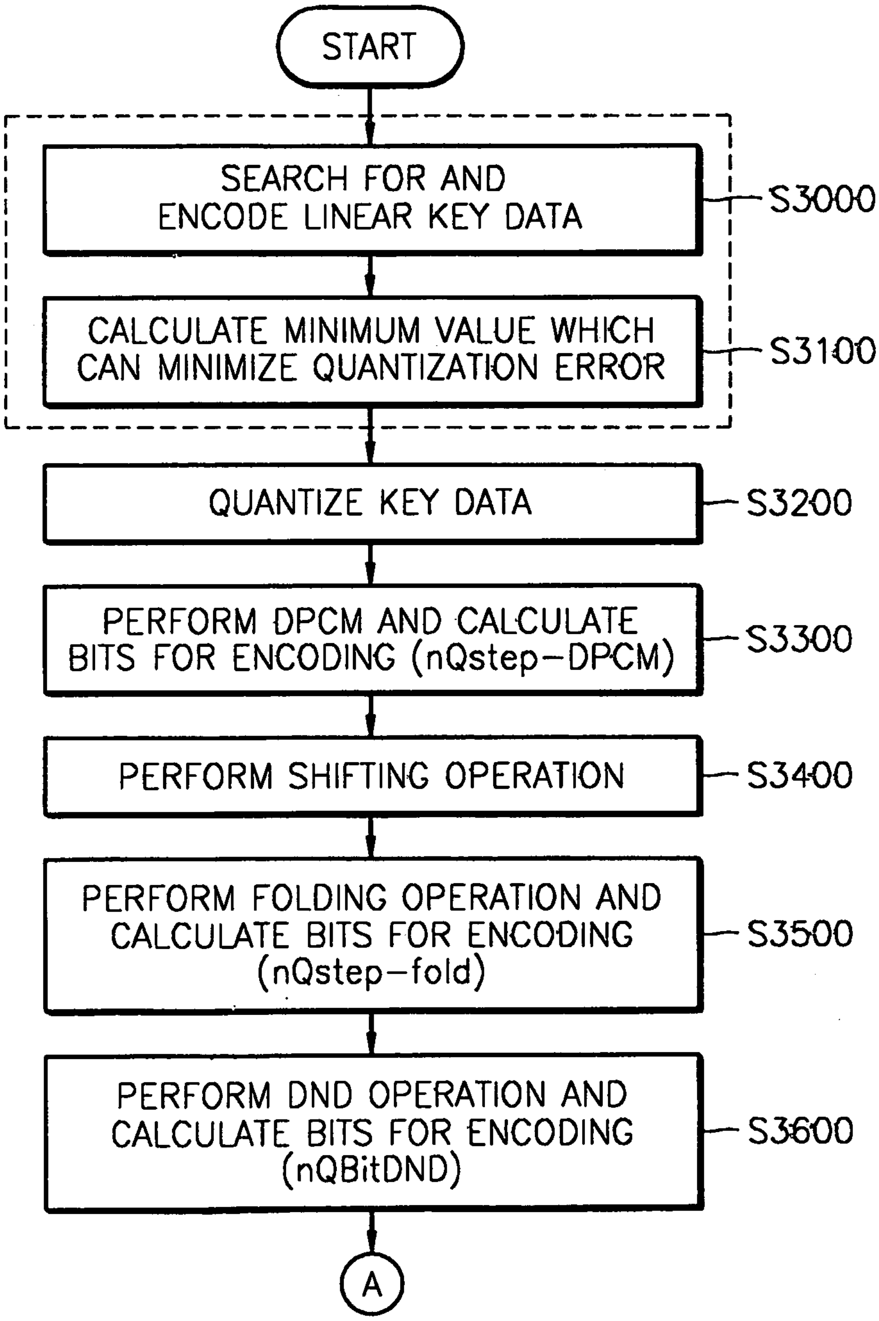
START
SEARCH FOR AND ENCODE LINEAR KEY DATA
S3000
CALCULATE MINIMUM VALUE WHICH CAN MINIMIZE QUANTIZATION ERROR
S3100
QUANTIZE KEY DATA
S3200
PERFORM DPCM AND CALCULATE BITS FOR ENCODING (nQstep-DPCM)
S3300
PERFORM SHIFTING OPERATION
S3400
PERFORM FOLDING OPERATION AND CALCULATE BITS FOR ENCODING (nQstep-fold)
S3500
PERFORM DND OPERATION AND CALCULATE BITS FOR ENCODING (nQBitDND)
S3600
A

FIG. 3B

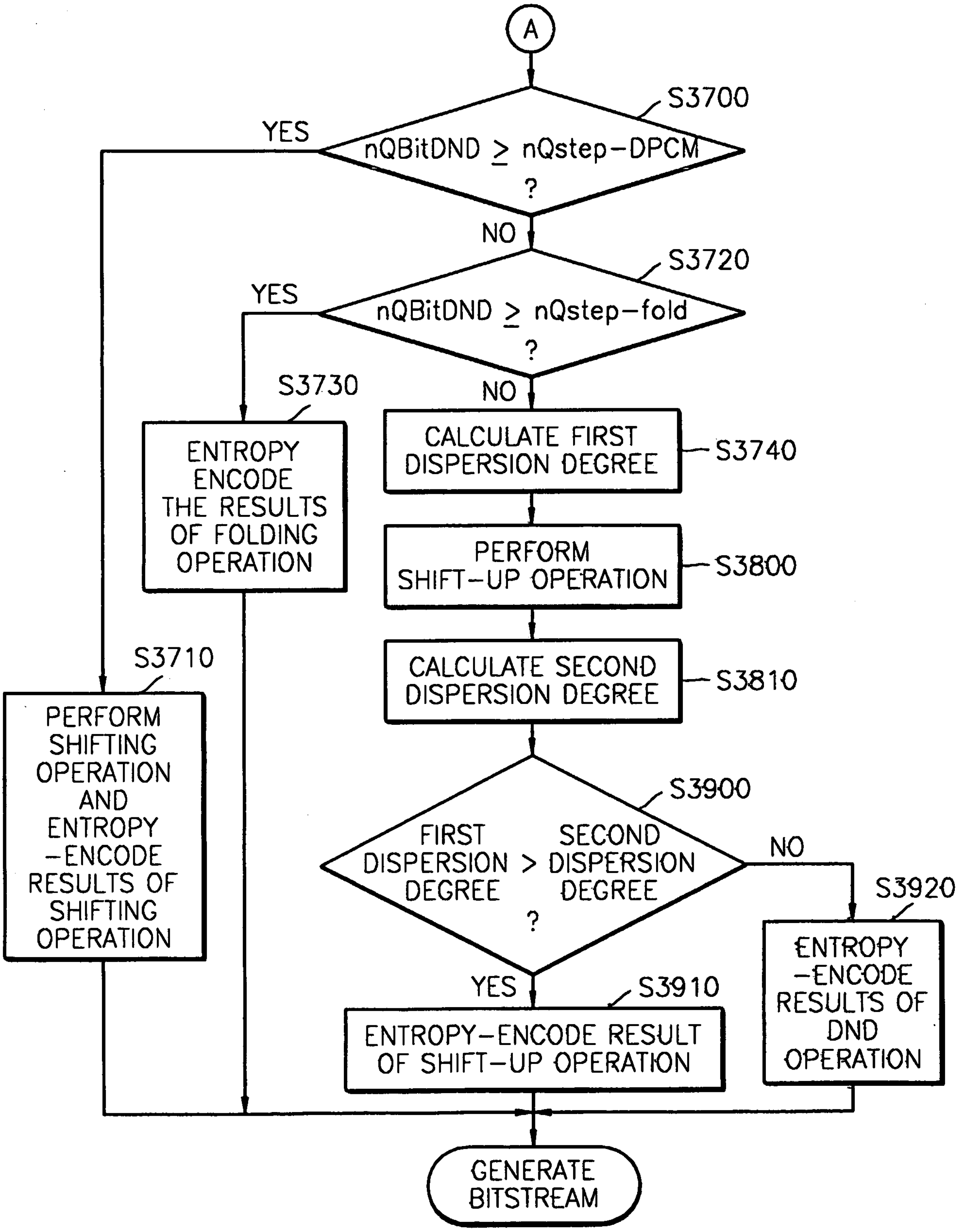
A
S3700
YES
nQBitDND ≥ nQstep−DPCM ?
NO
S3720
YES
nQBitDND ≥ nQstep−fold ?
NO
S3730
ENTROPY ENCODE THE RESULTS OF FOLDING OPERATION
CALCULATE FIRST DISPERSION DEGREE
S3740
PERFORM SHIFT−UP OPERATION
S3800
CALCULATE SECOND DISPERSION DEGREE
S3810
S3710
PERFORM SHIFTING OPERATION AND ENTROPY −ENCODE RESULTS OF SHIFTING OPERATION
S3900
FIRST DISPERSION DEGREE > SECOND DISPERSION DEGREE ?
NO
S3920
ENTROPY −ENCODE RESULTS OF DND OPERATION
YES
S3910
ENTROPY−ENCODE RESULT OF SHIFT−UP OPERATION
GENERATE BITSTREAM

FIG. 4A

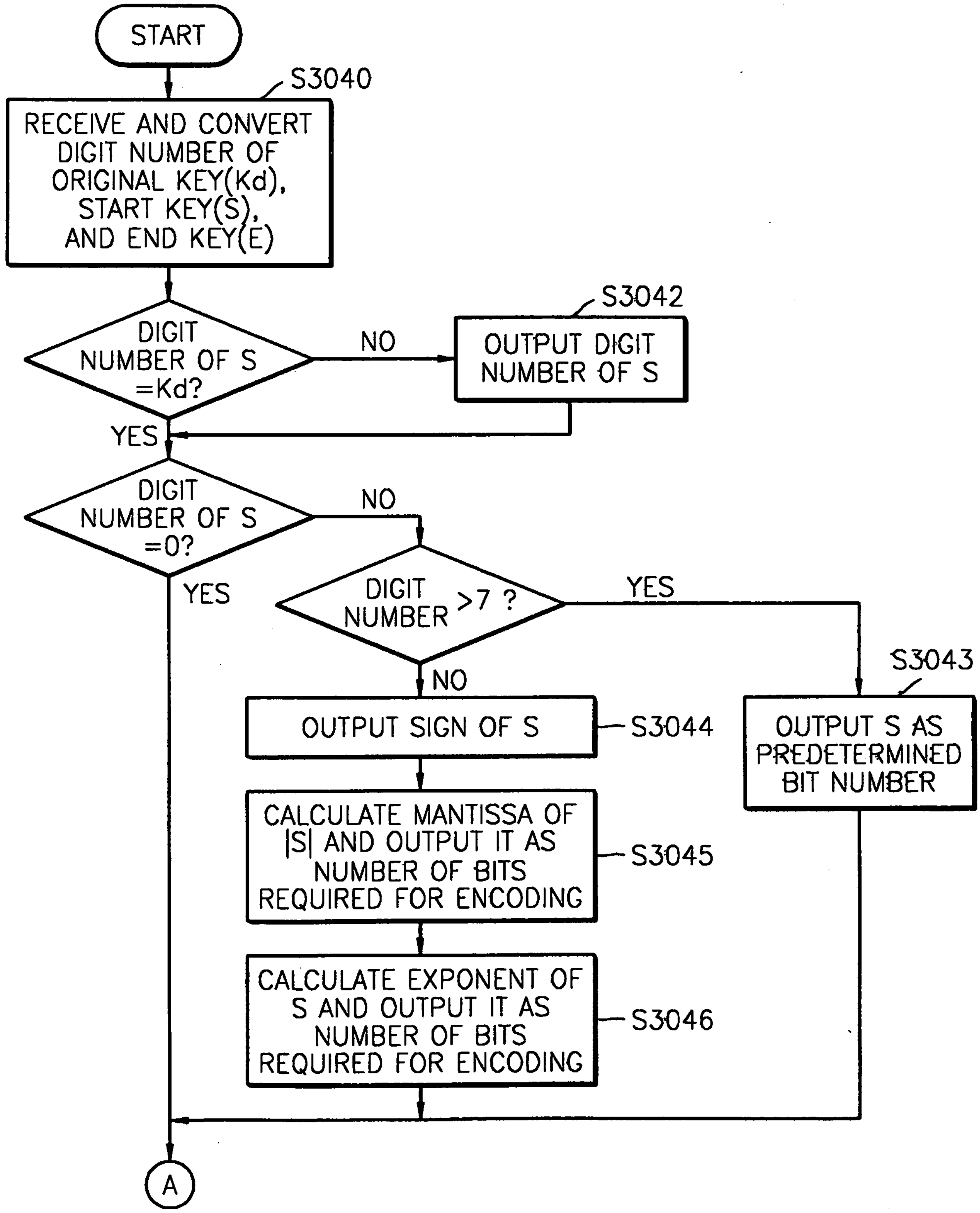
START
S3040
RECEIVE AND CONVERT DIGIT NUMBER OF ORIGINAL KEY(Kd), START KEY(S), AND END KEY(E)
DIGIT NUMBER OF S =Kd?
NO
S3042
OUTPUT DIGIT NUMBER OF S
YES
DIGIT NUMBER OF S =0?
NO
YES
DIGIT NUMBER >7 ?
YES
S3043
NO
OUTPUT SIGN OF S
S3044
OUTPUT S AS PREDETERMINED BIT NUMBER
CALCULATE MANTISSA OF |S| AND OUTPUT IT AS NUMBER OF BITS REQUIRED FOR ENCODING
S3045
CALCULATE EXPONENT OF S AND OUTPUT IT AS NUMBER OF BITS REQUIRED FOR ENCODING
S3046
A

FIG. 4B

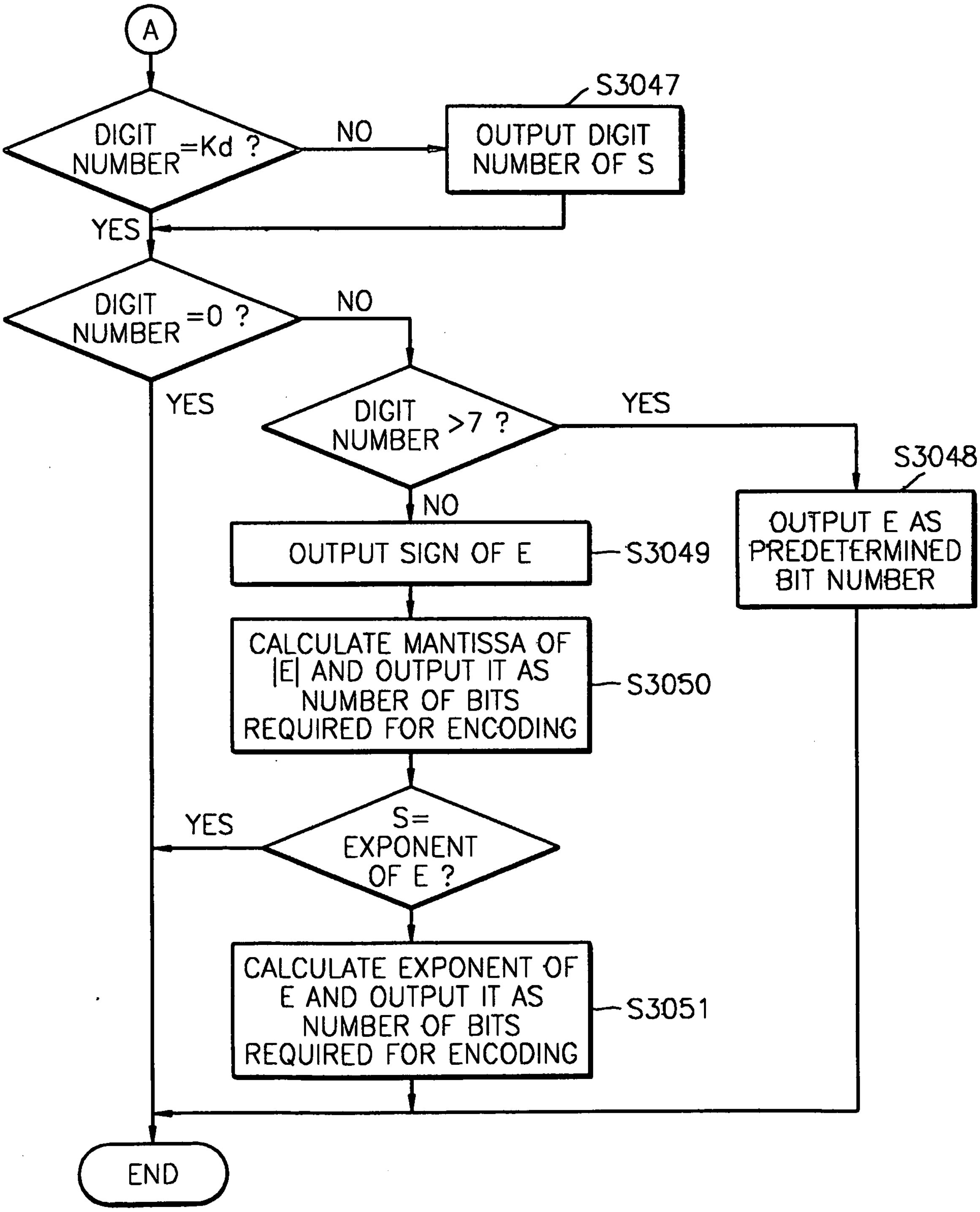
A
DIGIT NUMBER =Kd ?
NO
YES
S3047
OUTPUT DIGIT NUMBER OF S
DIGIT NUMBER =0 ?
NO
YES
DIGIT NUMBER >7 ?
YES
NO
S3048
OUTPUT E AS PREDETERMINED BIT NUMBER
OUTPUT SIGN OF E
S3049
CALCULATE MANTISSA OF |E| AND OUTPUT IT AS NUMBER OF BITS REQUIRED FOR ENCODING
S3050
S= EXPONENT OF E ?
YES
CALCULATE EXPONENT OF E AND OUTPUT IT AS NUMBER OF BITS REQUIRED FOR ENCODING
S3051
END

FIG. 5

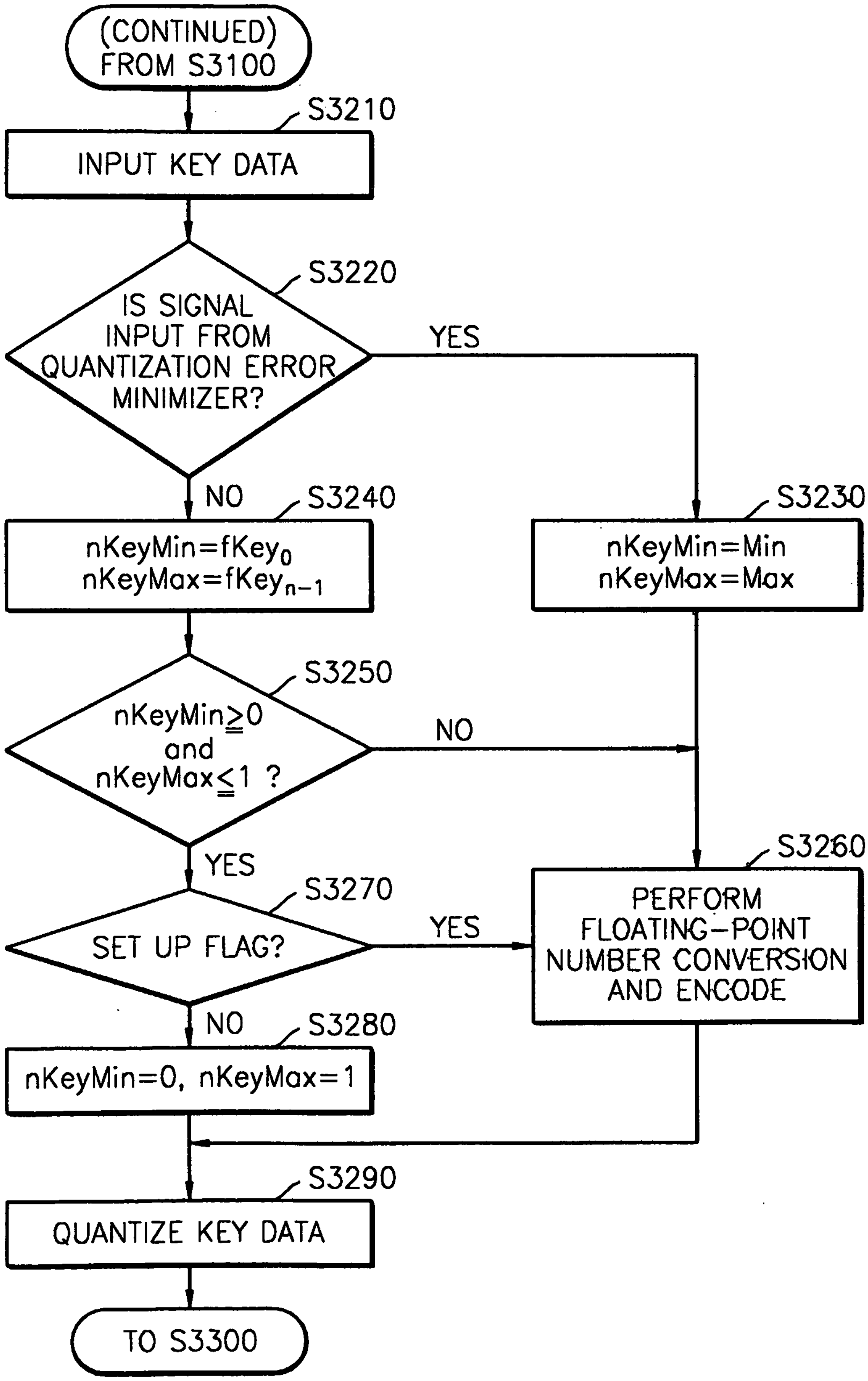
(CONTINUED) FROM S3100
S3210
INPUT KEY DATA
S3220
IS SIGNAL INPUT FROM QUANTIZATION ERROR MINIMIZER?
YES
NO
S3240
nKeyMin=fKey0
nKeyMax=fKeyn-1
S3230
nKeyMin=Min
nKeyMax=Max
S3250
nKeyMin≧0 and nKeyMax≦1 ?
NO
YES
S3260
PERFORM FLOATING-POINT NUMBER CONVERSION AND ENCODE
S3270
SET UP FLAG?
YES
NO
S3280
nKeyMin=0, nKeyMax=1
S3290
QUANTIZE KEY DATA
TO S3300

FIG. 6

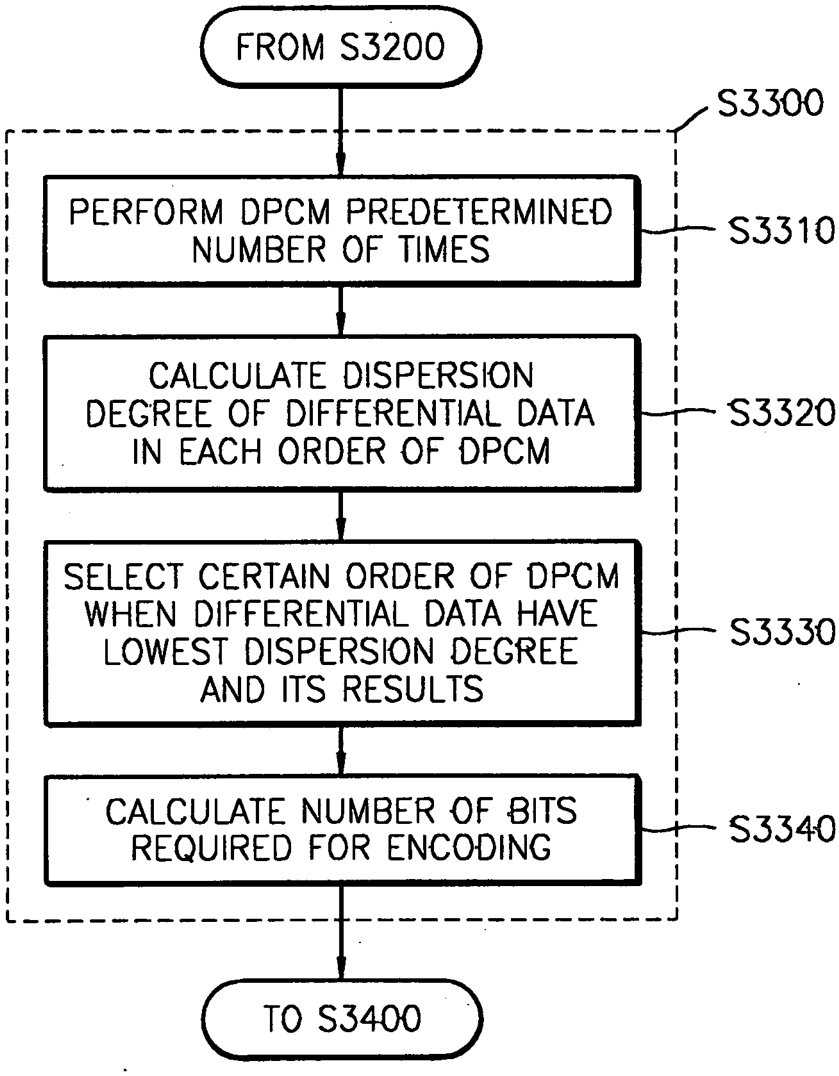
FROM S3200
S3300
PERFORM DPCM PREDETERMINED NUMBER OF TIMES
S3310
CALCULATE DISPERSION DEGREE OF DIFFERENTIAL DATA IN EACH ORDER OF DPCM
S3320
SELECT CERTAIN ORDER OF DPCM WHEN DIFFERENTIAL DATA HAVE LOWEST DISPERSION DEGREE AND ITS RESULTS
S3330
CALCULATE NUMBER OF BITS REQUIRED FOR ENCODING
S3340
TO S3400

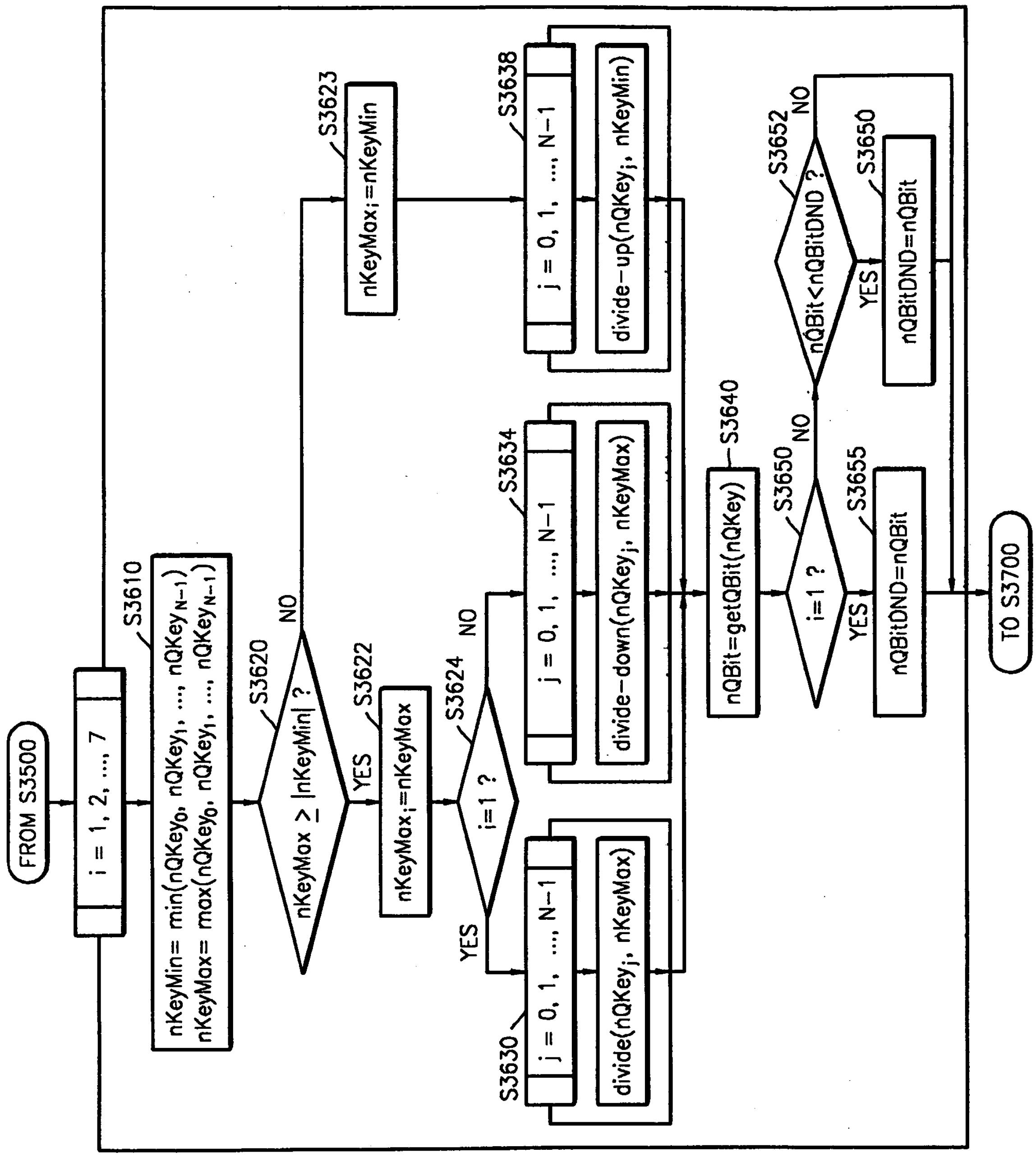
FROM S3500
i = 1, 2, ..., 7
S3610
nKeyMin= min(nQKey0, nQKey1, ..., nQKeyN-1)
nKeyMax= max(nQKey0, nQKey1, ..., nQKeyN-1)
S3620
nKeyMax ≥ |nKeyMin| ?
YES
NO
S3622
nKeyMaxi:=nKeyMax
S3623
nKeyMaxi:=nKeyMin
S3624
i=1 ?
YES
NO
S3630
j = 0, 1, ..., N-1
divide(nQKeyj, nKeyMax)
S3634
j = 0, 1, ..., N-1
divide-down(nQKeyj, nKeyMax)
S3638
j = 0, 1, ..., N-1
divide-up(nQKeyj, nKeyMin)
S3640
nQBit=getQBit(nQKey)
S3650
i=1 ?
YES
NO
S3655
nQBitDND=nQBit
S3652
nQBit<nQBitDND ?
YES
NO
S3650
nQBitDND=nQBit
TO S3700

FIG. 7

FIG. 8

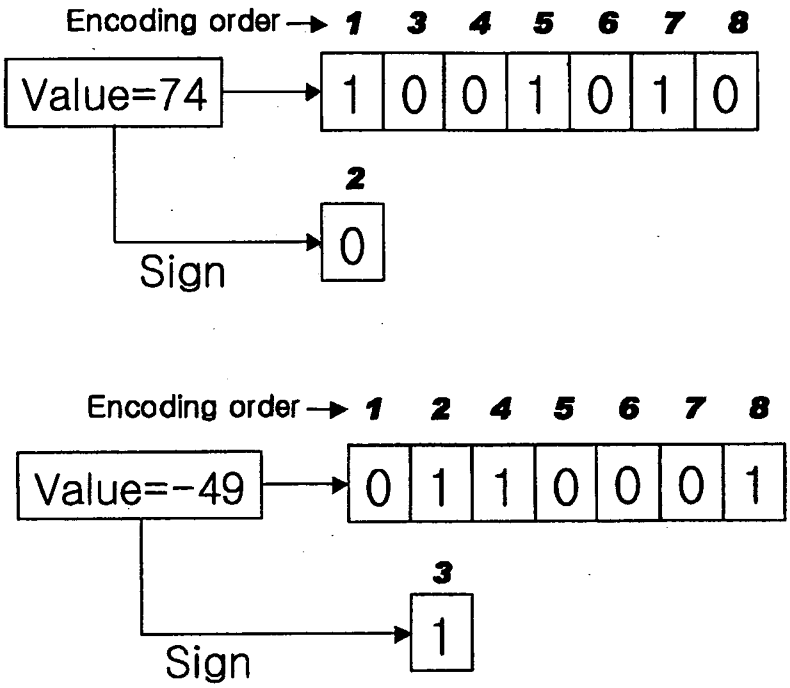
Encoding order
1 3 4 5 6 7 8
Value=74
1 0 0 1 0 1 0
2
0
Sign
Encoding order
1 2 4 5 6 7 8
Value=-49
0 1 1 0 0 0 1
3
1
Sign

# FIG. 9A

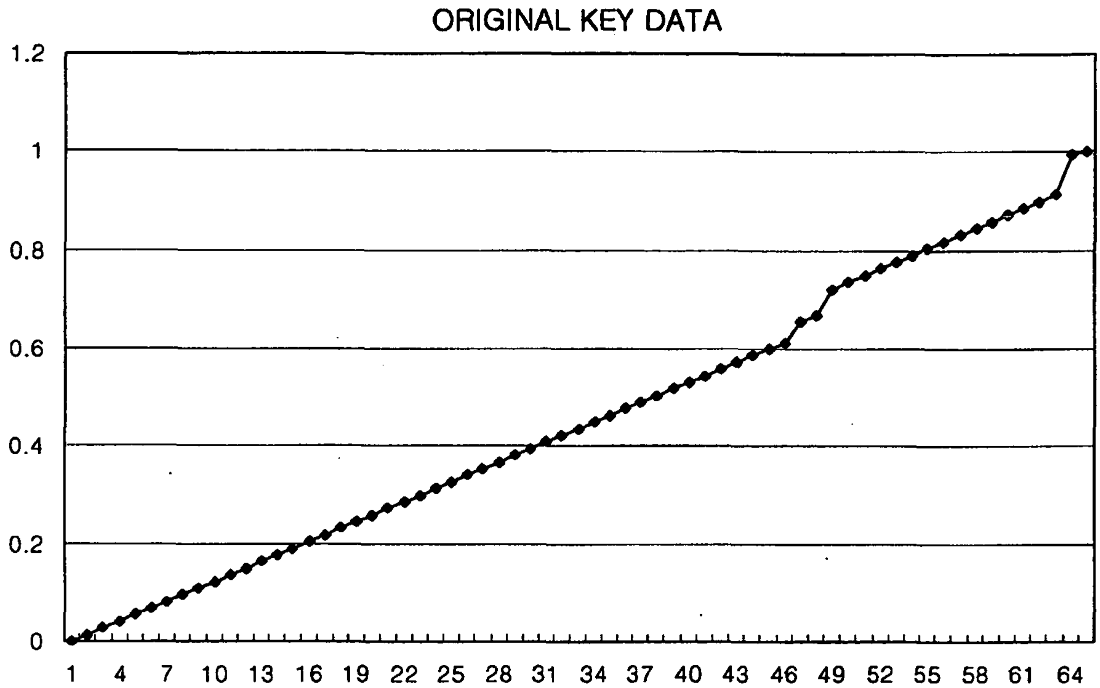
ORIGINAL KEY DATA
1.2
1
0.8
0.6
0.4
0.2
0
1 4 7 10 13 16 19 22 25 28 31 34 37 40 43 46 49 52 55 58 61 64

# FIG. 9B

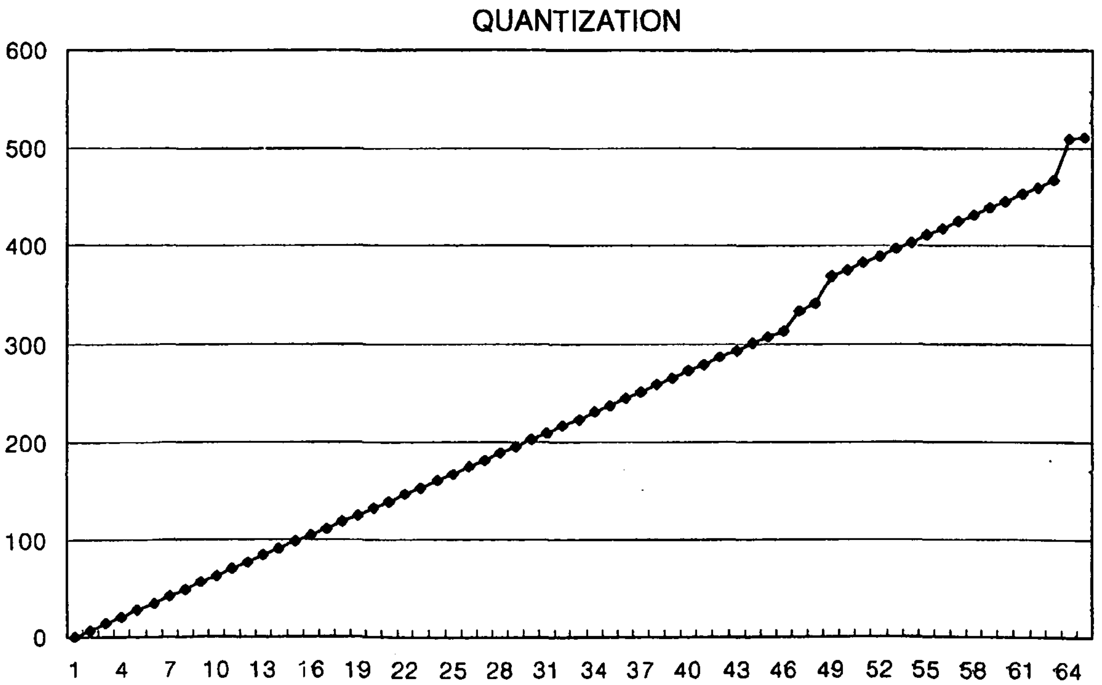
QUANTIZATION
600
500
400
300
200
100
0
1 4 7 10 13 16 19 22 25 28 31 34 37 40 43 46 49 52 55 58 61 64

# FIG. 9C

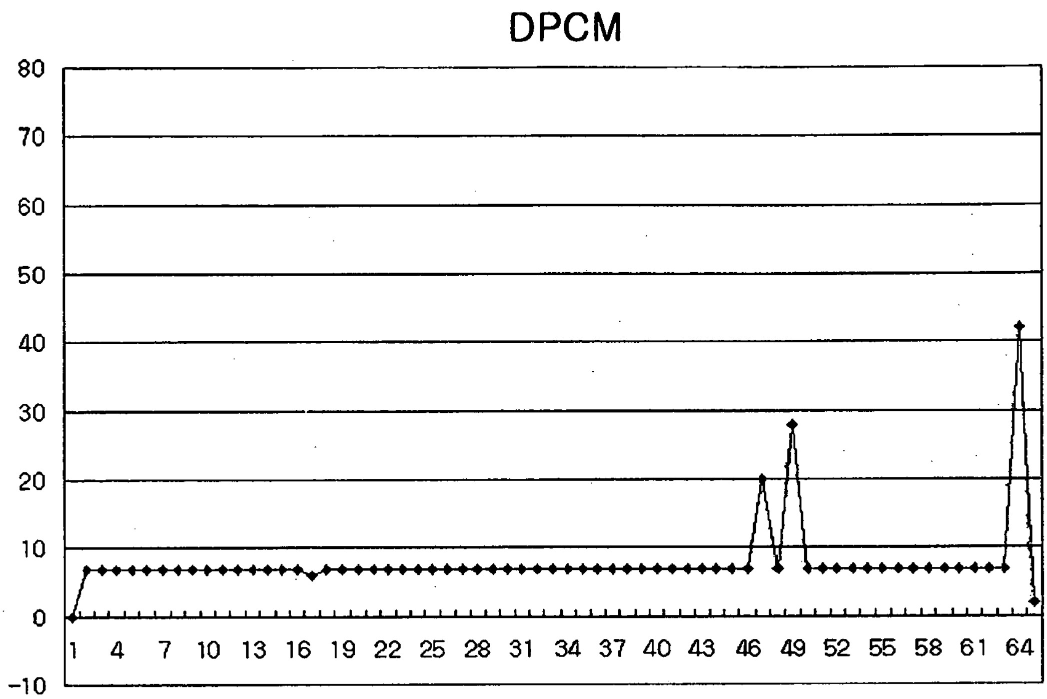
DPCM
80
70
60
50
40
30
20
10
0
-10
1 4 7 10 13 16 19 22 25 28 31 34 37 40 43 46 49 52 55 58 61 64

# FIG. 9D

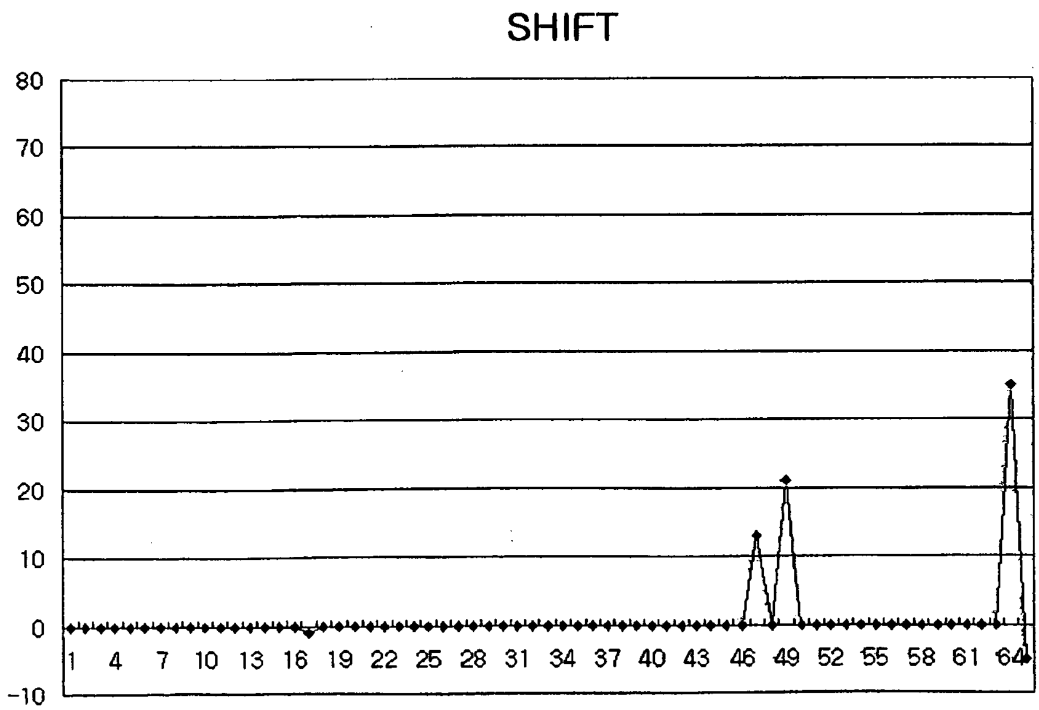
SHIFT
80
70
60
50
40
30
20
10
0
-10
1 4 7 10 13 16 19 22 25 28 31 34 37 40 43 46 49 52 55 58 61 64

FIG. 9E

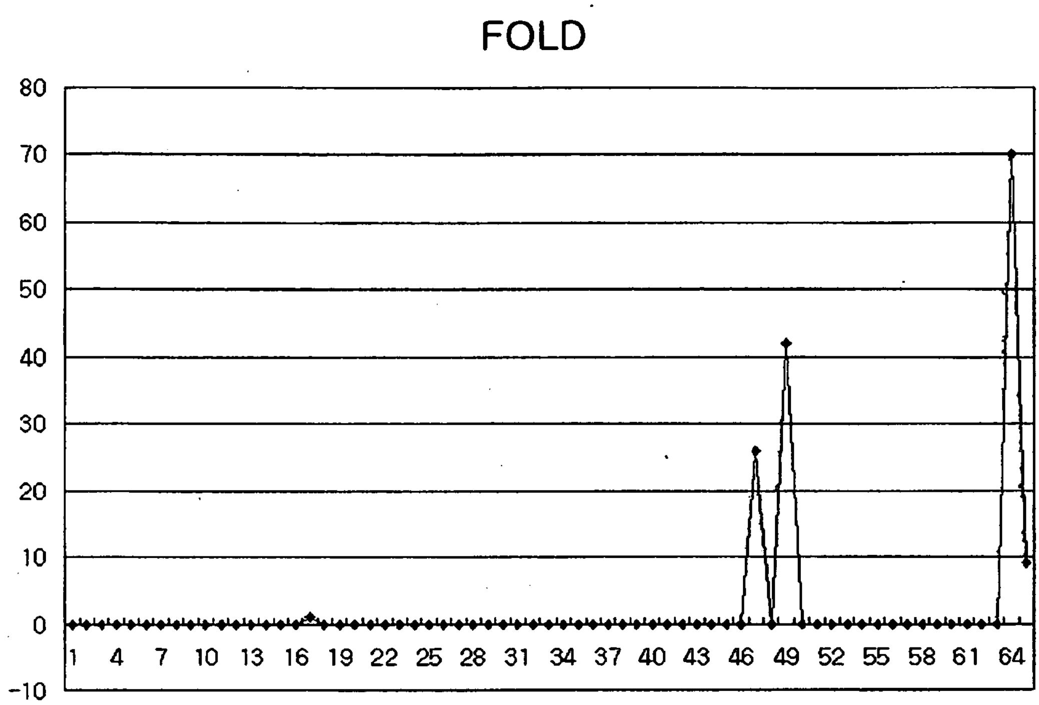
FOLD
80
70
60
50
40
30
20
10
0
-10
1 4 7 10 13 16 19 22 25 28 31 34 37 40 43 46 49 52 55 58 61 64

FIG. 9F

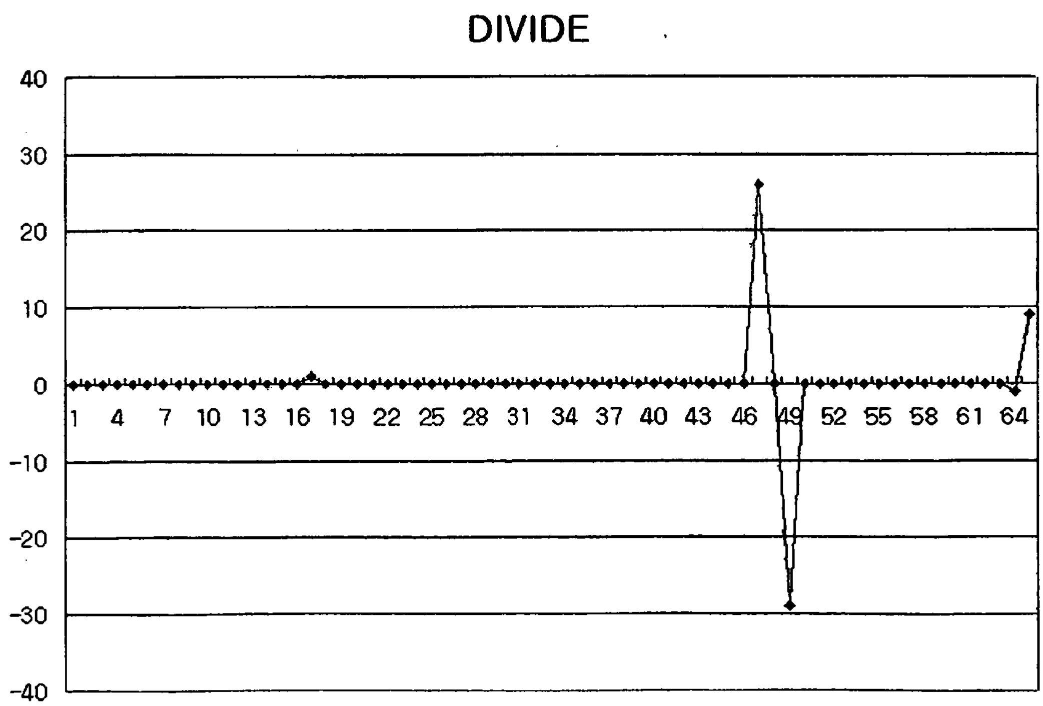
DIVIDE
40
30
20
10
0
-10
-20
-30
-40
1 4 7 10 13 16 19 22 25 28 31 34 37 40 43 46 49 52 55 58 61 64

# FIG. 9G

DIVIDE-UP

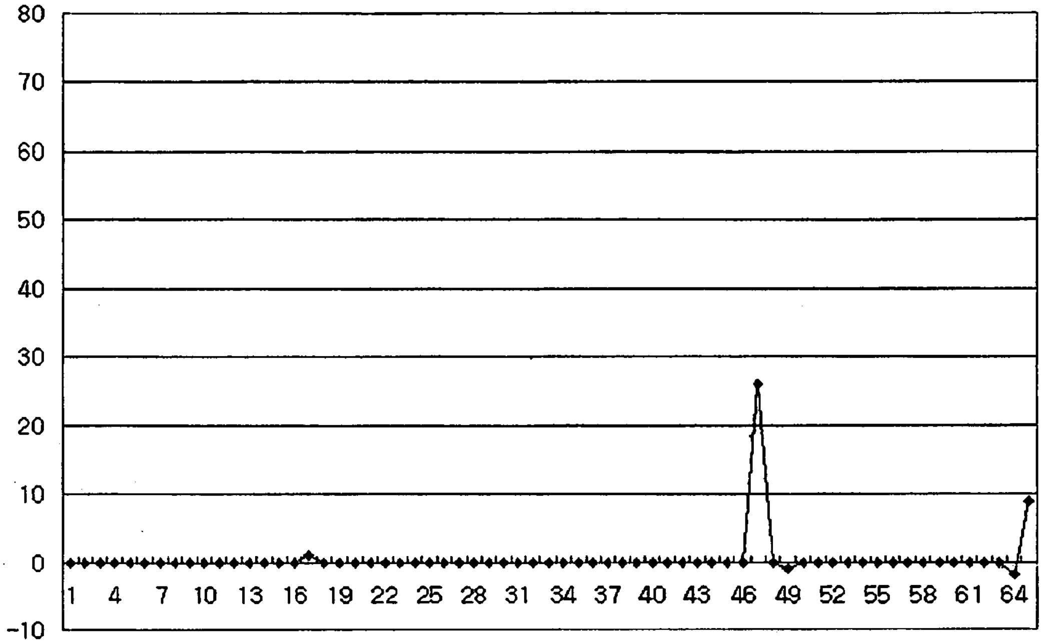


# FIG. 9H

DIVIDE-DOWN

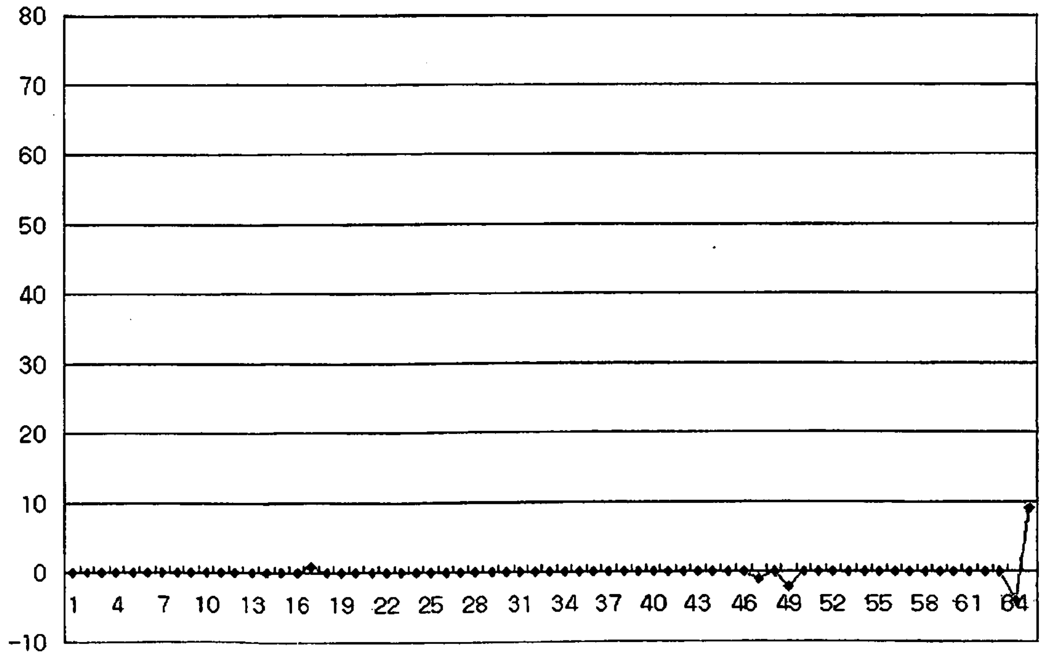

# FIG. 9I

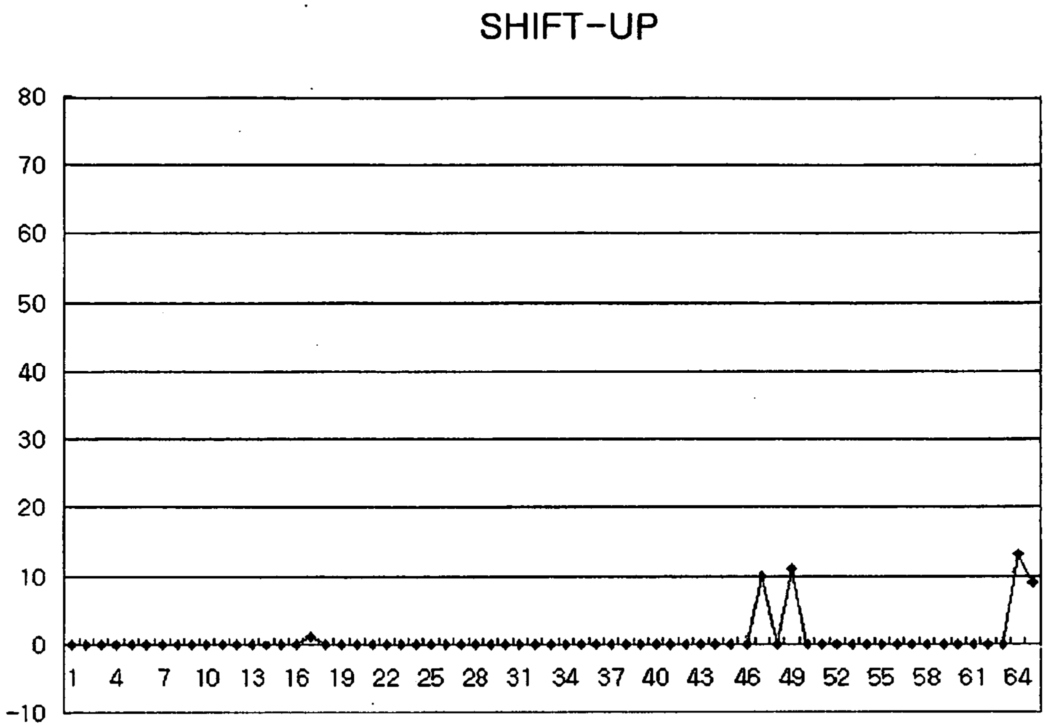
SHIFT-UP
80
70
60
50
40
30
20
10
0
-10
1 4 7 10 13 16 19 22 25 28 31 34 37 40 43 46 49 52 55 58 61 64

# FIG. 9J

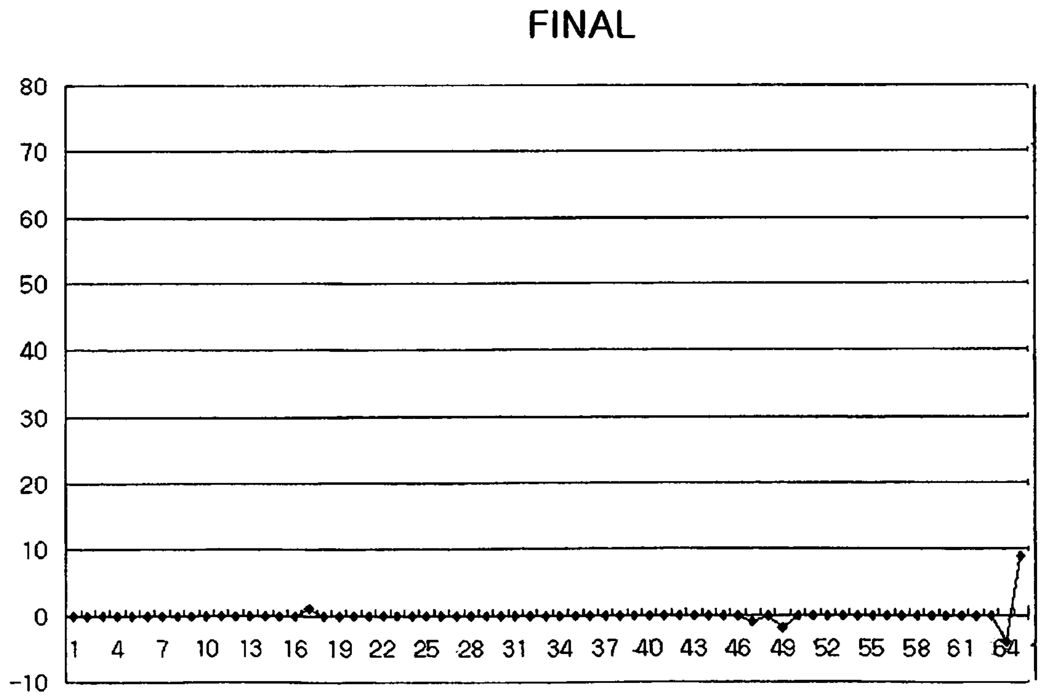
FINAL
80
70
60
50
40
30
20
10
0
-10
1 4 7 10 13 16 19 22 25 28 31 34 37 40 43 46 49 52 55 58 61 64

FIG. 10A

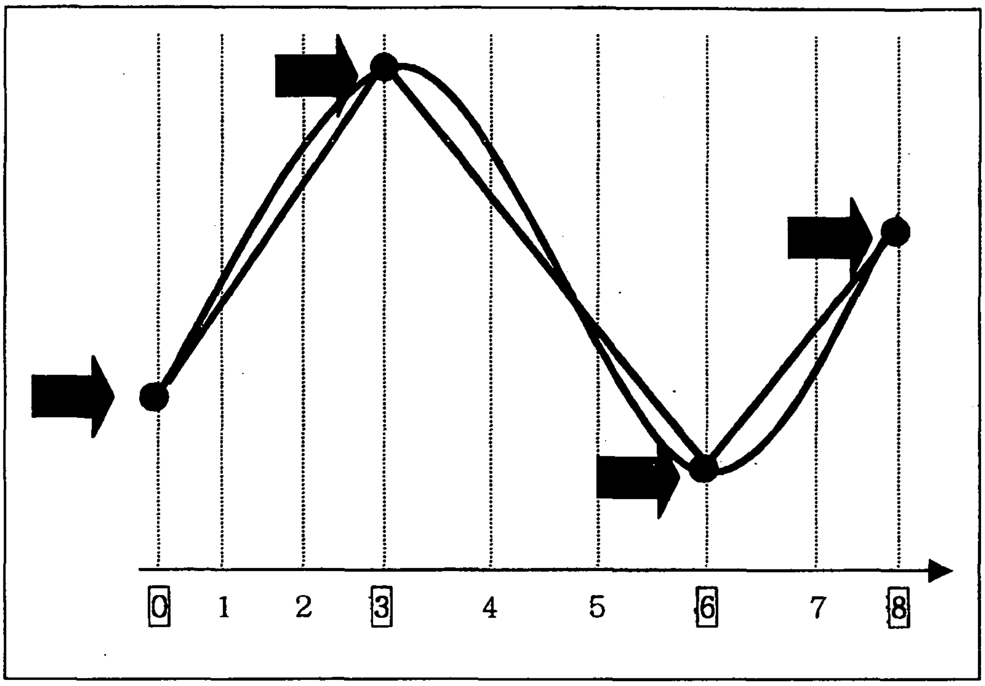


FIG. 10B

| ORIGINAL POINTS | P0 | P1 | P2 | P3 | P4 | P5 | P6 | P7 | P8 |
|---|---|---|---|---|---|---|---|---|---|
| KEY SELECTION FLAG | 1 | 0 | 0 | 1 | 0 | 0 | 1 | 0 | 1 |

FIG. 11A

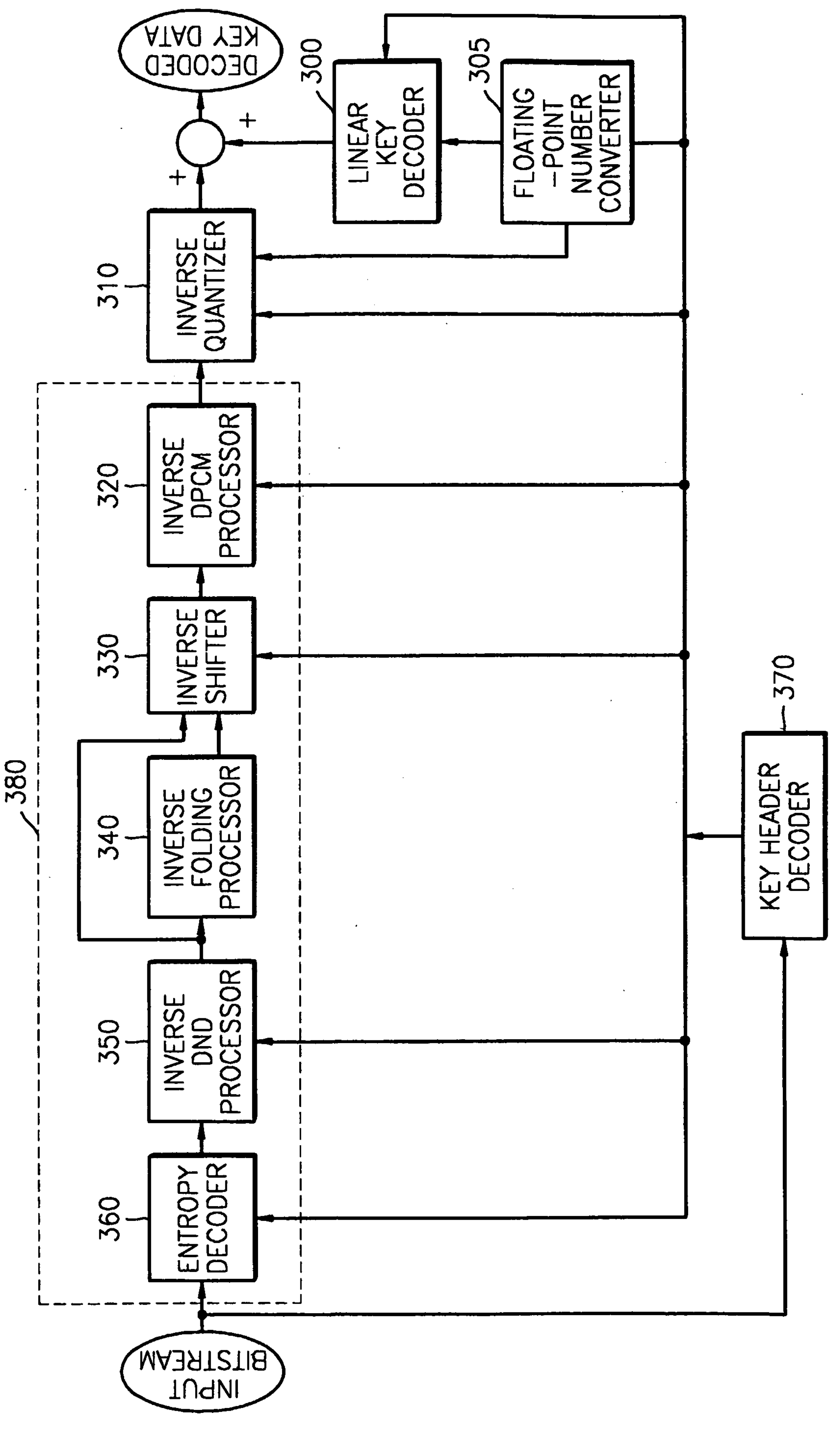
DECODED KEY DATA
300
LINEAR KEY DECODER
305
FLOATING -POINT NUMBER CONVERTER
310
INVERSE QUANTIZER
380
320
INVERSE DPCM PROCESSOR
330
INVERSE SHIFTER
340
INVERSE FOLDING PROCESSOR
350
INVERSE DND PROCESSOR
360
ENTROPY DECODER
370
KEY HEADER DECODER
INPUT BITSTREAM

FIG. 11B

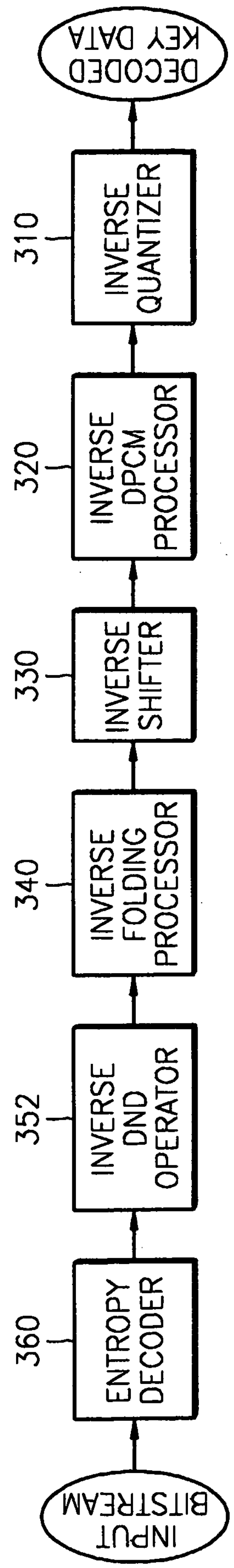


FIG. 11C

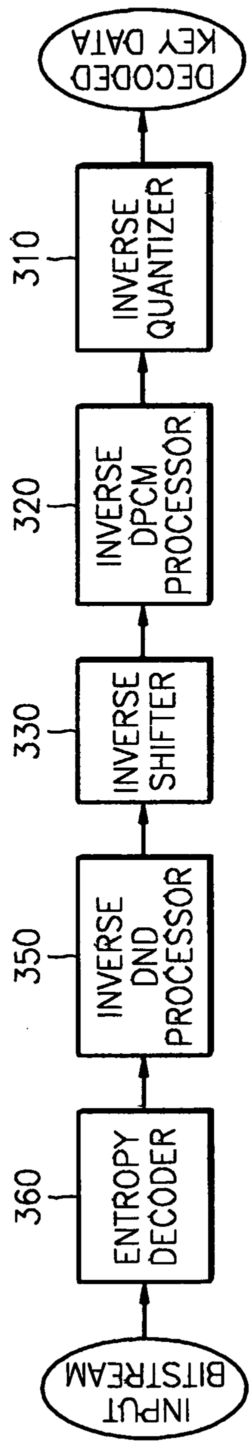

FIG. 11D

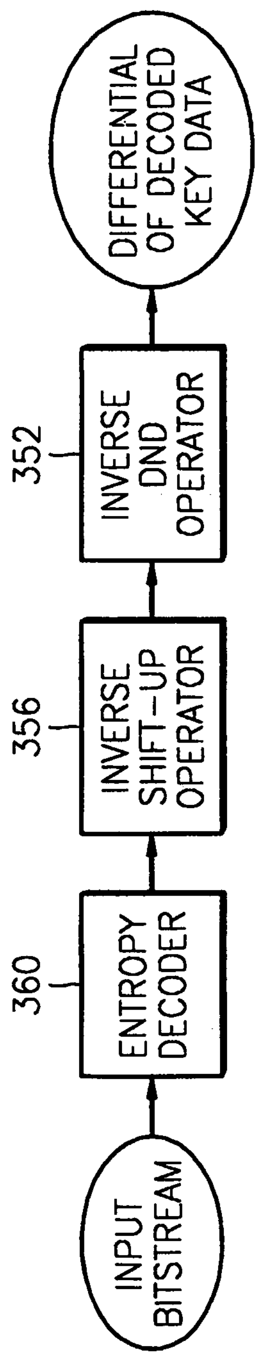
INPUT BITSTREAM
360
ENTROPY DECODER
356
INVERSE SHIFT-UP OPERATOR
352
INVERSE DND OPERATOR
DIFFERENTIAL OF DECODED KEY DATA

FIG. 11E

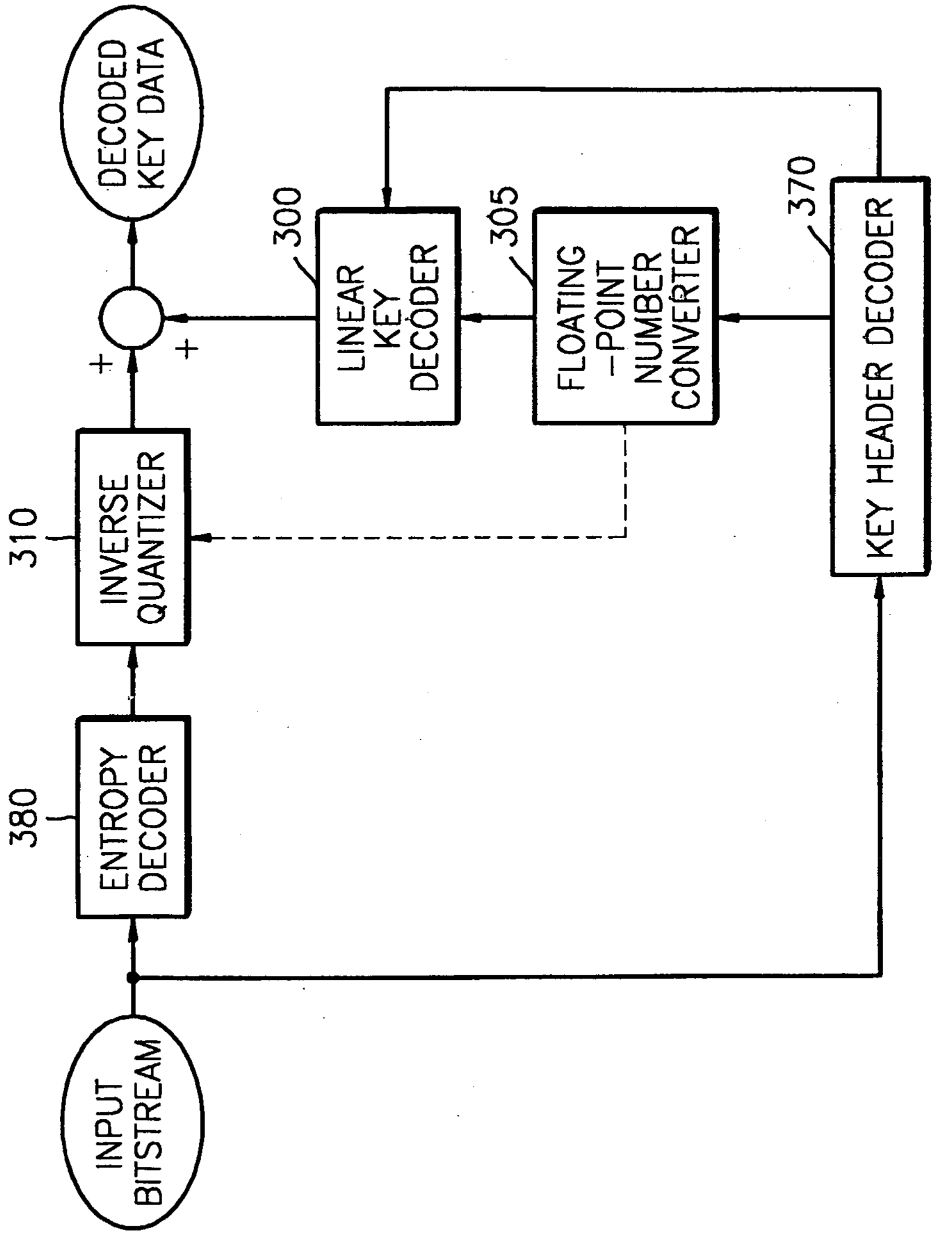
INPUT BITSTREAM
380
ENTROPY DECODER
310
INVERSE QUANTIZER
+
+
DECODED KEY DATA
300
LINEAR KEY DECODER
305
FLOATING -POINT NUMBER CONVERTER
370
KEY HEADER DECODER

FIG. 12

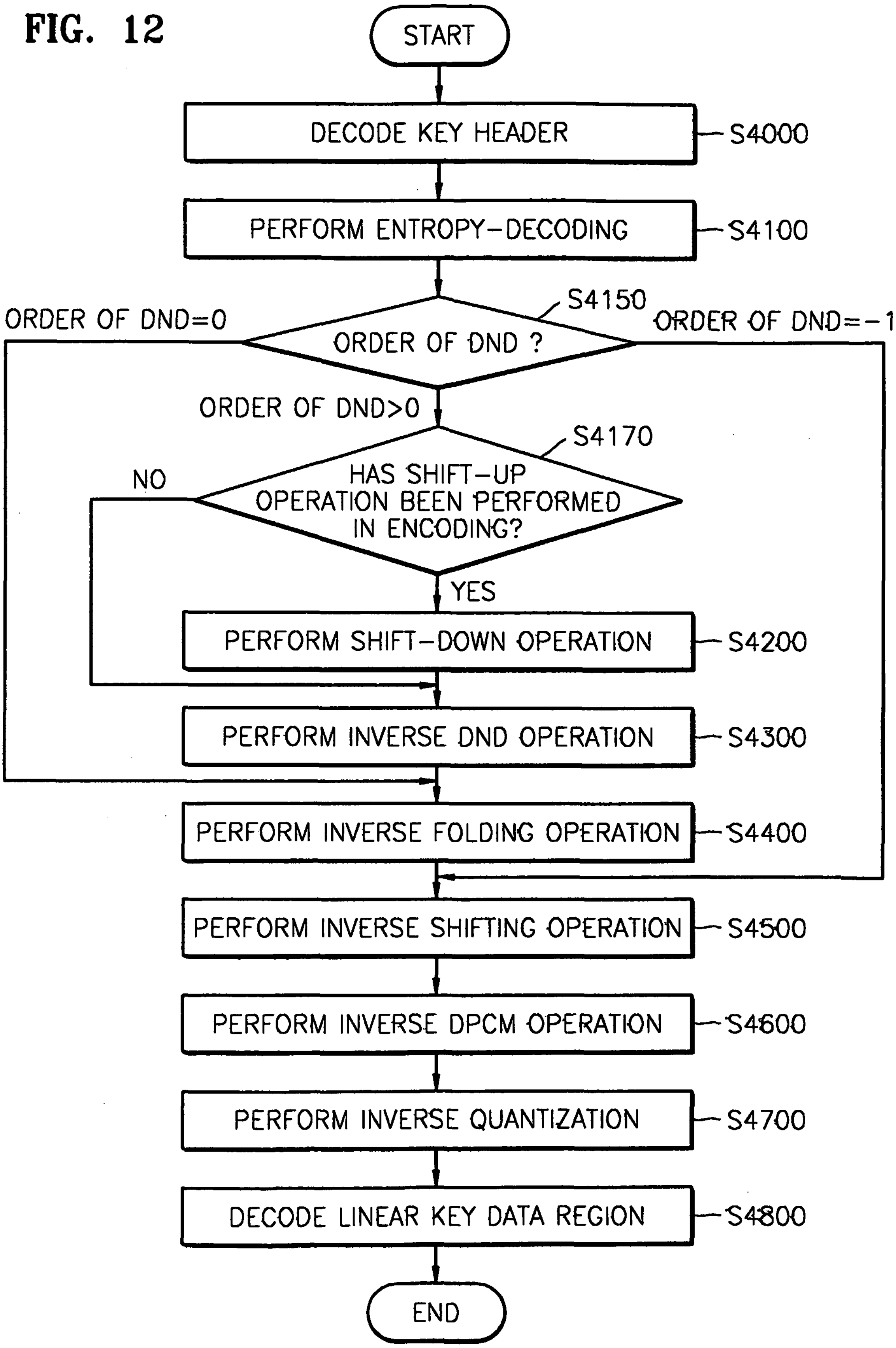
START
DECODE KEY HEADER
S4000
PERFORM ENTROPY-DECODING
S4100
S4150
ORDER OF DND=0
ORDER OF DND ?
ORDER OF DND=-1
ORDER OF DND>0
S4170
NO
HAS SHIFT-UP OPERATION BEEN PERFORMED IN ENCODING?
YES
PERFORM SHIFT-DOWN OPERATION
S4200
PERFORM INVERSE DND OPERATION
S4300
PERFORM INVERSE FOLDING OPERATION
S4400
PERFORM INVERSE SHIFTING OPERATION
S4500
PERFORM INVERSE DPCM OPERATION
S4600
PERFORM INVERSE QUANTIZATION
S4700
DECODE LINEAR KEY DATA REGION
S4800
END

FIG. 13

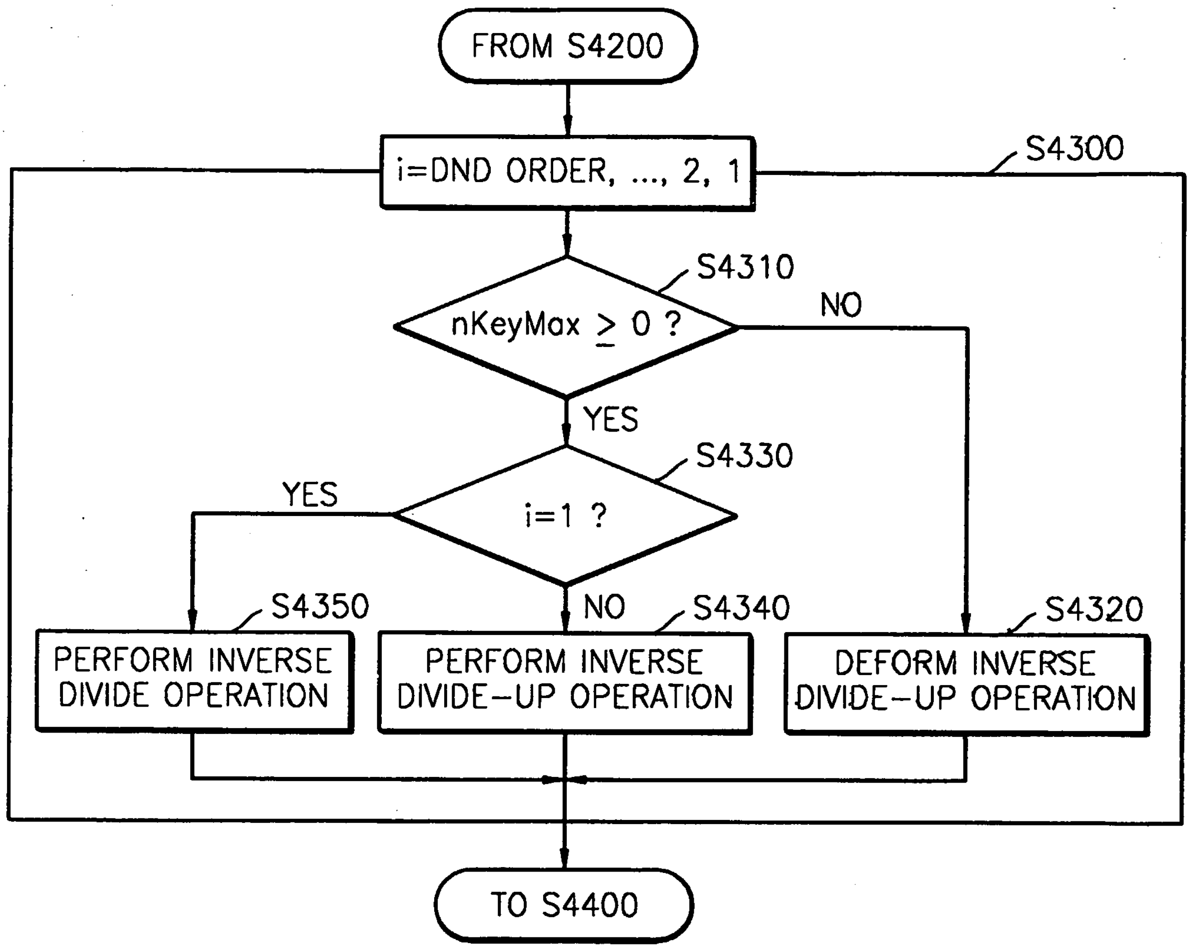
FROM S4200
i=DND ORDER, ..., 2, 1
S4300
S4310
nKeyMax ≥ 0 ?
NO
YES
S4330
YES
i=1 ?
S4350
NO
S4340
S4320
PERFORM INVERSE DIVIDE OPERATION
PERFORM INVERSE DIVIDE-UP OPERATION
DEFORM INVERSE DIVIDE-UP OPERATION
TO S4400

FIG. 14A

```
class KeyHeader  {
        int i;
        unsigned int(5) nKeyQBit;
        unsigned int(5) nNumKeyCodingBit;
        unsigned int(nNumKeyCodingBit) nNumberOfKey;
        unsigned int(4) nKeyDigit;
        bit(1) bIsLinearKeySubRegion;
        if(bIsLinearKeySubRegion == 1)
                LinearKey lKey(nKeyDigit);
        bit(1) bRangeFlag;
        if(bRangeFlag == 1)
                KeyMinMax keyMinMax(nKeyDigit);
        unsigned int(5) nBitSize;
        unsigned int(2) nKDPCMOrder;
        for(i = 0; i < nKDPCMOrder + 1; i++) {
                bit(1) nQIntraKeySign[[i]];
                if(i == 0 && nQIntraKeySign[i] == 1)
                        continue;
                unsigned int(nBitSize) nQIntraKey[[i]];
        }
        bit(1) bShiftFlag;
        if(bShiftFlag == 1) {
                bit(1) nKeyShiftSign;
                unsigned int(nBitSize) nKeyShift;
        }
        unsigned int(3) nDNDOrder;
        if(nDNDOrder == 7) {
                bit(1) bNoDND;
                if(bNoDND == 1)
                        nDNDOrder = -1;
        }
        int nMaxQBit = nBitSize;
        for(i = 0; i < nDNDOrder; i++) {
                bit(1) nKeyMaxSign[[i]];
                unsigned int(nMaxQBit) nKeyMax[[i]];
                nMaxQBit = (int)(log10(abs(nKeyMax[i]))/log10(2))+1;
                if(nMaxQBit+1 < nBitSize)
                        nMaxQBit += 1;
                else
                        nMaxQBit = nBitSize;
        }
        int bSignedAACFlag;
        int nKeyCodingBitQBit = (int)(log10(nKeyQBit))/log10(2))+1;
        unsigned int(nKeyCodingBitQBit) nKeyCodingBit;
        if(nDNDOrder != -1 && nDNDOrder != 0) {
                bit(1) bKeyInvertDownFlag;
                if(bKeyInvertDownFlag == 1) {
                        unsigned int(nKeyCodingBit) nKeyInvertDown;
                        bSignedAACFlag = 0;
                } else {
                        bSignedAACFlag = 1;
                }
        } else {
                bSignedAACFlag = 0;
        }
}
```

# FIG. 14B

```
class LinearKey (int nKeyDigit) {
	unsigned int(5) nNumLinearKeyCodingBit;
	unsigned int(nNumLinearKeyCodingBit) nNumberOfLinearKey;
	KeyMinMax kMinMax(nKeyDigit);
}
```

# FIG. 14C

```
class KeySelectionFlag(KeyHeader kHeader, int bPreserveKey) {
	int i;
	int nNumOfKeyValue = 0;
	if(bPreserveKey == 1) {
		for(i=0; i<kHeader.nNumberOfKey; i++) {
			qf_decode(&keyFlag[i], keyFlagContext);
			if(keyFlag[i] == 1)
				nNumOfKeyValue++;
		}
	} else
		nNumOfKeyValue = kHeader.nNumberOfKey;
}
```

# FIG. 14D

```
class KeyMinMax (int nKeyDigit) {
      bit(1) bMinKeyDigitSame;
      if((bMinKeyDigitSame == 0)
            unsigned int(4) nMinKeyDigit;
      else
            nMinKeyDigit = nKeyDigit;
      if(nMinKeyDigit != 0) {
            if(nMinKeyDigit < 8) {
                  int count = (int)(log10(10^nMinKeyDigit-1)/log10(2)) + 1;
                  bit(1) nMinKeyMantissaSign;
                  unsigned int(count) nMinKeyMantissa;
                  bit(1) nMinKeyExponentSign;
                  unsigned int(6) nMinKeyExponent;
            } else
                  float(32) fKeyMin;
      }
      bit(1) bMaxKeyDigitSame;
      if(bMaxKeyDigitSame == 0)
            unsigned int(4) nMaxKeyDigit;
      else
            nMaxKeyDigit = nKeyDigit;
      if(nMaxKeyDigit != 0) {
            if(nMaxKeyDigit < 8) {
                  int count = (int)(log10(10^nMaxKeyDigit)-1)/log10(2)) + 1;
                  bit(1) nMaxKeyMantissaSign;
                  unsigned int(count) nMaxKeyMantissa;
                  bit(1) bSameExponent;
                  if(bSameExponent == 0) {
                        bit(1) nMaxKeyExponentSign;
                        unsigned int(6) nMaxKeyExponent;
                  }
                  else
                        nMaxKeyExponent = nMinKeyExponent;
            } else
                  float(32) fKeyMax;
      }
}
```

# FIG. 14E

```
class Key (KeyHeader kHeader) {
      int nQKey[kHeader.nNumberOfKey];
      int i;
      int nNumberOfRemainingKey;
      if(kHeader.bIsLinearKeySubRegion == 1)
            nNumberOfRemainingKey = kHeader.nNumberOfKey
            kHeader.lKey.nNumberOfLinearKey;
      else
            nNumberOfRemainingKey = kHeader.nNumberOfKey;
      for(i = kHeader.nKDPCMOrder+1; i < nNumberOfRemainingKey; i++) {
            if(kHeader.bSignedAACFlag == 0)
                  decodeUnsignedAAC(nQKey[i], kHeader.nKeyCodingBit, keyContext);
            else
                  decodeSignedAAC(nQKey[i], kHeader.nKeyCodingBit+1, keySignContext,
                  keyContext);
      }
}
```

# FIG. 15A

```
void decodeSignedAAC(int *nDecodedValue, int qstep, QState *signContext,
QState *valueContext) {
        int b;
        b = qstep - 2;
        int msb = 0;
        do {
                qf_decode(&msb, &valueContext[b]);
                msb = msb << b;
                b--;
        } while (msb == 0 && b >=0);
        int sgn = 0;
        int rest = 0;
        if(msb != 0) {
                qf_decode(&sgn, signContext);
                while (b >= 0) {
                        int temp = 0;
                        qf_decode(&temp, &valueContext[b]);
                        rest |= (temp << b);
                        b--;
                }
        }
        if(sgn)
                *nDecodedValue = -(msb+rest);
        else
                *nDecodedValue = (msb+rest);
}
```

# FIG. 15B

```
void decodeUnsignedAAC(int *nDecodedValue, int qstep,
QState *valueContext) {
        int b;
        b = qstep - 1;
        int msb = 0;
        do {
                qf_decode(&msb, &valueContext[b]);
                msb = msb << b;
                b--;
        } while (msb == 0 && b >= 0);
        int rest = 0;
        if(msb != 0) {
                while (b >= 0) {
                        int temp = 0;
                        qf_decode(&temp, &valueContext[b]);
                        rest |= (temp << b);
                        b--;
                }
        }
        *nDecodedValue = (msb + rest);
}
```

# FIG. 15C

```
void decodeKey(int* nQIntraKey, int* nQKey, int nNumberOfRemainingKey,
int nKeyQBit)
{
      add(nQKey, nQIntraKey);            // add nQIntraKey array to nQKey array
// Inverse DND
      if(m_nDNDOrder > 0) {
            if(nKeyInvertDown != -1) {
                  for(k = 0; k < nNumberOfRemainingKey; k++)
                        invert-down(nQKey[k], nKeyInvertDown);
            }
            for(i = nDNDOrder; i > 0; i--) {
                  if(nKeyMax[i-1] >= 0) {
                        if(i == 1) {
                              for(k = 0; k < nNumberOfRemainingKey; k++)
                              inverse-divide(nQKey[k], nKeyMax[i-1]);
                        }
                        else {
                              for(k = 0; k < nNumberOfRemainingKey; k++)
                                    inverse-divide-down(nQKey[k], nKeyMax[i-1]);
                        }
                  } else {
                              for(k = 0; k < nNumberOfRemainingKey; k++)
                                    inverse-divide-up(nQKey{k], nKeyMax[i-1]);
                  }
            }
      }
      //Inverse Fold
      if(nDNDOrder != -1) {
            for(k = 0; k < nNumberOfRemainingKey; k++)
                  inverse-fold(nQKey[k])
      }
      for(k = 0; k < nNumberOfRemainingKey; k++)
            inverse-shift(nQKey[k], nKeyShift)  //Inverse Shift

      for(i = 0; i < nKDPCMOrder; i++)      //Inverse DPCM
            inverse-dpcm(nQKey, nNumberOfRemainingKey);
      //Inverse Quantization
      inverse-quantize(nQKey, nNumberOfRemaingKey, nKeyQBit);
}
```